# EUROPEAN PATENT SPECIFICATION

(11) **EP 3 734 362 B1**
(45) Date of publication and mention of the grant of the patent: **08.09.2021**
(21) Application number: 20166910.8
(22) Date of filing: 30.03.2020
(51) Int. Cl.: G03F 7/023, G03F 7/022

(54) **POSITIVE PHOTOSENSITIVE RESIN COMPOSITION, PATTERNING PROCESS, METHOD OF FORMING CURED FILM, INTERLAYER INSULATION FILM, SURFACE PROTECTIVE FILM, AND ELECTRONIC COMPONENT**
POSITIVE LICHTEMPFINDLICHE HARZZUSAMMENSETZUNG, STRUKTURIERUNGSVERFAHREN, VERFAHREN ZUR HERSTELLUNG EINES GEHÄRTETEN FILMS, ZWISCHENSCHICHTISOLATIONSFILM, OBERFLÄCHENSCHUTZFILM UND ELEKTRONISCHES BAUELEMENT
COMPOSITION DE RÉSINE PHOTOSENSIBLE POSITIVE, PROCÉDÉ DE FORMATION DE MOTIFS, PROCÉDÉ DE FORMATION D'UN FILM DURCI, FILM D'ISOLATION INTERCOUCHE, FILM PROTECTEUR DE SURFACE ET COMPOSANT ÉLECTRONIQUE

(30) Priority: 15.04.2019 JP 2019077383
(43) Date of publication of application: 04.11.2020
(73) Proprietor: Shin-Etsu Chemical Co., Ltd., Tokyo (JP)
(72) Inventor: Urano, Hiroyuki, Niigata (JP); Takemura, Katsuya, Niigata (JP); Iio, Masashi, Niigata (JP); Honda, Kazuya, Niigata (JP)
(74) Representative: Wibbelmann, Jobst

(56) References cited:
- EP-A1- 3 235 803
- JP-A- 2008 145 579
- US-A- 5 302 489
- US-A1- 2009 176 172
- US-A1- 2012 100 484

## Description

### TECHNICAL FIELD

The present invention relates to a positive photosensitive resin composition, a patterning process capable of developing with an alkaline aqueous solution that uses the positive photosensitive resin composition, a method of forming a cured film, an interlayer insulation film, a surface protective film, and an electronic component.

### BACKGROUND ART

As miniaturization and higher performance of various electronic devices such as personal computers, digital cameras, and mobile phones advance, a demand for further miniaturization, thinning and higher density rapidly are increasing. Accompanying these, it is demanded for interlayer insulation films and surface protective films of semiconductor devices to combine excellent electric characteristics, heat resistance, mechanical characteristics.

In a high-density mounting technology such as a three-dimensional lamination, as a photosensitive insulation material capable of forming a pattern on a substrate, a polyimide film has been utilized as a protective film or an insulation layer, its insulation property, mechanical characteristics, and adhesiveness with a substrate are kept drawing attention, and its development is active even now.

So far, as a photosensitive polyimide material, a material that utilizes polyamic acid that is a precursor of the polyimide, for example, one in which a photosensitive group is introduced in a carboxyl group of the polyamic acid by an ester bond (Patent Document 1, Patent Document 2) has been proposed. However, in these proposals, since in order to obtain a polyimide film that is a target, an imidization treatment at a high temperature exceeding 300°C after a patterned film is formed is necessary, in order to endure the high temperature, there were problems such that an undercoat base material is restricted, or copper of a wiring is oxidized.

As an improvement of this, in order to make a post-curing temperature lower, a photosensitive polyimide that uses a pre-imidized and solvent-soluble resin has been proposed (Patent Document 3, Patent Document 4). In the Patent Document 3, a negative photosensitive composition having a closed-ring polyimide has been proposed and the pattern-forming property and the adhesiveness are described. However there is no description of the mechanical strength.

Although the Patent Document 4 proposes a positive photosensitive resin composition that uses an alkali-soluble and closed-ring polyimide, a photoacid generator and a heat crosslinking agent having a methylol group, there was room for improving a value of breaking elongation when cured at low temperatures.

Furthermore, in the Patent Document 5, a positive photosensitive resin composition that uses an alkali-soluble polyimide containing a diamine residue having a triazine or diazine skeleton in a molecular skeleton, an alkali-soluble polyimide having a glass transition temperature different from that of the polyimide, and a photoacid generator have been proposed. Although the resin composition is a material having excellent adhesiveness with copper wire, there was room for improving the mechanical characteristics, in particular, the breaking elongation.

Furthermore, although Patent Document 6 proposes a polyimide resin composition in which a polyimide having a carboxyl group in a molecule skeleton and a polyimide containing a heterocyclic skeleton having a nitrogen atom at a molecular terminal are combined, there is no description of a photosensitive resin composition. Furthermore, in the case of using the composition described in the Patent Document 6 as an insulation material that is used in the surface protective film or the interlayer insulation film, the carboxyl group contained in the resin which remains in a cured film causes copper migration, therefore, it is necessary to completely block the carboxyl group. There, in order to block the carboxyl group, for example, an epoxy type crosslinking agent is used. However, since the carboxyl group and the epoxy type crosslinking agent are very reactive to cause a problem of storage stability, application of the relevant composition in the present field is difficult.

Furthermore, in Patent Document 7, a positive photosensitive resin composition that uses an alkali-soluble polyamide-imide, and a photoacid generator has been proposed. Although the resin composition is a material excellent in solvent solubility and resolution, there was a room for improving the mechanical characteristics, in particular, the breaking elongation.

Thus, hereafter, since as higher densification and higher integration of chips proceed, the miniaturization of patterns in a rewiring technology of the insulation protective film further proceeds, as the photosensitive resin composition, a composition that can realize high resolution without damaging excellent features such as the mechanical characteristics of a pattern and a protective film and adhesiveness obtained by heating is demanded strongly.

### CITATION LIST

### PATENT LITERATURE

Patent Literature 1: Japanese Patent Laid-Open Publication No. S49-115541
Patent Literature 2: Japanese Patent Laid-Open Publication No. S55-45746
Patent Literature 3: Japanese Patent No. 3232022
Patent Literature 4: Japanese Patent Laid-Open Publication No. 2006-313237
Patent Literature 5: WO 2018/159384 A1
Patent Literature 6: Japanese Patent Laid-Open Publication No. 2001-106911
Patent Literature 7: Japanese Patent Laid-Open Publication No. 2018-158966

### SUMMARY OF INVENTION

### TECHNICAL PROBLEM

The present invention was performed in view of the above situations and intends to provide a positive photosensitive resin composition that is soluble in an alkaline aqueous solution, can form a fine pattern and can obtain high resolution, and has excellent mechanical characteristics even when cured at low temperatures.

### SOLUTION TO PROBLEM

To solve the problem, the present invention provides a positive photosensitive resin composition comprising:
(A-1) an alkali-soluble resin containing at least one or more structures selected from a polyimide structure, a polybenzoxazole structure, a polyamide-imide structure, and a precursor structure thereof;
(A-2) a resin containing at least one or more structures selected from a polyimide structure, a polybenzoxazole structure, a polyamide-imide structure, and a precursor structure thereof, each of which has no alkali-soluble group and contains a heterocyclic skeleton having at least one or more nitrogen atoms at a molecular end;
(B) a compound having a quinonediazide structure for serving as a photosensitizer to generate an acid by light and increase a dissolution speed to an alkaline aqueous solution; and
(D) a solvent.

The positive photosensitive resin composition like this is soluble in an alkaline aqueous solution, enables a fine pattern and high resolution, and has excellent mechanical characteristics even when cured at low temperatures.

Furthermore, the positive photosensitive resin composition of the present invention may contain a polyimide structure in which the (A-2) is represented by the following general formula (1). 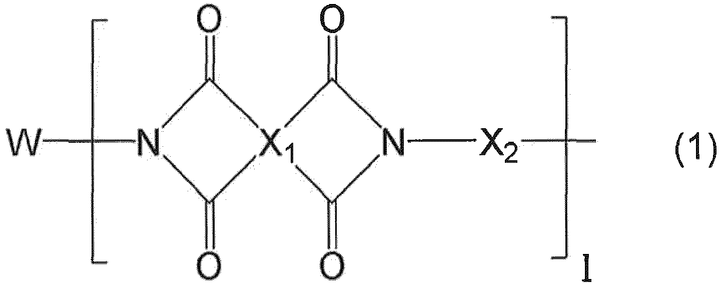 In the formula, W is a monovalent organic group having a heterocyclic skeleton having at least one or more nitrogen atoms, X₁ is a tetravalent organic group, X₂ is a divalent organic group, and "1" represents an integer of 1 to 1000.

Since the positive photosensitive resin composition like this may improve the elongation of a cured film of the photosensitive composition, the mechanical characteristics may be excellent even when cured at low temperatures.

Furthermore, the positive photosensitive resin composition of the present invention preferably contains 5 parts by mass or larger and 50 parts by mass or smaller of the (A-2) relative to 100 parts by mass of the (A-1).

The positive photosensitive resin composition like this may make a desirable intermolecular interaction between resins (A-1), and the resin (A-1) and the resin (A-2), and may obtain an effect of improving the elongation of the cured film of the photosensitive composition, and does not cause the problem such as residues during lithography patterning.

Furthermore, in the positive photosensitive resin composition of the present invention, the (A-1) preferably contains a structure represented by the following general formulae (2) and/or (3), 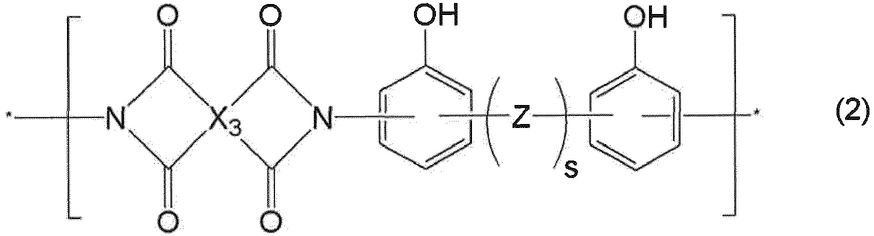 wherein X₃ is a tetravalent organic group, "s" represents 0 or 1, Z is a divalent linking group, and when s=0, two aromatic rings in the formula are directly bonded without a linking group, 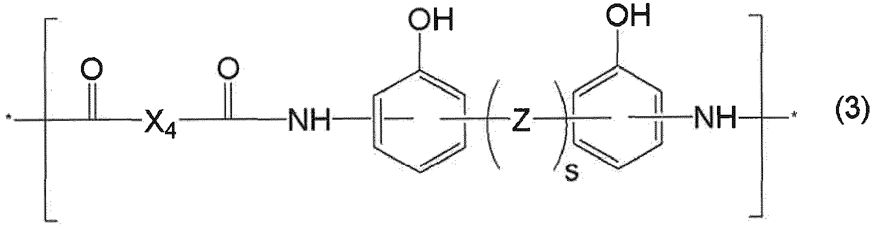 wherein X₄ is a divalent organic group, and "s" and Z are the same as the above.

The positive photosensitive resin composition like this may have more preferable solubility to the alkaline aqueous solution, and may become more excellent in the mechanical characteristics of the cured product.

In this case, Z in the general formulae (2) and (3) is preferable to be a divalent group represented by the following general formula (4) or (5), 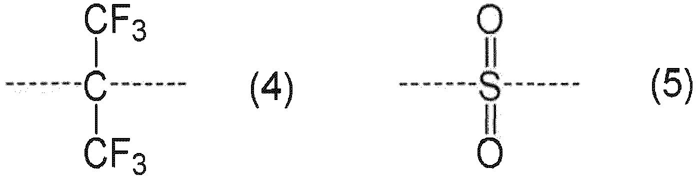 wherein a dotted line represents a bond.

When Z is a group like this, it is preferable that the solubility to a developer of an alkaline aqueous solution be improved.

Furthermore, in the positive photosensitive resin composition of the present invention, the (A-1) is, furthermore, preferable to contain a structural unit represented by the following general formulae (6) and/or (8), 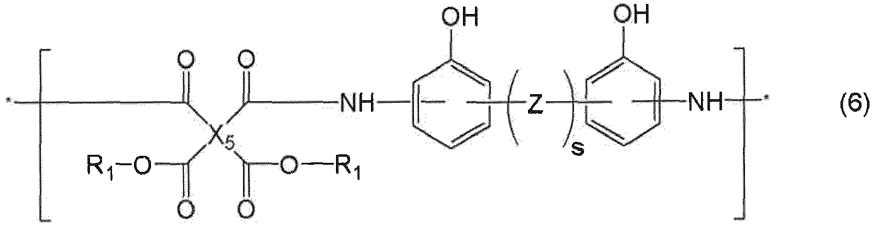 wherein X₅ is a tetravalent organic group, R₁ is a group represented by the following general formula (7), "s" represents 0 or 1, Z is a divalent linking group, and, when s=0, two aromatic rings in the formula are directly linked without a linking group, 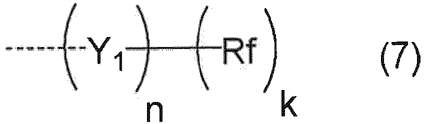 wherein a dotted line represents a bond, Y₁ is an organic group with a valency of (k+1), Rf is a linear branched, or cyclic alkyl group having 1 to 20 carbon atoms or an aromatic group optionally substituted with an alkyl group in which a part or all of hydrogen atoms are substituted with fluorine atoms, "k" represents 1, 2 or 3, and "n" represents 0 or 1, 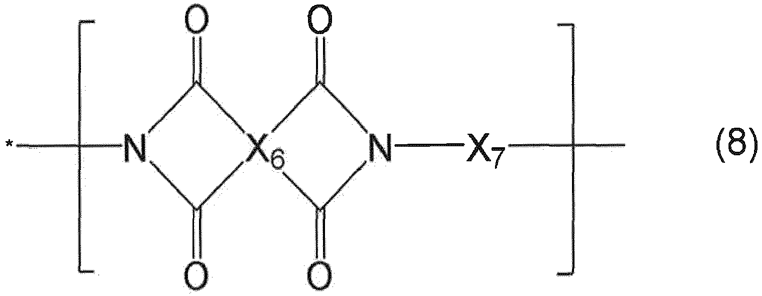 wherein X₆ is a tetravalent organic group, and X₇ is a group shown by the following general formula (9), 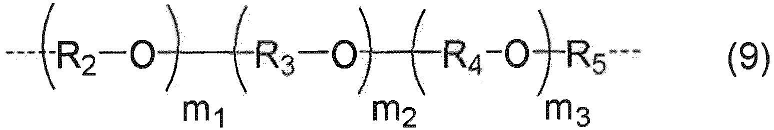 wherein R₂ to R₅ each is independently a linear or branched alkylene group having 2 to 10 carbon atoms, m₁ is an integer of 1 to 40, and m₂, m₃ each is independently an integer of 0 to 40.

By containing the structural unit like this, the positive photosensitive resin composition of the present invention has improved solubility to a general-purpose organic solvent, may be used without limiting a solvent of the composition, may generate flexibility, and may obtain a cured film having high elongation and low warpage.

In this case, the R₁ in the general formula (6) is preferably an organic group selected from any one of groups represented by the following general formulae (10), (11), (12) and (13), 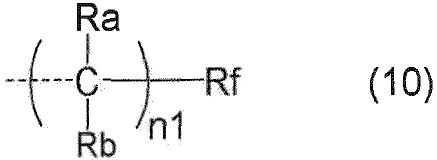 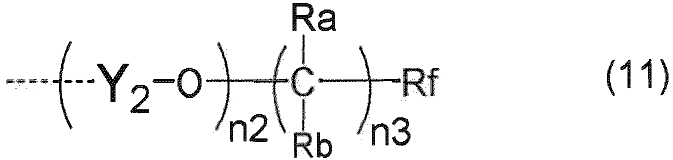 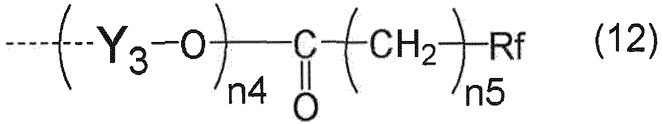 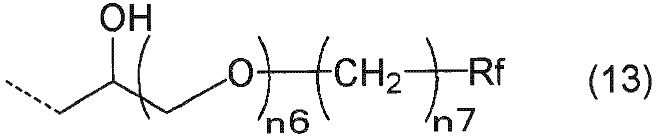 wherein a dotted line represents a bond, Rf is the same as the above, Ra and Rb are a hydrogen atom or an alkyl group having 1 to 3 carbon atoms, Y₂ and Y₃ are a linear or branched alkylene group having 1 to 6 carbon atoms, n1 represents an integer of 0 to 6, n2 represents an integer of 1 to 6, n3 represents an integer of 0 to 6, n4 represents an integer of 1 to 6, n5 represents an integer of 0 to 6, n6 represents 0 or 1, and n7 represents an integer of 0 to 6.

From the easy availability of a compound that is a raw material for introducing R₁, the R₁ is preferable to be a group like this.

Furthermore, the positive photosensitive resin composition of the present invention preferably furthermore contains (C) one or two or more kinds of crosslinking agents selected from an amino condensate modified by formaldehyde or formaldehyde-alcohol; a phenol compound having two or more methylol groups or alkoxymethylol groups by average in one molecule; a compound in which a hydrogen atom of a phenolic hydroxy group is substituted with a glycidyl group; a compound in which a hydrogen atom of a phenolic hydroxy group is substituted with a substituent represented by the following formula (C-1); and a compound containing two or more nitrogen atoms having a glycidyl group represented by the following formula (C-2), 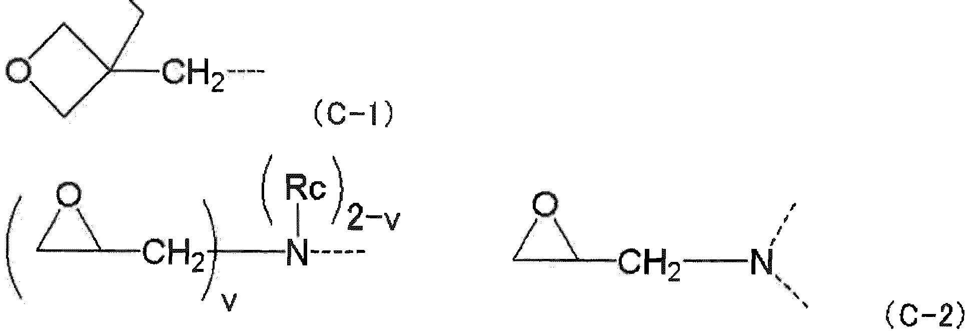 wherein a dotted line represents a bond, Rc represents a linear, branched, or cyclic alkyl group having 1 to 6 carbon atoms, and "v" represents 1 or 2.

The (C) component like this causes a crosslinking reaction in the post-curing after a pattern of the positive photosensitive resin composition of the present invention is formed to improve the strength of the cured product further and to form a more preferable cured film.

Furthermore, the positive photosensitive resin composition of the present invention is preferable to contain (E) a compound to generate an acid by heating.

The (E) component like this may further improve the mechanical strength, chemical resistance, adhesiveness of an obtained pattern or a film, by furthermore advancing the crosslinking and curing reaction.

Furthermore, the present invention provides a patterning process comprising steps of:
(1) forming a photosensitive material film by coating the positive photosensitive resin composition according to any one of claim 1 to 9 on a substrate;
(2) subsequently, after a heat treatment, exposing the photosensitive material film with a high energy beam having a wavelength of 190 to 500 nm or an electron beam via a photomask; and
(3) developing with a developer of an alkaline aqueous solution.

According to the patterning process like this, since the positive photosensitive resin composition becomes alkali-soluble, a fine pattern may be formed and high resolution may be obtained.

Furthermore, the present invention provides a method of forming a cured film comprising a step of heating and post-curing a film on which a pattern is formed by the patterning process according to claim 10 at a temperature of 100 to 300°C.

The method of forming a cured film enables a cured film (pattern) to have excellent mechanical characteristics even when cured at low temperatures.

Furthermore, the present invention provides an interlayer insulation film or a surface protective film being a cured film by curing the positive photosensitive resin composition.

The cured film obtained by curing the positive photosensitive resin composition of the present invention has excellent adhesiveness with a substrate, heat resistance, electric property, mechanical strength and chemical resistance to an alkaline release liquid, and a semiconductor element having the cured film as a protective coating has excellent reliability. Therefore, the cured film is suitable as a protective coating (an interlayer insulation film or surface protective film) of electric and electronic components, semiconductor elements.

Furthermore, the present invention provides an electronic component having the interlayer insulation film or the surface protective film.

The protective coating like this (interlayer insulation film or surface protective film) is effective for an insulation film for semiconductor elements including rewiring use, an insulation film for multilayer printed board and so on from the viewpoint of heat resistance, chemical resistance, and insulation property, and may give electronic components having excellent reliability.

### ADVANTAGEOUS EFFECTS OF INVENTION

As was described above, the present invention may provide a positive photosensitive resin composition that is soluble in an alkaline aqueous solution, enables a fine pattern and high resolution, and has excellent mechanical characteristics even when cured at low temperatures.

### DESCRIPTION

As was described above, a photosensitive resin composition that is soluble in an alkaline aqueous solution, enables a fine pattern and high resolution, and has excellent mechanical characteristics even when cured at low temperatures has been demanded.

The present inventors studied hard to achieve the above object and found that a pattern obtained by using a positive photosensitive resin composition comprising (A-1) an alkali-soluble resin containing a specific structure, (A-2) a resin not having an alkali-soluble group but containing a specific structure, (B) a specific photosensitizer, and (D) a solvent is fine and has an excellent pattern shape.

Furthermore, it was found that a protective film obtained by using the positive photosensitive resin composition, by forming a pattern, and by heating has excellent mechanical characteristics, in particular, the breaking elongation. That is, it was found that a cured film with a pattern formed by using the positive photosensitive resin composition is excellent as an electric, electronic component protective film, and an insulation protective film, thus the present invention was completed. In the present specification, the electric and electronic components are called summarized also as "electronic component".

That is, the present invention is a positive photosensitive resin composition including:
(A-1) an alkali-soluble resin containing at least one or more structures selected from a polyimide structure, a polybenzoxazole structure, a polyamide-imide structure, and a precursor structure thereof;
(A-2) a resin containing at least one or more structures selected from a polyimide structure, a polybenzoxazole structure, a polyamide-imide structure, and a precursor structure thereof, each of which has no alkali-soluble group and contains a heterocyclic skeleton having at least one or more nitrogen atoms at a molecular end;
(B) a compound having a quinonediazide structure for serving as a photosensitizer to generate an acid by light and increase a dissolution speed to an alkaline aqueous solution; and
(D) a solvent.

In what follows, the present invention will be detailed, but the present invention is not limited to these.

### (Positive Photosensitive Resin Composition)

The positive photosensitive resin composition of the present invention will be described.

The positive photosensitive resin composition of the present invention includes:
(A-1) an alkali-soluble resin containing at least one or more structures selected from a polyimide structure, a polybenzoxazole structure, a polyamide-imide structure, and a precursor structure thereof;
(A-2) a resin containing at least one or more structures selected from a polyimide structure, a polybenzoxazole structure, a polyamide-imide structure, and a precursor structure thereof, each of which has no alkali-soluble group and contains a heterocyclic skeleton having at least one or more nitrogen atoms at a molecular end;
(B) a compound having a quinonediazide structure for serving as a photosensitizer to generate an acid by light and increase a dissolution speed to an alkaline aqueous solution; and (D) a solvent. The positive photosensitive resin composition may be alkali-developed. Furthermore, the positive photosensitive resin composition may furthermore contain, as needs arise, (C) a crosslinking agent, (E) a compound (thermal acid generator) that generates an acid by heat and so on, other than the (A-1) component, (A-2) component, (B) component and (D)component.

### ((A-1) Alkali-soluble resin)

An alkali-soluble resin (A-1) of the present invention is an alkali-soluble resin containing at least one or more structures selected from a polyimide structure, a polybenzoxazole structure, a polyamide-imide structure, and a precursor structure thereof. Although the resin (A-1) is not particularly restricted as long as an alkali-soluble resin containing the above structures, one containing the structure represented by the following general formula (2) and/or (3) is preferable. 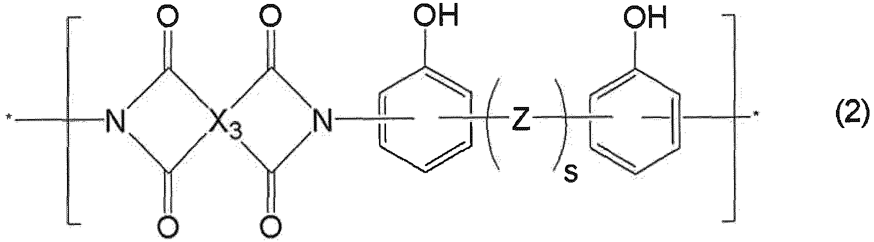 In the formula, X₃ is a tetravalent organic group, "s" represents 0 or 1, Z is a divalent linking group, and when s=0, two aromatic rings in the formula are directly bonded without a linking group. 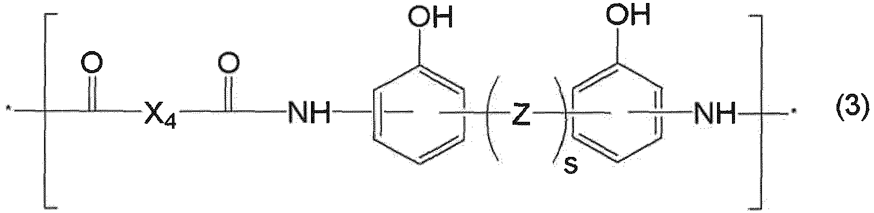 In the formula, X₄ is a divalent organic group, and "s" and Z are the same as those described above.

Although X₃ in the general formula (2) is a tetravalent organic group, it is not restricted as long as it is a tetravalent organic group. Preferably, X₃ is a tetravalent organic group of a cyclic aliphatic group having 4 to 40 carbon atoms or an aromatic group, and more preferably, a tetravalent organic group represented by the following formula (14). Furthermore, a structure of X₃ may be a combination of one or two or more kinds. 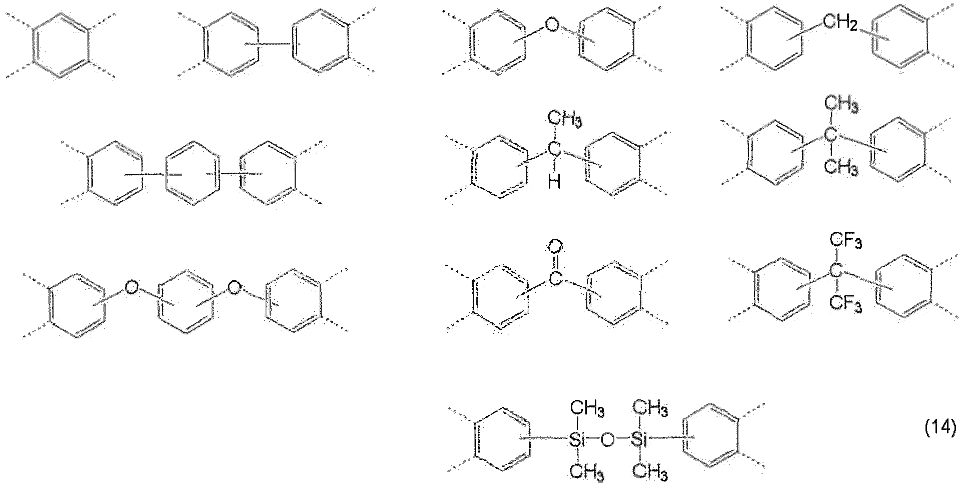 In the formulae, a dotted line represents a bond.

The s in the general formula (2) represents 0 or 1, and when s is 0, two aromatic rings in the general formula (2) are bonded directly without the divalent linking group Z.

When s is 1, two aromatic rings in the general formula (2) are bonded via the divalent linking group Z. Z is not restricted as long as it is a divalent group. Preferably, the Z is a divalent organic group of an alicyclic aliphatic group having 4 to 40 carbon atoms or aromatic group, and more preferably a divalent linking group represented by the following formula (15). The structure of Z may be one kind or a combination of two or more kinds. 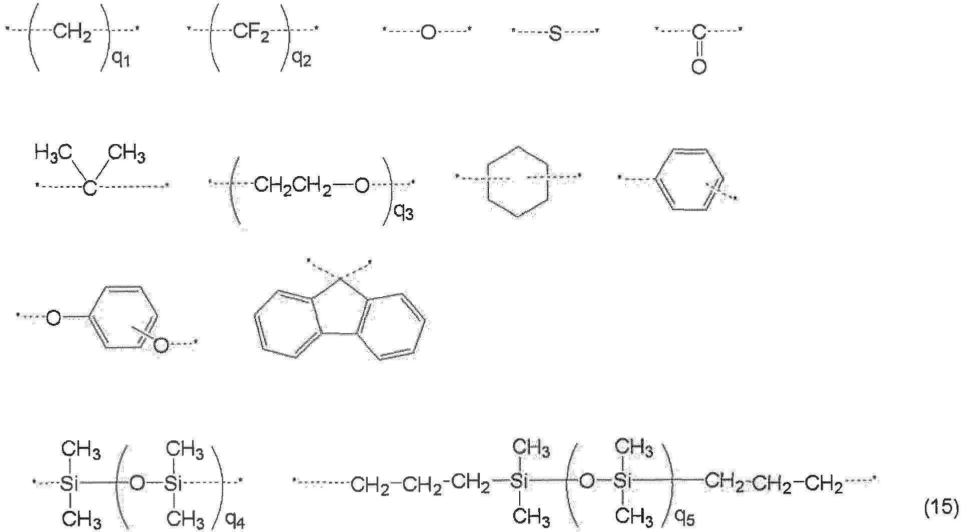 In the formulae, q₁, q₂, and q₃ represent an integer of 1 to 6, and q₄ and q₅ represent an integer of 1 to 10. A dotted line represents a bond.

In particular, a preferable divalent linking group Z is a divalent group represented by the following general formula (4) or (5). 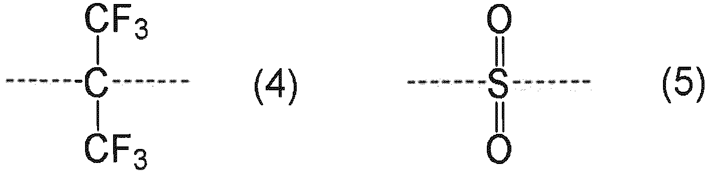 In the formulae, a dotted line represents a bond.

As a structural unit represented by the general formula (2), when Z in the general formula (2) is a group represented by the formula (4), a structural unit represented by the following general formula (2-1) is preferable, and when Z in the general formula (2) is a group represented by the general formula (5), a structural unit represented by the following general formula (2-2) is preferable. 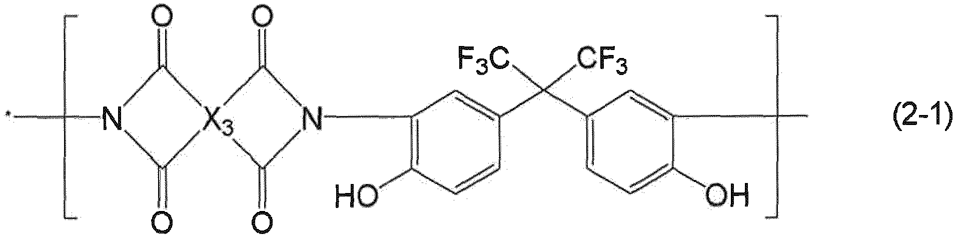 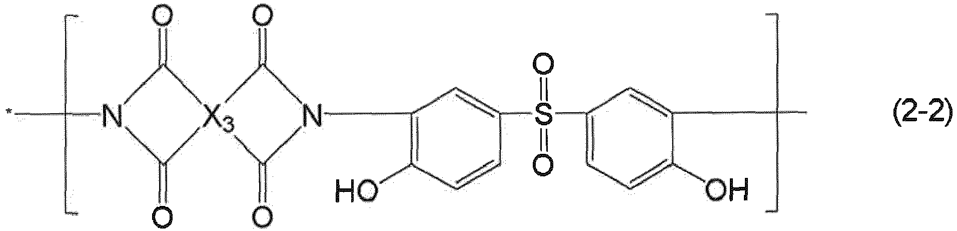 In the formulae, X₃ is the same as that described above.

As shown by the general formula (2-1), when the divalent linking group Z is a hexafluoropropylidene group shown by the formula (4) and is located at a p-position of a phenolic hydroxy group, since the hexafluoropropylidene group is an electron withdrawing group, the acidity of the phenolic hydroxy group becomes high, and the solubility to a developer of an alkaline aqueous solution increases. Therefore, it is preferred that the Z be the group shown by the formula (4).

Similarly, as shown by the general formula (2-2), when the divalent linking group Z is a sulfonic group shown by the formula (5) and is located at a p-position of a phenolic hydroxy group, since the sulfonic group is also an electron withdrawing group, the acidity of the phenolic hydroxy group becomes high, and the solubility to a developer of an alkaline aqueous solution increases. Therefore, it is also preferred that the Z be the group shown by the formula (5).

The X₄ in the general formula (3) is a divalent organic group and is not restricted as long as it is the divalent organic group. Preferably, it is a divalent organic group of an aliphatic chain length structure or an alicyclic aliphatic group having 4 to 40 carbon atoms, or an aromatic group. Furthermore preferably, it is a divalent organic group represented by the following formula (16). The structure of the X₄ may be one kind or a combination of two or more kinds. 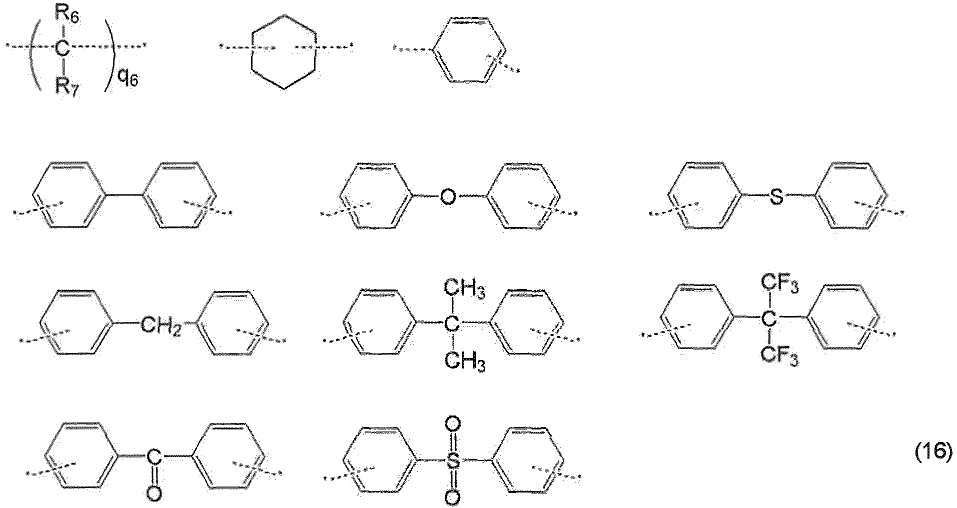 In the formulae, R₆ and R₇ each independently a hydrogen atom, a fluorine atom, or an alkyl group having 1 to 6 carbon atoms, q₆ is an integer of 1 to 30, and a dotted line represents a bond.

When the X₄ in the general formula (3) is a divalent organic group that is an aliphatic chain length structure, the mechanical strength, in particular, the elongation of a cured film of the positive photosensitive resin composition of the present invention is improved. Therefore, this case is preferred.

The s and Z in the general formula (3) are the same as the above, the Z is preferable to be the general formula (4) or (5) from the viewpoint of the solubility to a developer of an alkaline aqueous solution. Also in this case, in the same manner as the case of the formulae (2-1) and (2-2), the acidity of the phenolic hydroxy group becomes higher, and the solubility to the developer that is an alkaline aqueous solution is improved. Therefore, this case is preferred.

The alkali-soluble resin (A-1) of the present invention may furthermore contain a structural unit represented by the following general formula (17) (hereinafter, also referred to as a structural unit (17)), in addition to the structural units shown by the general formulae (2) and (3). 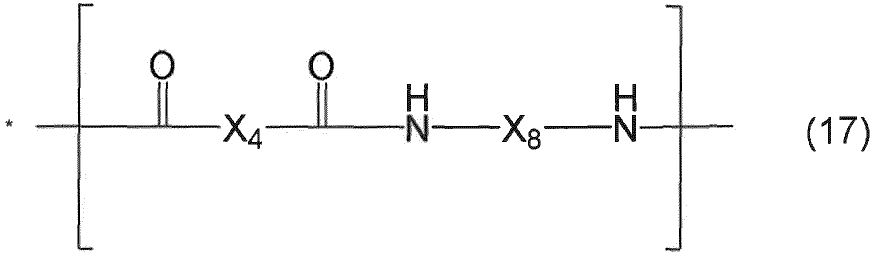 In the formula, the X₄ is the same as the above. X₈ is a divalent organic group.

The X₈ in the general formula (17) is a divalent organic group, as long as it is a divalent organic group, there is no restriction, and it is preferable to be a divalent organic group having 6 to 40 carbon atoms, and a cyclic organic group having an aromatic ring having a substitution group or a cyclic organic group containing 1 to 4 aliphatic rings, or an aliphatic group or a siloxane group not having a cyclic structure. Furthermore, as the preferable X₈, a structure shown by the following formula (18) or (19) is exemplified. The structure of the X₈ may be one kind or a combination of two or more kinds. 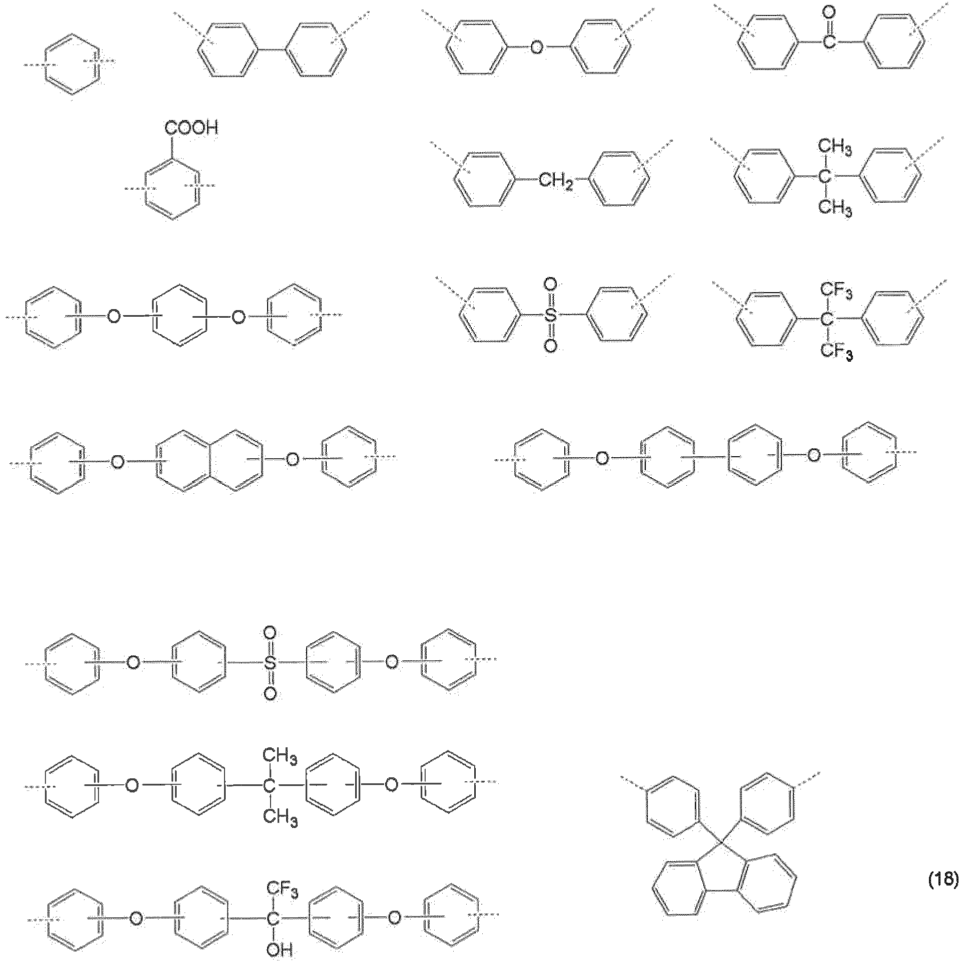 In the formulae, a dotted line represents a bond. 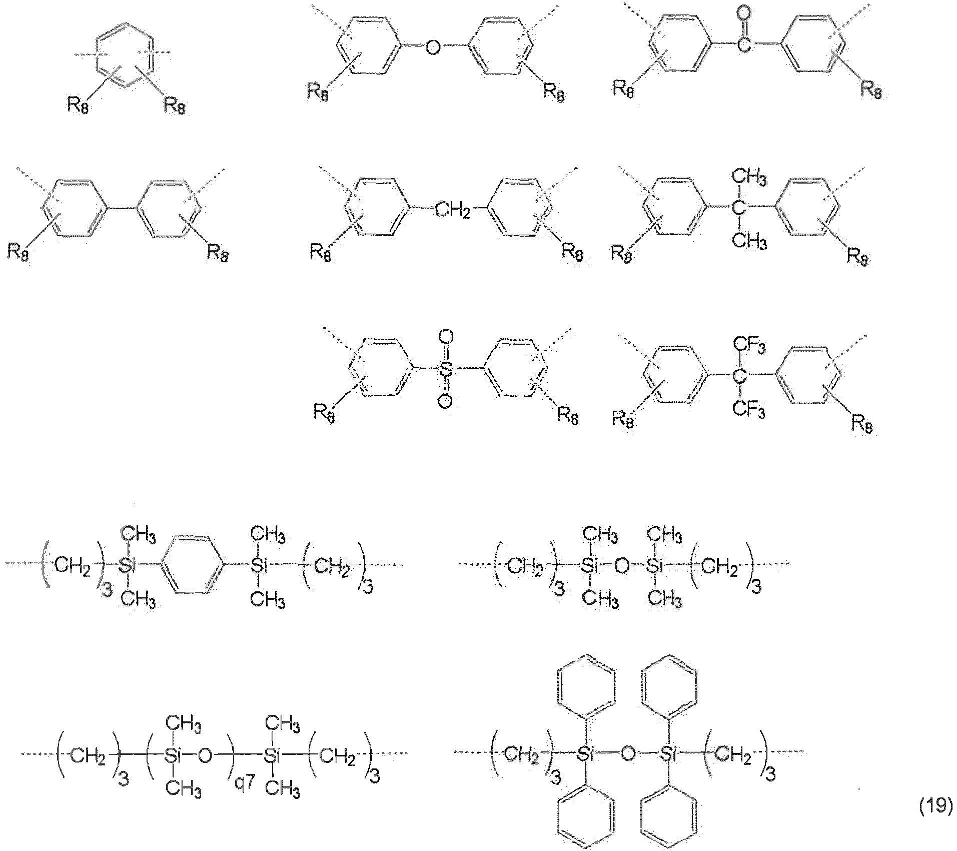 In the formulae, a dotted line represents a bond with an amino group, R₈s each represent independently a methyl group, an ethyl group, a propyl group, an n-butyl group, or a trifluoromethyl group, and q₇ represents a positive number of 2 to 20.

Furthermore, the alkali-soluble resin (A-1) of the present invention may furthermore contain a structural unit shown by the following general formula (20) (hereinafter, also referred to as structural unit (20)), in addition to the structural units shown by the general formulae (2) and (3). 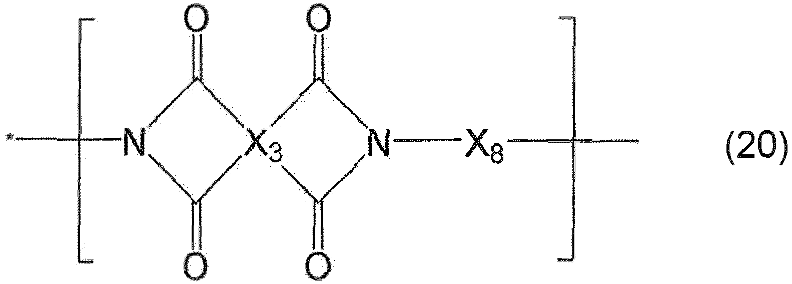 In the formula, X₃ and X₈ are the same as those shown above.

The alkali-soluble resin (A-1) of the present invention is preferable to furthermore contain a structural unit shown by the following general formula (6) (hereinafter, also referred to as structural unit (6)), in addition to the structural units shown by the general formulae (2) and (3). 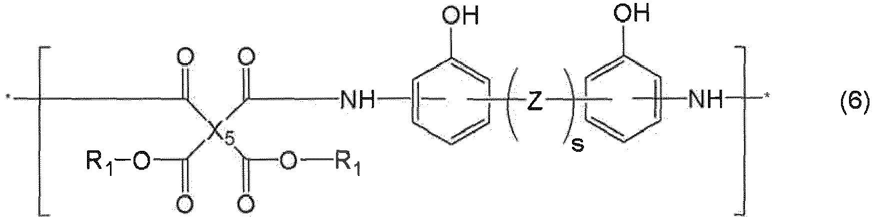 In the formula, X₅ is the same tetravalent organic group as or different from the X₃, R₁ is a group represented by the following general formula (7), and s and Z are the same as the above. 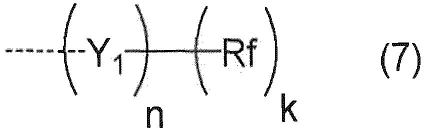 In the formula, a dotted line represents a bond, Y₁ is an organic group with a valency of (k+1), Rf is a linear branched, or cyclic alkyl group having 1 to 20 carbon atoms or an aromatic group optionally substituted with an alkyl group in which a part or all of hydrogen atoms are substituted with fluorine atoms, "k" represents 1, 2 or 3, and "n" represents 0 or 1.

The alkali-soluble resin (A-1) which is contained in the structural unit (6) improves the solubility to a general-purpose organic solvent such as propylene glycol monomethyl ether acetate, and thus a solvent of the composition may be used limitlessly.

As the Y₁ in the general formula (7), a linear or branched divalent organic group (for example, alkylene group) having 1 to 6 carbon atoms is preferable.

Furthermore, R₁ in the general formula (6) is preferable to be an organic group selected from groups shown by the following formulae (10), (11), (12), and (13). Regarding the following formula (11), an organic group represented by the following formula (11') is more preferable. 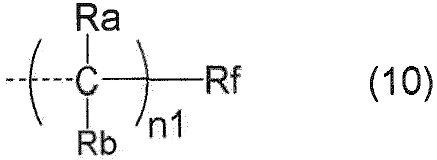 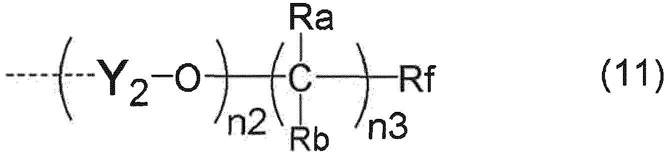 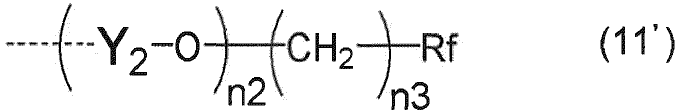 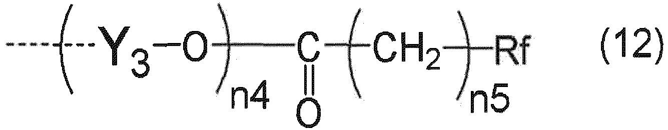 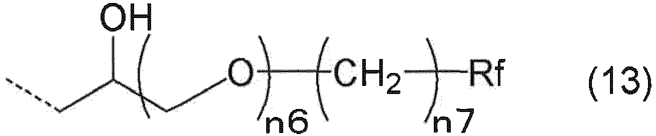 In the formulae, a dotted line represents a bond, Rf is the same as the above, Ra and Rb each are a hydrogen atom or an alkyl group having 1 to 3 carbon atoms, Y₂ and Y₃ each are a linear or branched alkylene group having 1 to 6 carbon atoms, n1 represents an integer of 0 to 6, n2 represents an integer of 1 to 6, n3 represents an integer of 0 to 6, n4 represents an integer of 1 to 6, n5 represents an integer of 0 to 6, n6 represents 0 or 1, and n7 represents an integer of 0 to 6.

In the organic group shown by the general formula (10), as a preferred organic group, the followings may be exemplified. However, there is no restriction to these. 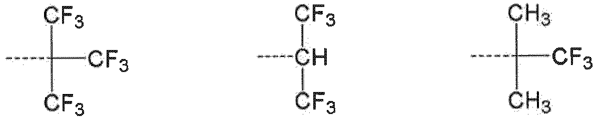 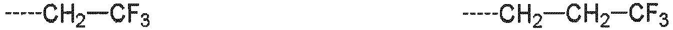 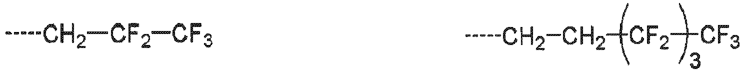 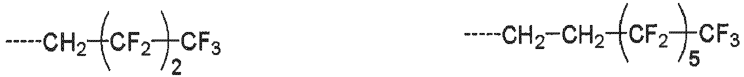 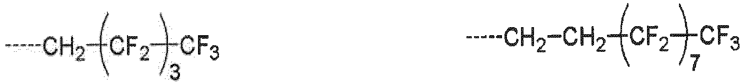 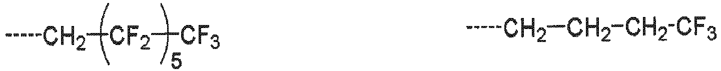 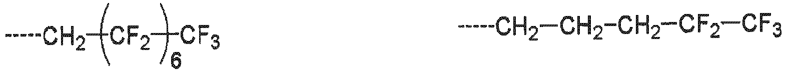 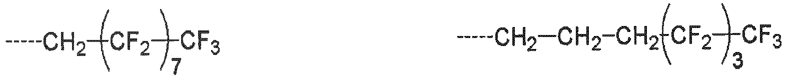 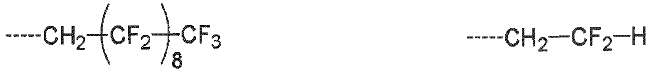 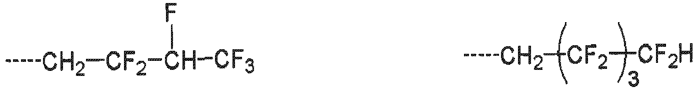 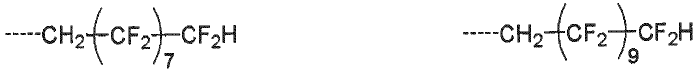 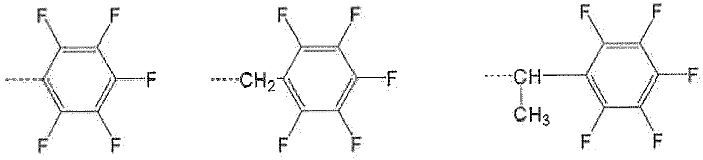 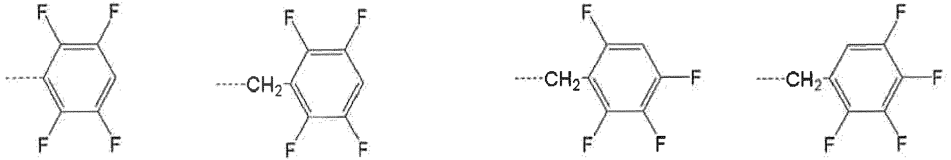 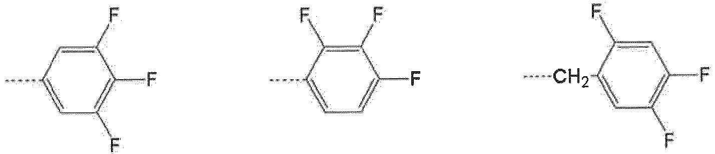 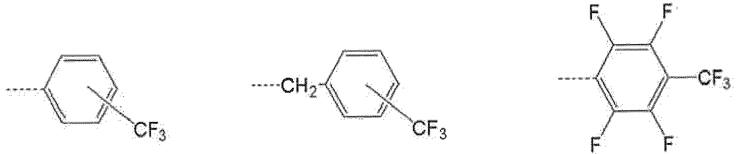 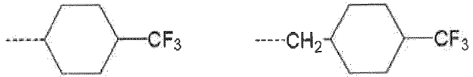 In the formulae, a dotted line represents a bond.

In the organic group shown by the general formula (11), as a preferred organic group, the followings may be exemplified. However, there is no restriction to these. 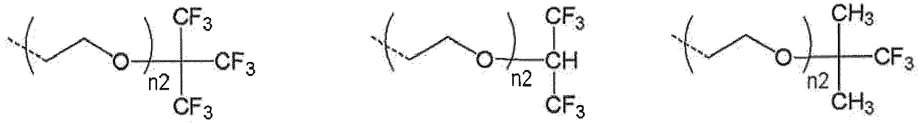 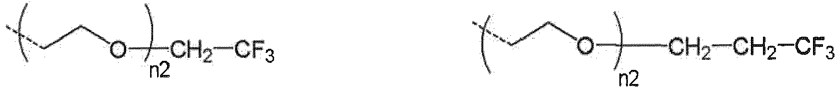 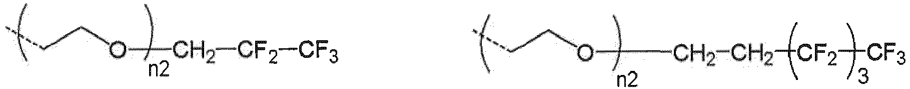 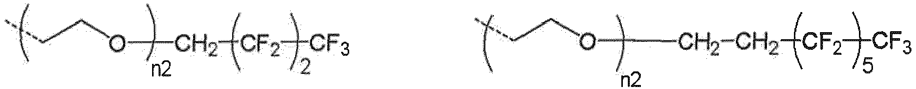 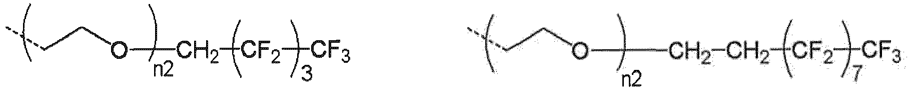 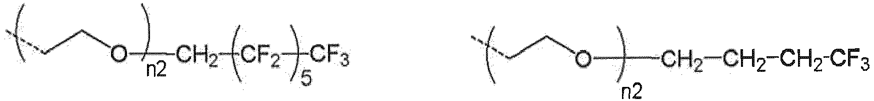 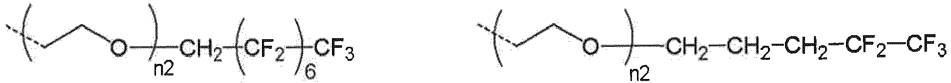 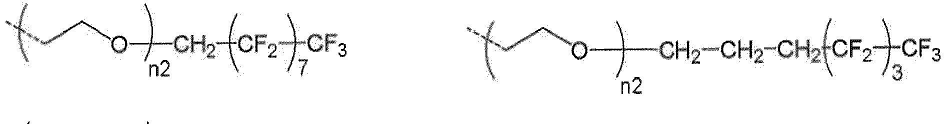 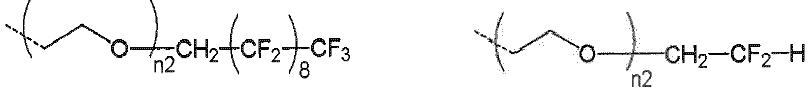 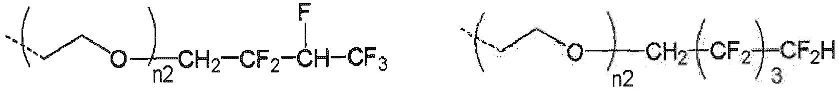 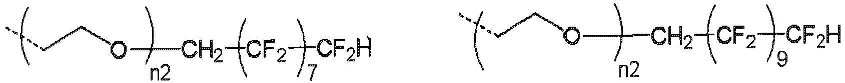 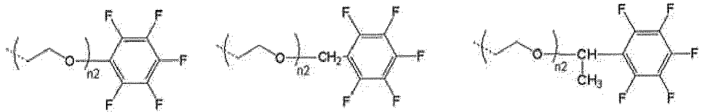 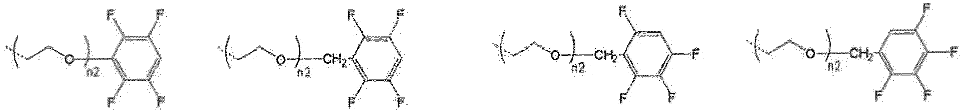 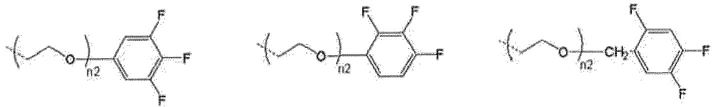 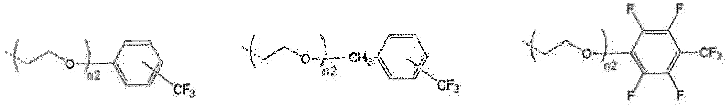 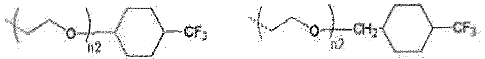 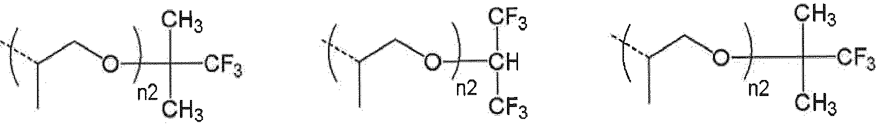 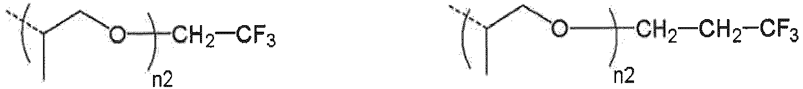 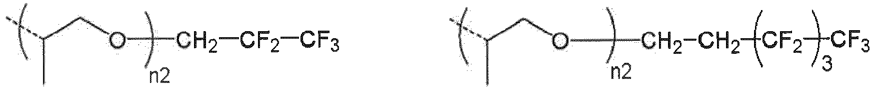 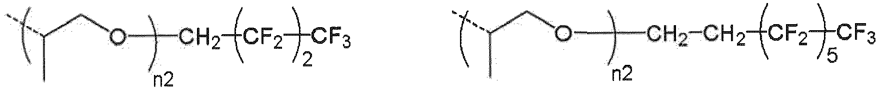 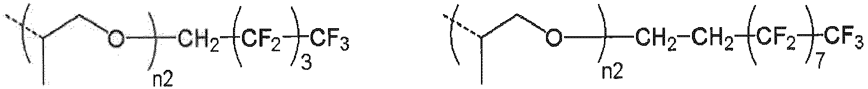 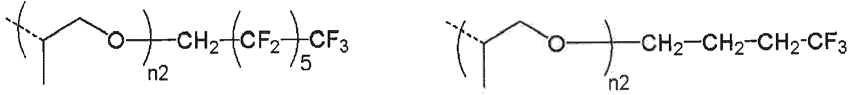 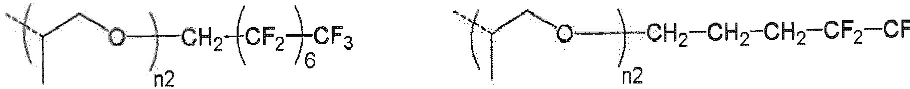 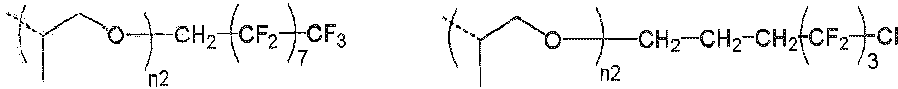 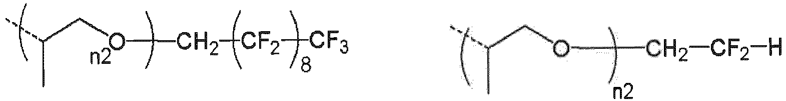 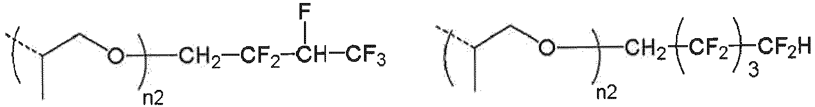 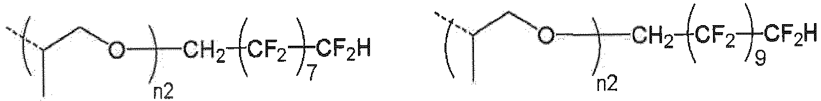 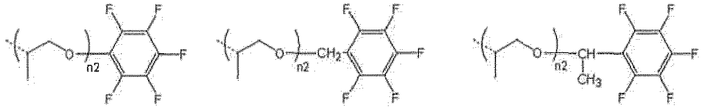 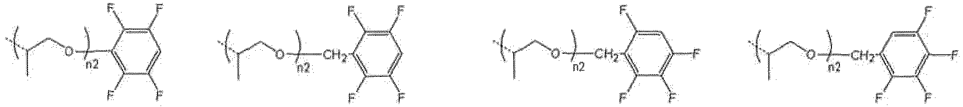 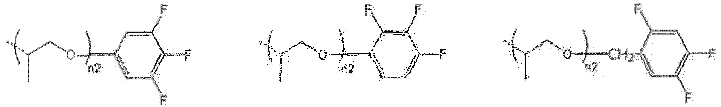 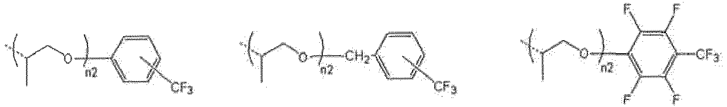 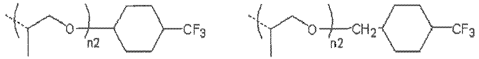 In the formulae, a dotted line represents a bond, "n2" represents an integer of 1 to 6, preferably an integer of 1 to 3, more preferably 1 or 2, and most preferably 1.

In the organic group shown by the general formula (12), as a preferred organic group, the followings may be exemplified. However, there is no restriction to these. 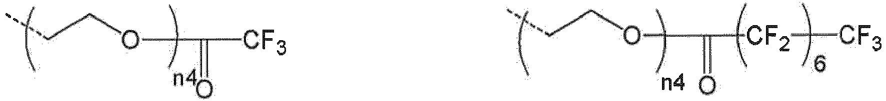 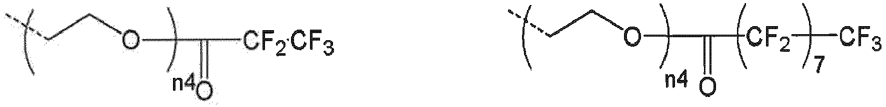 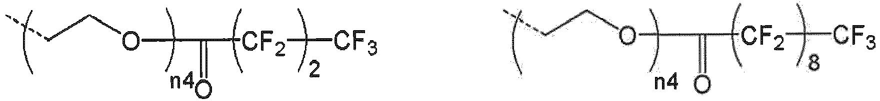 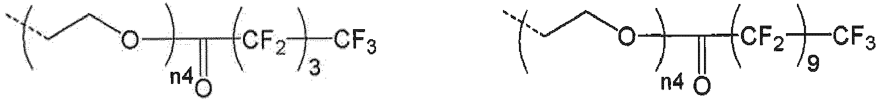 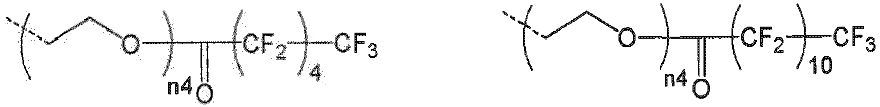 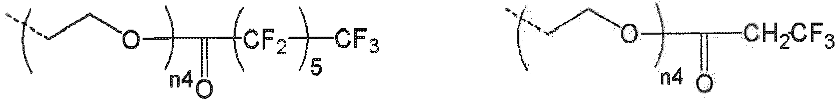 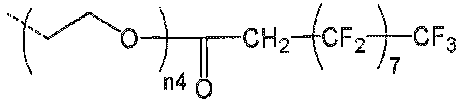 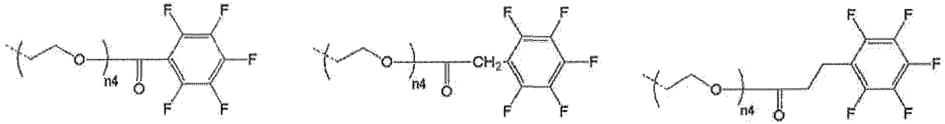 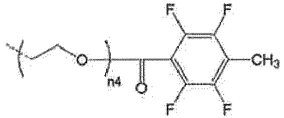 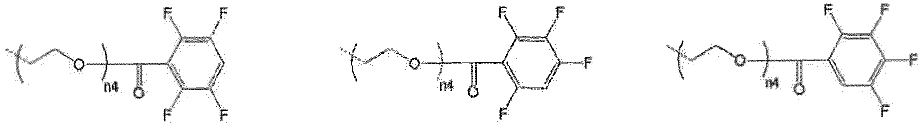 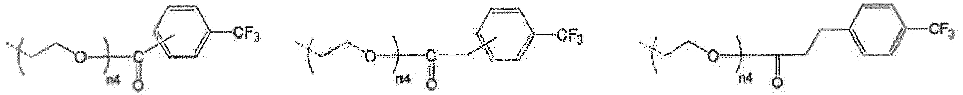 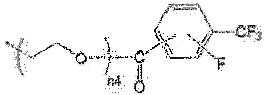 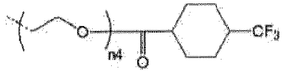 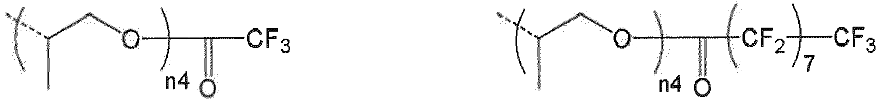 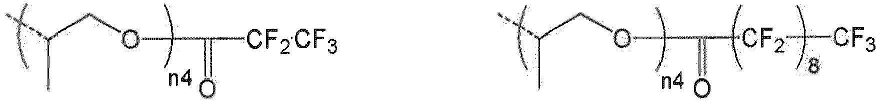 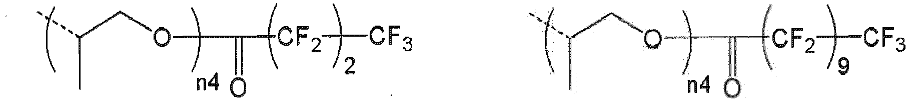 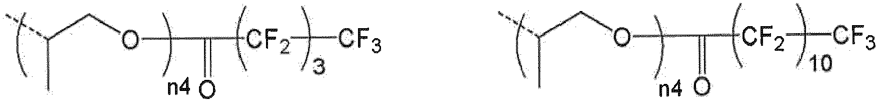 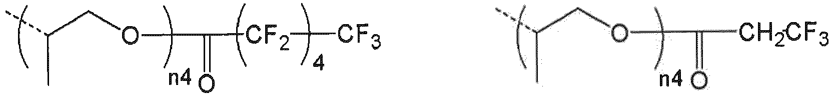 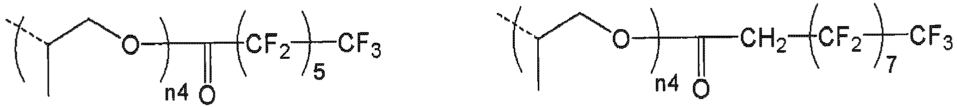 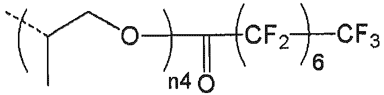 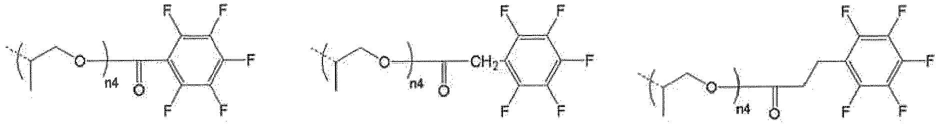 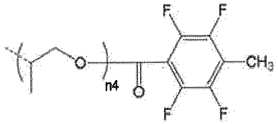 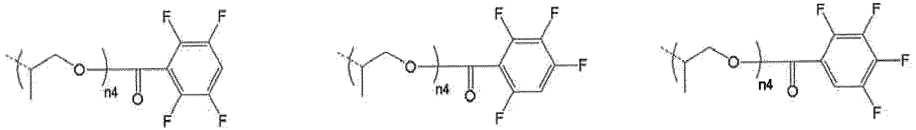 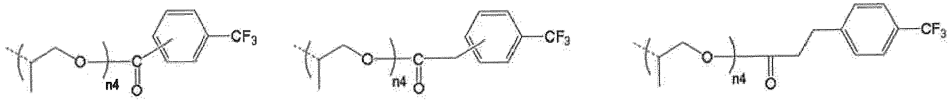 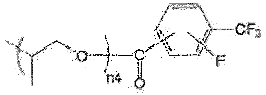 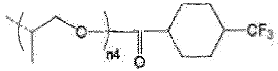 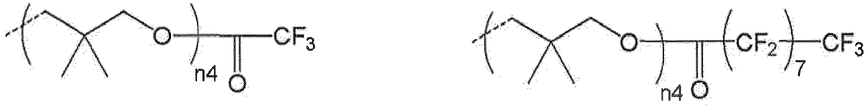 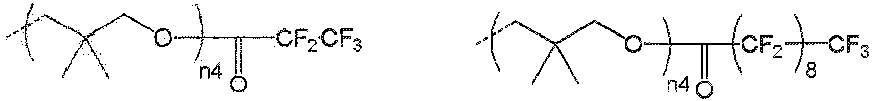 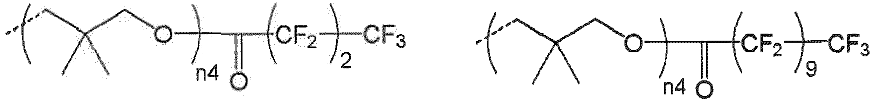 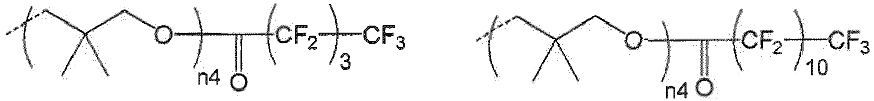 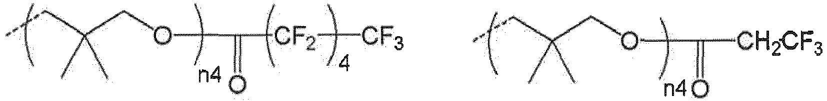 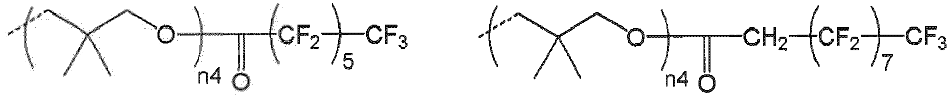 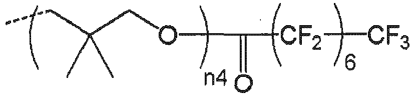 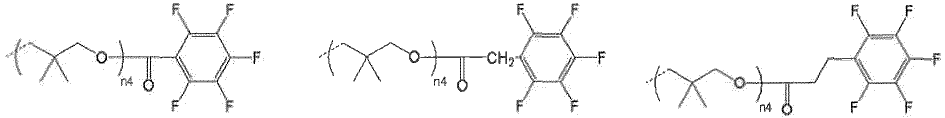 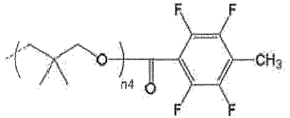 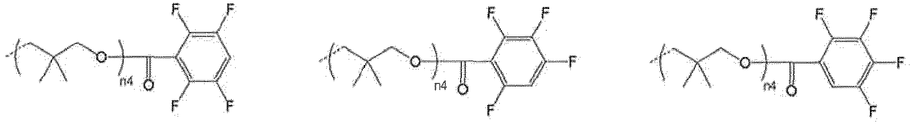 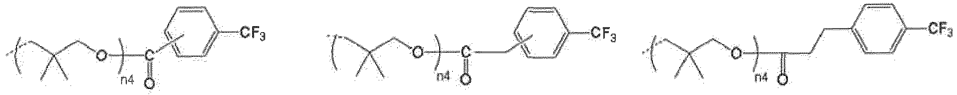 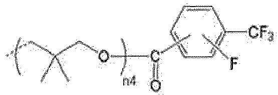 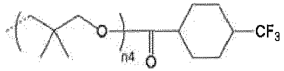 In the formula, a dotted line represents a bond, "n4" represents an integer of 1 to 6, preferably an integer of 1 to 3, more preferably 1 or 2, and most preferably 1.

In the organic group shown by the general formula (13), as a preferred organic group, the followings may be exemplified. However, there is no restriction to these. 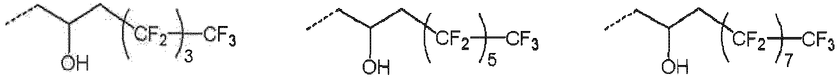 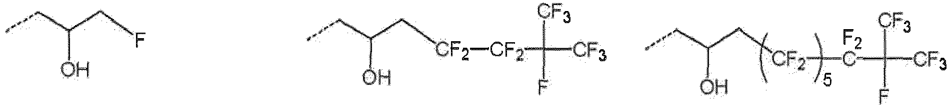 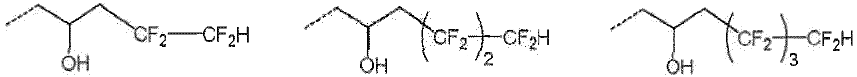 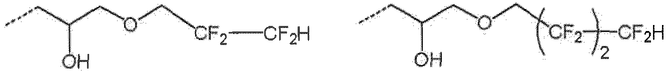 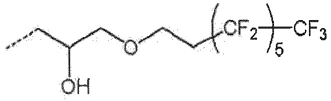 In the formula, a dotted line represents a bond.

Here, after performing the patterning with the positive photosensitive resin composition of the present invention, in the heating of the post-curing, in a structural unit of a polyimide precursor shown by the general formula (6), a ring-closure reaction for imidization proceeds. At this time, the introduced R₁ is eliminated and removed from a system to observe a thickness of a formed film decrease. Accordingly, in order to keep a thickness reduction at a minimum level during the post-curing, the more preferred R₁ may have a small molecular weight.

The alkali-soluble resin (A-1) of the present invention preferably furthermore contains a structural unit shown by the following general formula (8) (hereinafter, referred to as a structural unit (8)) in addition to the structural units shown by the general formulae (2) and (3). 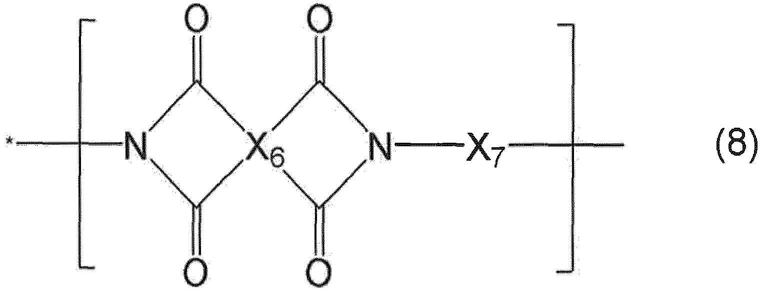 In the formula, X₆ is the same tetravalent organic group as or different from X₃, and X₇ is a group represented by the following general formula (9). 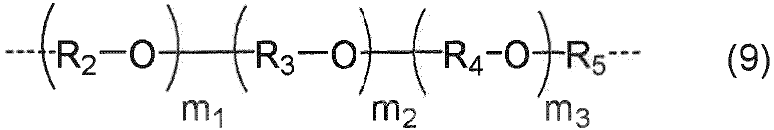 In the formula, R₂ to R₅ each is independently a linear or branched alkylene group having 2 to 10 carbon atoms, m₁ is an integer of 1 to 40, m₂, m₃ each is independently an integer of 0 to 40.

X₆ in the formula (8) may be a tetravalent organic group cited as X₃, for example, a tetravalent organic group shown by the above formula (14). With regard to X₇ (a group shown by the general formula (9)), the followings may be exemplified as a preferred organic group. There is no restriction to these.

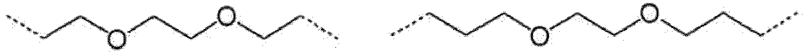

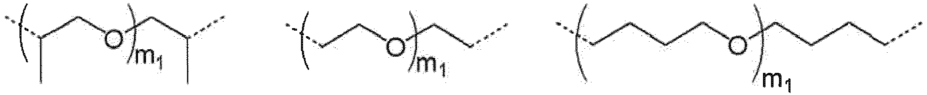

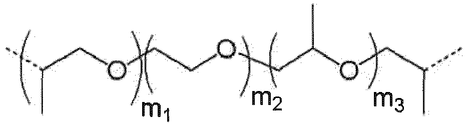

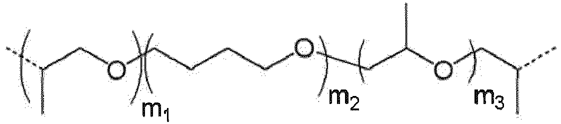

When the alkali-soluble resin (A-1) contains a structural unit (8) like this, the flexibility is generated to obtain a cured film having high elongation and low warpage.

### (Production Method of Alkali-soluble Resin (A-1))

The alkali-soluble resin (A-1) of the present invention contains structures represented by the following general formula (2) and/or (3). 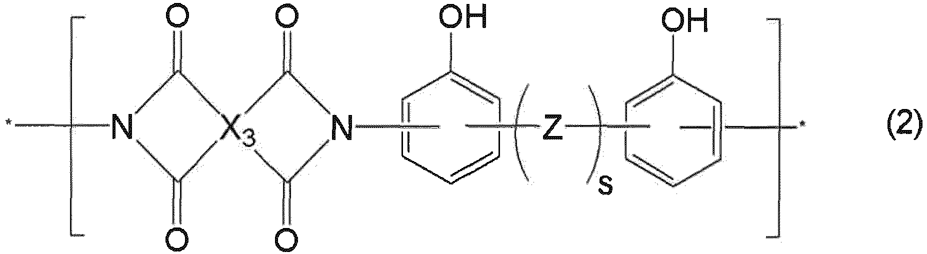 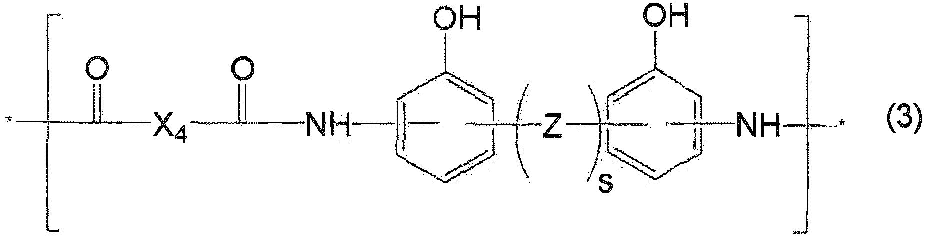 In the formulae, X₃, X₄, s and Z are the same as the above.

An alkali-soluble resin containing the structural unit represented by the general formula (2) may be obtained by reacting tetracarboxylic dianhydride represented by the following general formula (21) and a diamine represented by the following general formula (22). Firstly, the tetracarboxylic dianhydride shown by the following general formula (21) and the diamine shown by the following general formula (22) are reacted to synthesize amide acid, followed by heating and dehydrating to form an imide ring to be able to obtain a polymer containing the structural unit (2).

The structural unit (2) may be produced by performing the following steps in sequence: dissolving diamine in a solvent having a high boiling point and high polarity such as γ-butyrolactone or N-methyl-2-pyrrolidone, adding an acid anhydride, reacting at 0 to 80°C, preferably 10 to 50°C to form an amide acid, adding a nonpolar solvent such as xylene, and heating to 100 to 200°C, preferably to 130 to 180°C to perform an imidization reaction while removing water from a reaction system. 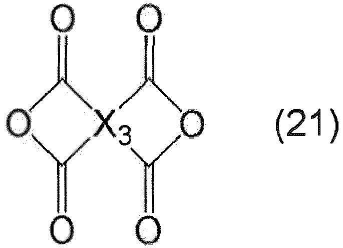 In the formula, X₃ is the same as the above. 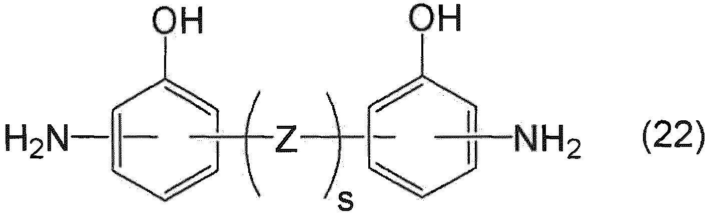 In the formula, s and Z are the same as the above.

Preferred examples of tetracarboxylic dianhydrides shown by the general formula (21) include an aromatic dianhydride, an alicyclic dianhydride, an aliphatic dianhydride. Examples of the aromatic dianhydride include pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxydiphthalic dianhydride, 2,3,3',4'-oxypdihthalic dianhydride, 2,3,2*'*,3*'*-oxydiphthalic dianhydride, diphenylsulfone-3,3',4,4'-tetracarboxylic dianhydride, benzophenone-3,3*'*,4,4*'*-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-bis(3,4-dicarboxyphenoxy)benzene dianhydride, p-phenylene bis (trimellitic acid monoester anhydride), bis(1,3-dioxo-1,3-dihydroisobenzofuran-5-carboxylic acid)-1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl)fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis (trifluoromethyl)-4,4*'*-bis(3,4-dicarboxyphenoxy)biphenyl dianhydride, 2,2*'*-bis[(dicarboxyphenoxy)phenyl]propane dianhydride, 2,2'-bis[(dicarboxyphenoxy)phenyl]hexafluoropropane dianhydride, and acid dianhydride compounds obtained by substituting the aromatic rings of these by an alkyl group, an alkoxy group, a halogen atom but are not limited to these.

Examples of the alicyclic dianhydride include 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3.3.0]octane-2,4,6,8-tetracarboxylic dianhydride, bicyclo[4.3.0]nonane-2,4,7,9-tetracarboxylic dianhydride, bicyclo[4.4.0]decane-2,4,7,9-tetracarboxylic dianhydride, bicyclo[4.4.0]decane-2,4,8,10-tetracarboxylic dianhydride, tricyclo[6.3.0.0^{2,6}]undecane-3,5,9,11-tetracarboxylic dianhydride, bicyclo[2.2.2]octane-2,3,5,6-tetracarboxylic dianhydride, bicyclo[2.2.2]oct-7-ene-2,3,5,6-tetracarboxylic dianhydride, bicyclo[2.2.1]heptanetetracarboxylic dianhydride, bicyclo[2.2.1]heptane-5-carboxymethyl-2,3,6-tricarboxylic dianhydride, 7-oxabicyclo[2.2.1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic anhydride, and "RIKACID" (Registered trademark) BT-100 (all tradenames, available from New Japan Chemical Co., Ltd.) and their derivatives, or an acid dianhydride compound in which an alicyclic ring of the above is substituted with an alkyl group, an alkoxy group, a halogen atom, but are not limited to these.

Examples of the aliphatic dianhydride include 1,2,3,4-butanetetracarboxylic dianhydride, 1,2,3,4-pentanetetracarboxylic dianhydride, and derivatives thereof, without limiting to these.

These aromatic dianhydrides, alicyclic dianhydrides, or aliphatic dianhydrides may be used singularly or in a combination of two or more kinds.

In the general formula (22), s represents 0 or 1, in the case of s=0, two aromatic rings in the general formula (22) are directly bonded without the divalent linking group Z.

In the case of s=1 in the general formula (22), Z in the general formula (22) is not restricted as long as Z is a divalent group. As was described above, a divalent organic group of an alicyclic aliphatic group having 4 to 40 carbon atoms or aromatic group is preferred, and a divalent linking group shown by the formula (15) is more preferred. Furthermore, a structure of the Z may be one kind or a combination of two or more kinds.

Furthermore, preferable examples of the diamine shown by the general formula (22) are compounds shown by the following general formulae (23), (24).

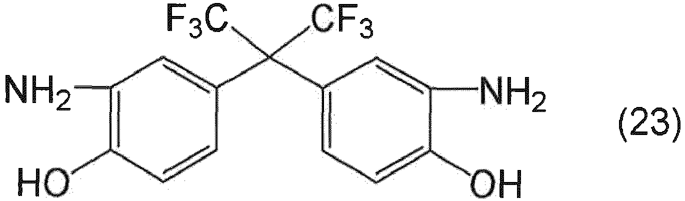

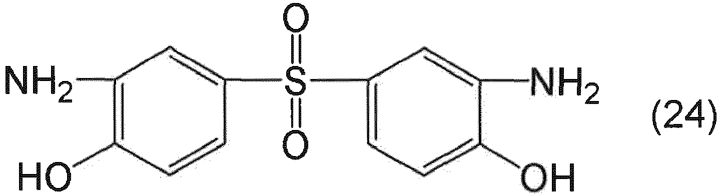

An alkali-soluble resin obtained by reacting the diamine shown by the general formula (23) and tetracarboxylic dianhydride shown by the general formula (21) becomes a polymer containing a structural unit shown by the general formula (2-1) that is a preferable structural unit.

Alternatively an alkali-soluble resin obtained by reacting the diamine shown by the general formula (24) and tetracarboxylic dianhydride shown by the general formula (21) becomes a polymer containing a structural unit shown by the general formula (2-2) that is a preferable structural unit.

The alkali-soluble resin containing the structural unit (3) may be obtained by reacting a dicarboxylic acid compound shown by the following general formula (25) and diamine shown by the general formula (22). 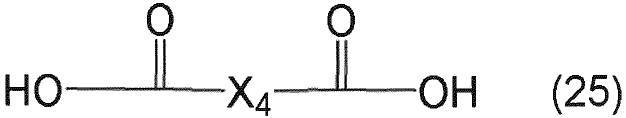 In the formula, X₄ is the same as the above.

Here, a polymer containing a structural unit (3) may be obtained by reacting, for example, a dicarboxylic acid compound shown by the general formula (25) and diamine shown by the general formula (22) under the presence of a dehydration condensation agent. That is, the polymer containing the structural unit (3) may be produced by performing the following steps in sequence: dissolving the dicarboxylic acid compound shown by the general formula (25) in a reaction solvent to use a resultant in a reaction, charging and mixing a well-known dehydration condensation agent such as dicyclohexylcarbodiimide, 1-ethoxycarbonyl-2-ethoxy-1, 2-dihydroquinone, 1,1-carbonyldioxy-di-1,2,3-benzotriazole, or N,N'-discuccinimidyl carbonate in the reaction solution with icing to convert the dicarboxylic acid compound shown by the general formula (25) to an acid anhydride, and adding dropwise solution or dispersion of diamine shown by the general formula (22) separately in a solvent to the acid anhydride to cause a polycondensation.

As another method of obtaining a polymer containing the structural unit (3) by reacting the dicarboxylic acid compound shown by the general formula (25) and diamine (a diamine compound) shown by the general formula (22), there is an exemplary method in which a dicarboxylic acid compound shown by the general formula (25) is converted to an acid chloride by using a chlorinating agent such as thionyl chloride or dichlorooxalic acid, followed by reacting with diamine shown by the general formula (22) to synthesize.

In a reaction in which the dicarboxylic acid compound described above is converted to an acid chloride with a chlorinating agent, a basic compound may be used together. As the basic compound, for example, pyridine, 4-dimethylaminopyridine, triethyl amine may be used.

Next, the obtained acid chloride of the dicarboxylic acid compound and the diamine shown by the general formula (22) are reacted under the presence of a basic catalyst, so that a polymer containing a structural unit (3) of a target is able to be obtained. At this time, as the basic catalyst such as pyridine, dimethylaminopyridine, 1,8-diazabicyclo[5.4.0]undeca-7-ene or 1,5-diazabicyclo[4.3.0]nona-5-ene may be used.

Among methods of producing the alkali-soluble resin of the present invention, as a solvent used in a method that undergoes the acid chloride, one that well dissolves the dicarboxylic acid compound and their acid chlorides, and furthermore the polymer obtained by a polycondensation reaction with diamines is preferable. Specifically, N-methyl-2-pyrohlidone, N,N-dimethylacetamide, N,N-dimethylformamide, dimethylsulfoxide, tetramethylurea, hexamethylphosphoric triamide, γ-butyrolactone may be used. Other than the polar solvent, also ketones, esters, lactones, ethers, halogenated hydrocarbons or hydrocarbons may be used. For example, acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dicycloethane, 1,4-dicyclobutane, trichloroethylene, chlorobenzene, o-dichlorobenzene, hexane, heptane, octane, benzene, toluene, xylene may be used. These organic solvents may be used singularly or in a combination of two or more kinds.

Suitable examples of the X₄ in the dicarboxylic acid compounds shown by the general formula (25), the same as the above may be used.

Furthermore, examples of the dicarboxylic acid compound shown by the general formula (25) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid and diglycolic acid.

Examples of the dicarboxylic acid compound having an aromatic ring include phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyl dicarboxylic acid, 3,4'-biphenyl dicarboxylic acid, 3,3'-biphenyl dicarboxylic acid, 4,4'-benzophenone dicarboxylic acid, 3,4'-benzophenone dicarboxylic acid, 3,3'-benzophenone dicarboxylic acid, 4,4'-hexafluoroisopropylidene dibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxyphenyl)propane, 2,6-naphthalene dicarboxylic acid, but are not limited to these. Furthermore, these materials may be used singularly or in a combination of these.

As preferable examples as s and Z in the general formula (22), the same as the above examples may be used.

As was described above, the alkali-soluble resin (A-1) of the present invention may furthermore contain the following structural units (17) and/or (20). 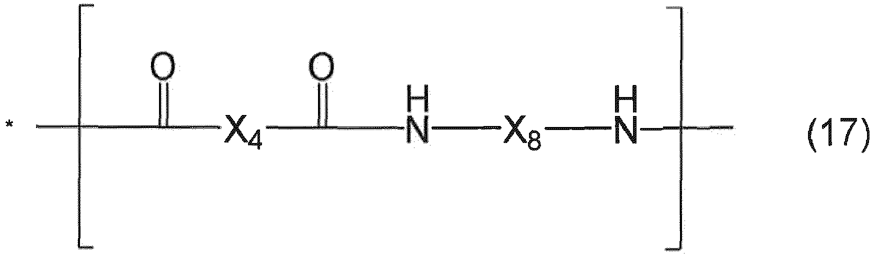 In the formula, X₄ and X₈ are the same as the above. 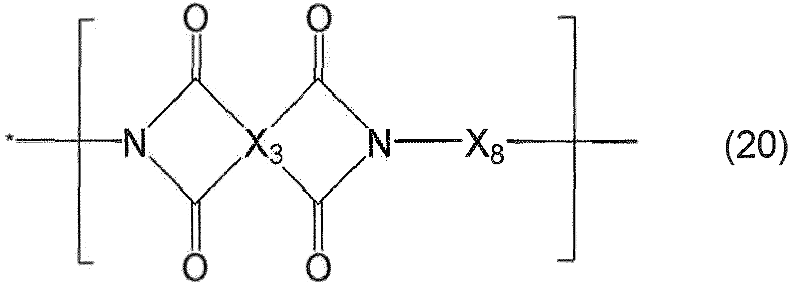 In the formula, X₃ and X₈ are the same as the above.

The alkali-soluble resin containing the structural unit (17) may be obtained by simultaneously reacting a dicarboxylic acid compound shown by the general formula (25) and both of diamine shown by the general formula (22) and diamine shown by the following formula (26). Exemplarily, the alkali-soluble resin containing the structural unit (17) may be obtained by the similar method of producing the polymer containing the structural unit (3). Specifically, the method includes performing a reaction under the presence of the dehydration condensation agent or a reaction of converting to an acid chloride with a chlorinating agent, followed by reacting with the diamine.

**H₂N-X₈-NH₂** **(26)**

In the formula, X₈ is the same as the above.

As the diamine shown by the general formula (26), an aromatic diamine, an alicyclic diamine and an aliphatic diamine may be exemplified. Examples of the preferable aromatic diamine include 3,4'-diaminodiphenyl ether, 4,4'-diaminodiphenyl ether, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenylsulfide, 4,4'-diaminodiphenylsulfide, 1,4-bis(4-aminophenoxy)benzene, benzidine, 2,2'-bis(trifluoromethyl)benzidine, 3,3'-bis(trifluoromethyl)benzidine, 2,2'-dimethylbenzidine, 3,3'-dimethylbenzidine, 2,2'3,3'-tetramethylbenzidine, 2,2'-dichlorobenzidine, 3,3'-dichlorobenzidine, 2,2'3,3'-tetrachlorobenzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis[4-(3-aminophenoxy)phenyl]sulfone, bis(4-aminophenoxy)biphenyl, bis{4-(4-aminophenoxy)phenyl} ether, 1,4-bis(4-aminophenoxy)benzene, 9,9-bis(4-aminophenyl)fluorene, 2,2'-bis[3-(3-aminobenzamide)-4-hydroxyphenyl]hexafluoropropane, 4-aminophenyl-4'-aminobenzoate, 4,4'-diaminobenzanilide, or a diamine compound in which the aromatic ring of the above is substituted with an alkyl group, an alkoxyl group, a halogen atom, but are not limited to these.

Examples of the alicyclic diamine include cyclobutanediamine, isophoronediamine, bicyclo[2.2.1]heptanebismethylamine, tricyclo[3.3.1.1^{3.7}]decane-1,3-diamine, 1,2-cyclohexyldiamine, 1,3-cyclohexyldiamine, 1,4-diaminocyclohexane, trans-1,4-diaminocyclohexane, cis-1,4-diaminocyclohexane, 4,4'-diaminodicyclohexylmethane, 3,3'-dimethyl-4,4'-diaminodicyclohexylmethane, 3,3'-diethyl-4,4'-diaminodicyclohexylmethane, 3,3',5,5'-tetramethyl-4,4'-diaminodicyclohexylmethane, 3,3',5,5'-tetraethyl-4,4'-diaminodicyclohexylmethane, 3,5-diethyl-3',5'-dimethyl-4,4'-diaminodicyclohexylmethane, 4,4'-diaminodicyclohexyl ether, 3,3'-dimethyl-4,4'-diaminodicyclohexyl ether, 3,3'-diethyl-4,4'-diaminodicyclohexyl ether, 3,3',5,5'-tetramethyl-4,4'-diaminodicyclohexyl ether, 3,3',5,5'-tetraethyl-4,4'-diaminodicyclohexyl ether, 3,5-diethyl-3',5'-dimethyl-4,4'-diaminodicyclohexyl ether, 2,2-bis(4-aminocyclohexyl)propane, 2,2-bis(3-methyl-4-aminocyclohexyl)-propane, 2,2-bis(3-ethyl-4-aminocyclohexyl)propane, 2,2-bis(3,5-dimethyl-4-aminocyclohexyl)propane, 2,2-bis(3,5-diethyl-4-aminocyclohexyl) propane, 2,2-(3,5-diethyl-3',5'-dimethyl-4,4'-diaminodicyclohexyl)propane, or a diamine compound in which an aliphatic ring of the above is substituted with an alkyl group, an alkoxyl group, a halogen atom, but are not limited to these.

Examples of the aliphatic diamine include: alkylene diamines such as ethylenediamine, 1,3-diaminopropane, 1,4-diaminobutane, 1,5-diaminopentane, 1,6-diaminohexane, 1,7-diaminoheptane, 1,8-diaminooctane, 1,9-diaminononane, 1,10-diaminodecane; ethylene glycol diamines such as bis(aminomethyl) ether, bis(2-aminoethyl) ether, bis(3-aminopropyl) ether; and siloxanediamines such as 1,3-bis(3-aminopropyl)tetramethyldisiloxane, 1,3-bis(4-aminobutyl)tetramethyldisiloxane, α,ω-bis(3-aminopropyl)polydimethylsiloxane, but are not limited to these.

These aromatic diamines, alicyclic diamines, or aliphatic diamines may be used singularly or in a combination of two or more kinds.

Preferably, siloxanediamines may be also used.

The alkali-soluble resin containing the structural unit (20) may be obtained by performing the same reaction procedure for the structural unit (2). Exemplarily, a mixture of a diamine shown by the general formula (22) and a diamine shown by the general formula (26) reacts with a tetracarboxylic dianhydride shown by the general formula (21) to synthesize an amide acid, followed by performing a heating and dehydrating step to form an imide ring to obtain the alkali-soluble resin containing the structural unit (20).

As was described above, the alkali-soluble resin (A-1) of the present invention may furthermore contains the following structural unit (6).

A polymer having the structural unit shown by the general formula (6) may be obtained by reacting a tetracarboxylic acid diester compound shown by the following formula (27) and a diamine shown by the general formula (22). Exemplarily, the polymer may be obtained by the similar method of producing a polymer containing the structural unit (3), the method including a reaction under the presence of the dehydration condensation agent or a reaction for converting to an acid chloride by using a chlorinating agent, followed by reacting with the diamine. 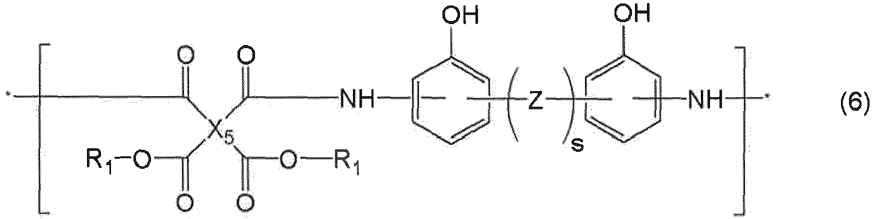 In the formula, X₅, R₁, s, and Z are the same as the above. 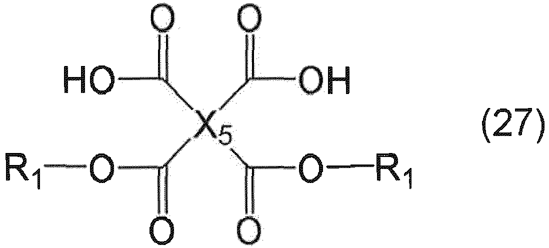 In the formula, R₁ and X₅ are the same as the above.

As a method of producing the tetracarboxylic acid diester compound shown by the general formula (27), a method of introducing R₁ is exemplified. In the method, the tetracarboxylic dianhydride shown by the general formula (28) reacts with a compound having a hydroxy group at a terminal shown by the general formula (29) under the presence of a basic catalyst such as pyridine. Here, the tetracarboxylic dianhydride shown by the following general formula (28) is an origin of the tetravalent organic group X₅ in the general formula (6), for example, shown by the formula (14). The compound having a hydroxy group at a terminal shown by the following general formula (29) allows to introduce a group shown by the general formula (7). 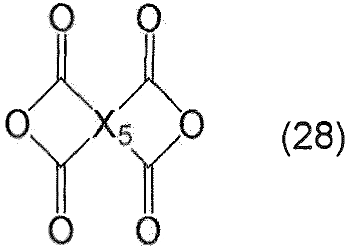 In the formula, X₅ is the same as the above. 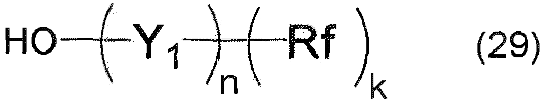 In the formula, Y₁, Rf, k and n are the same as the above.

As the tetracarboxylic dianhydride shown by the general formula (28), examples shown by the tetracarboxylic dianhydride shown by the general formula (21) are cited as preferred examples.

In a reaction between the tetracarboxylic dianhydride shown by the general formula (28) and a compound having a hydroxy group at a terminal shown by the general formula (29), both of them are stirred, dissolved and mixed over 4 to 10 hours at a reaction temperature of 20 to 50°C, in a reaction solvent, under the presence of a basic catalyst such as pyridine to forward a half esterification reaction of the acid dianhydride. A solution in which the desired tetracarboxylic acid diester compound shown by the general formula (27) is dissolved in a reaction solvent may be obtained.

The obtained tetracarboxylic acid diester compound may be isolated, or the obtained solution may be used as it is in a reaction with diamine in the next step described below.

The preferred reaction solvent is one that well dissolves the tetracarboxylic acid diester compound and a polymer having a structural unit of a polyimide precursor obtained by a polycondensation reaction performed next between the tetracarboxylic acid diester compound and the diamines. For example, N-methyl-2-pyrolidone, N,N-dimethyl acetamide, N,N-dimethyl formamide, dimethylsulfoxide, tetramethyl urea, and γ-butyrolactone may be used. Furthermore, ketones, esters, lactones, ethers, halogenated hydrocarbons, hydrocarbons may be used, specific example include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene and xylene. These may be used, as needs arise, singularly or in a combination of two or more kinds.

Preferable examples of the general formula (22) are the same as the above.

As was described above, the alkali-soluble resin (A-1) of the present invention may furthermore contain the following structural unit (8). 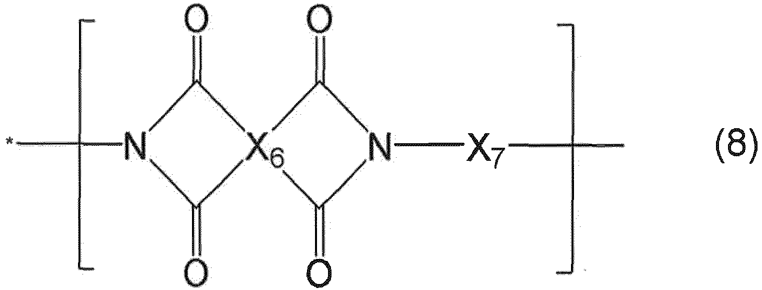 In the formula, X₆ and X₇ are the same as the above. 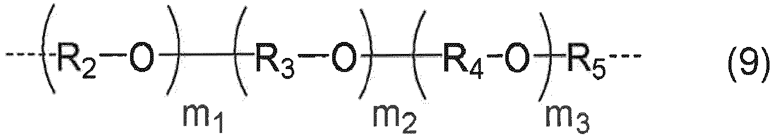 In the formula, R₂ to R₅, m₁, m₂ and m₃ are the same as the above.

The alkali-soluble resin containing the structural unit (8) may be obtained by performing the same reaction procedure as performed for the structural unit (2). Exemplarily, after an amide acid is synthesized by reaction between the tetracarboxylic dianhydride shown by the following general formula (30) and a mixture of the diamine shown by the general formula (22) and the diamine shown by the following general formula (31), an imide ring is formed by performing a heating and dehydration step to obtain the alkali-soluble resin containing the structural unit (8). 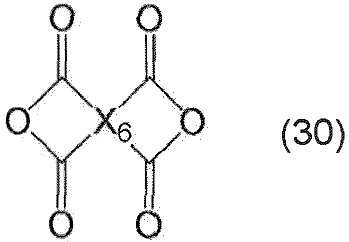 In the formula, X₆ is the same as the above. 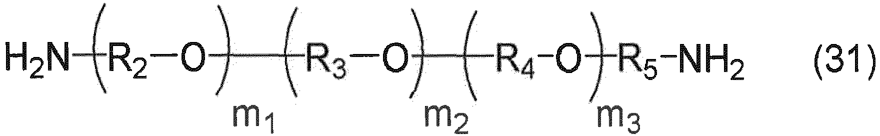 In the formula, R₂ to R₅, m₁, m₂ and m₃ are the same as the above.

As the tetracarboxylic dianhydride shown by the general formula (30), a preferable example includes one cited as the tetracarboxylic dianhydride shown by the general formula (21).

Examples of the diamine shown by the general formula (31) include 1,2-bis(aminoetoxy)ethane, HK-511, ED-600, ED-900, ED-2003, EDR-148, EDR-176, D-230, D-400, D-2000, THF-100, THF-140, THF-170, RE-600, RE-900, RE-2000, RP-405, RP-409, RP-2005, RP-2009, RT-1000, HE-1000, and HT-1700 (all trade names, manufactured by Huntsman Corporation), but are not limited to these.

### (Molecular weight of polymer and introduction of end blocking agent)

A preferable molecular weight of the alkali-soluble resin is preferably 5,000 to 100,000, and more preferably 7,000 to 30,000. When the molecular weight is 5,000 or larger, a photosensitive resin composition that includes the alkali-soluble resin as a base resin may be readily formed into a film having a desired film thickness on a substrate. When the molecular weight is 100,000 or smaller, the viscosity of the photosensitive resin composition does not become remarkable high, and there is no fear of failing to form a film.

The alkali-soluble resin may be blocked with an end blocking agent at both ends to control a molecular weight in the polycondensation reaction, and to suppress a temporal variation in molecular weight of the obtained polymer, that is, to suppress gelling. As the end blocking agent reacting with the acid dianhydride, a monoamine or monovalent alcohol may be exemplified. As the end blocking agent reacting with the diamine compound, an acid anhydride, a monocarboxylic acid, a monoacid chloride compound, a mono-active ester compound, dicarbonic acid esters, vinyl ethers may be exemplified. In addition, reaction of the end blocking agent allows various organic groups to be introduced into the terminal.

Examples of the monoamines used as a blocking agent for the terminal group of the acid anhydride include aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, but are not limited to these. These may be used singularly or in a combination of two or more kinds.

Examples of the monohydric alcohol used as a blocking agent for the terminal group of the acid anhydride include methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-eicosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentane monomethylol, dicyclopentane monomethylol, tricyclodecane monomethylol, norborneol, terpineol, but are not limited to these. These may be used singularly or in combination of two or more kinds.

Examples of the acid anhydride, the monocarboxylic acid, the monoacid chloride compound and the mono-active ester compound to be used as the blocking agent for the terminal amino group include: acid anhydrides such as phthalic anhydride, maleic anhydride, nadic anhydride, cyclohexanedicarboxylic anhydride, 3-hydroxyphthalic anhydride; monocarboxylic acids such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid, 8-ethynyl-2-naphthoic acid, and monoacid chloride compounds obtained by chlorination of carboxyl groups of the above; monoacid chloride compounds in which one carboxyl group of the dicarboxylic acids is chlorinated such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene, 2,7-dicarboxynaphthalene; and active ester compounds obtained by the reaction of a monoacid chloride compound and either N-hydroxybenzotriazole or N-hydroxy-5-norbornene-2,3-dicarboxyimide.

Examples of the dicarbonic acid ester used as the blocking agent for terminal amino groups include di-tert-butyl dicarbonate, dibenzyl dicarbonate, dimethyl dicarbonate, and diethyl dicarbonate.

Examples of the vinyl ether compound used as the blocking agent for terminal amino groups include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, and benzyl vinyl ether.

Examples of other compounds used as the blocking agent for terminal amino groups include: chloroformate esters such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, isopropyl chloroformate; isocyanate compounds such as butyl isocyanate, 1-naphthyl isocyanate, octadecyl isocyanate, phenyl isocyanate; benzoyl chloride, methanesulfonyl chloride, and p-toluenesulfonyl chloride.

An introduction rate of the blocking agent for the terminal group of the acid anhydride is preferably in the range 0.1 to 60 mol%, more preferably in the range of 5 to 50 mol%, and furthermore preferably in the range of 5 to 20 mol% relative to the tetracarboxylic dianhydride component shown by the general formula (21). The component is a raw material of the alkali-soluble resin of the present invention. An introduction rate of the blocking agent for the terminal group of the amino group is preferably in the range of 0.1 to 100 mol% and particularly preferably in the range of 5 to 90 mol% relative to a diamine component. In addition, different terminal groups may be introduced by reacting with two or more of the end blocking agents.

### ((A-2) Resin containing heterocyclic skeleton with nitrogen atom)

The (A-2) component of the present invention is a resin that contains at least one or more structures selected from a polyimide structure, a polybenzoxazole structure, a polyamide-imide structure, and precursor structures thereof, each of which has no alkali-soluble group and contains a heterocyclic skeleton having at least one or more nitrogen atoms at a molecular terminal. The resin is not particularly limited as long as it doesn't have the alkali-soluble group but contains the specific structure. The resin may contain a structure represented by the following general formula (1). 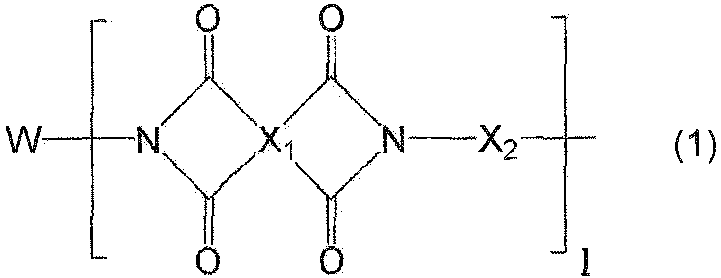 W is a monovalent organic group comprising a heterocyclic skeleton having at least one or more nitrogen atoms, X₁ is a tetravalent organic group which is the same as or different from the X₃, X₂ is a divalent organic group which is the same as or different from the X₂, and "1" represents an integer of 1 to 1000.

Here, the alkali-soluble group indicates a functional group that interacts or reacts with an alkali to increase the solubility of the resin to an alkali solution, specifically, an acidic group may be exemplified. Examples of the preferable alkali-soluble group include a carboxyl group, a phenolic hydroxy group, a hydroxy alkyl group in which a carbon atom at an alpha-position of an alcoholic hydroxy group is substituted with an electron drawing group, a sulfonic acid group, and a thiol group. Exemplarily, the alkali-soluble group includes a group having an acid dissociation constant (pKa) of the same degree as the phenolic hydroxy group, for example, one having the pKa in the range of 6 to 12.

The (A-2) component of the present invention doesn't have the alkali-soluble group like this in the structural unit and/or at the main chain terminal of the resin.

The W in the general formula (1) is a monovalent organic group having a heterocyclic skeleton having at least one or more nitrogen atoms. Preferably, the W includes a monovalent organic group represented by the following formula (32), but is not restricted to these. A structure of the W may be one kind or a combination of two or more kinds. 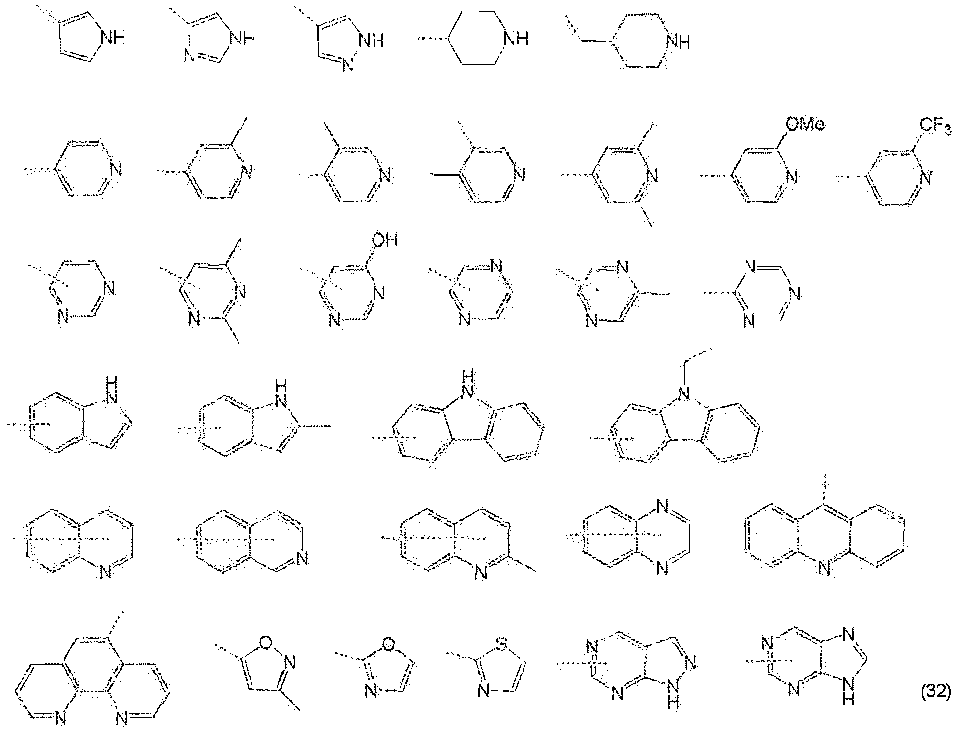 In the formulae, a dotted line represents a bond.

When the W in the general formula (1) has the organic group like the above at a molecular terminal, the elongation of a cured film of the photosensitive resin composition including the alkali-soluble resin (A-1) and the resin (A-2) of the present invention is improved. This is considered that the alkali-soluble group in the alkali-soluble resin (A-1) and an organic group shown by the W in the resin (A-2) form a hydrogen bond between molecules, and the resin (A-1) and the resin (A-2) properly tangle to improve the intermolecular interaction between the resin (A-1)s, and the resin (A-1) and the resin (A-2).

When a monovalent organic group having a heterocyclic skeleton having at least one or more nitrogen atoms in the resin (A-2) (a functional group shown by the W) is present not at a molecular terminal but in a molecular skeleton, a molecular interaction due to a hydrogen bond with the resin (A-1) becomes excessive to be unable to obtain a desired effect. Therefore, it is necessary for the organic group to be present at least one or more at the molecular terminal.

When the resin (A-2) has the alkali-soluble group, a hydrogen bond has been formed within the molecule in the resin (A-2), or between molecules of the resin (A-2) to cause an undesirable effect and further proceeding gelation during resin synthesis. Consequently, the resin (A-2) is necessary not to have the alkali-soluble group.

"1" in the general formula (1) represents an integer from 1 to 1000, preferably an integer from 1 to 100, and furthermore preferably an integer from 1 to 50. When "1" is larger than 1000, an amount of terminal organic group W interacting with the alkali-soluble resin (A-1) becomes relatively smaller. Consequently "1" is preferably 1000 or smaller, and particularly preferably 50 or smaller.

An addition amount of the resin (A-2) is preferably 5 parts by mass or larger and 50 parts by mass or smaller relative to 100 parts by mass of the alkali-soluble resin (A-1). When the addition amount is 5 parts by mass or larger, an interaction effect with the alkali-soluble resin (A-1) as was described above is obtained. When it is 50 parts by mass or smaller, a problem of such a residue during lithography patterning doesn't occur due to the (A-2) itself not having the alkali-solubility, and consequently the addition amount of the resin (A-2) is preferably set to the above range. The addition amount of the resin (A-2) is preferably 5 parts by mass or larger and 30 parts by mass or smaller. By setting the addition amount in the range, the balance between the interaction effect and the lithography patterning becomes excellent.

### ((B) Photosensitizer)

A (B) component in the positive photosensitive resin composition of the present invention is a photosensitizer that generates an acid by light to increase the dissolution speed to an alkaline aqueous solution, and is a compound having a quinonediazide structure. As the (B) component, a compound having a 1,2-naphtoquinone diazide sulfonyl group in a molecule may be exemplified.

Examples of the compound having a 1,2-naphthoquinone diazide sulfonyl group in its molecule include compounds having a 1,2-naphthoquinone diazide sulfonyl group shown by the following general formula (33) or (34).

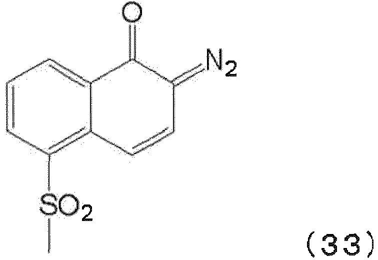

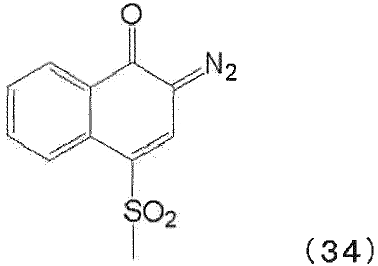

Illustrative examples of a preferable compound into which the 1,2-naphthoquinone diazide sulfonyl group is introduced include trihydroxybenzophenone or tetrahydroxybenzophenone, a ballast molecule shown by the following general formula (35) having a phenolic hydroxy group and a novolac resin having a repeating unit represented by the following formula (40) with a weight average molecular weight in the range of 2,000 to 20,000, preferably 3,000 to 10,000. That is, those obtained by substituting a hydrogen atom(s) of the phenolic hydroxy group of the following resin or compound which has the phenolic hydroxy group with the 1,2-naphthoquinone diazide sulfonyl group are suitable to the (B) component.

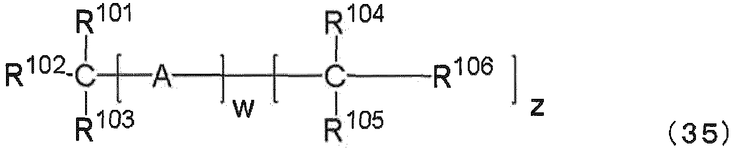

Here, R¹⁰¹ to R¹⁰⁶ each independently represents a hydrogen atom, a methyl group, a group represented by the following formula (36) or a group represented by the following formula (37). "w" is an integer of 0 to 2, and "z" is an integer of 0 to 2. When "z" is 0, "w" is 1 or 2. A is represented as follows: when "z" is 0 and "w" is 1, A is a hydrogen atom, a methyl group, or a group represented by the following formula (36); when "z" is 0 and "w" is 2, one of A's is a methylene group or a group represented by the following formula (38), and the other is a hydrogen atom, a methyl group or a group shown by the following formula (36); when "z" is 1, A is a methylene group or a group represented by the following formula (38);when "z" is 2 and "w" is 1, A is a methyne group or a group represented by the following formula (39); and when "z" is 2 and "w" is 2, one of A's is a methylene group or a group represented by the following formula (38), and the other is a methyne group or a group represented by the following formula (39). 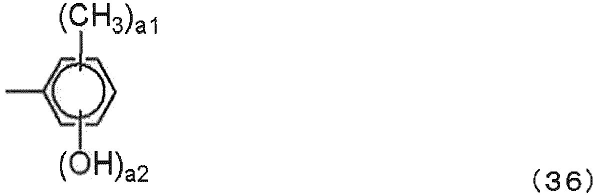 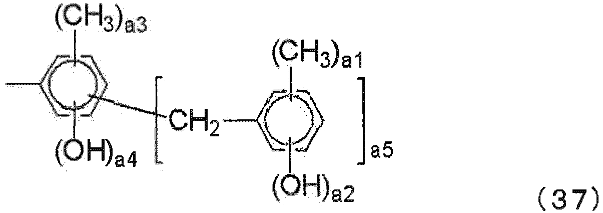 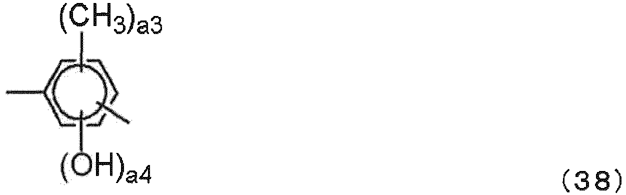 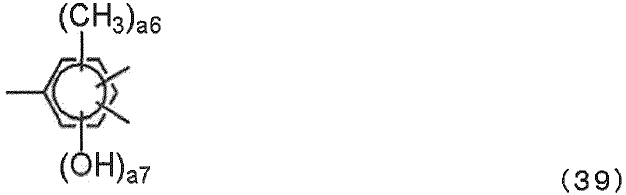 In the formulae, a1, a2, a3, a4, a5, a6, and a7 each is an integer of 0 to 3, a1+a2≤5, a3+a4≤4 and a6+a7≤3.

In this case, a low nucleus body (ballast molecule) of the formula (35) has the number of benzene rings of 2 to 20, more preferably 2 to 10, still more preferably 3 to 6, and a ratio of the number of the phenolic hydroxy groups to the number of the benzene rings is 0.5 to 2.5, more preferably 0.7 to 2.0, and still more preferably 0.8 to 1.5.

As the low nucleus body (ballast molecule) like this, specifically, the followings may be exemplified.

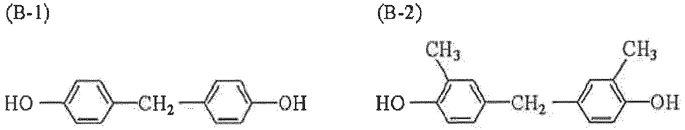

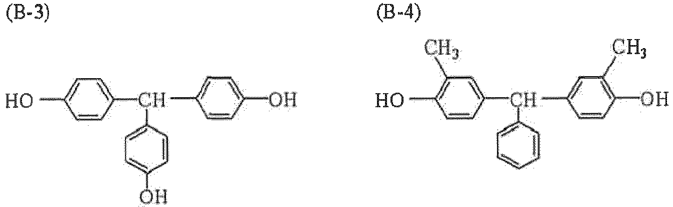

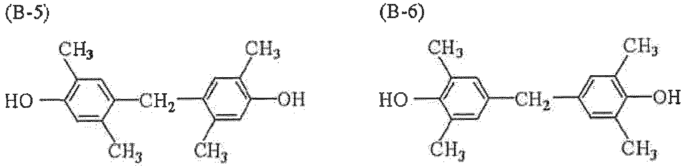

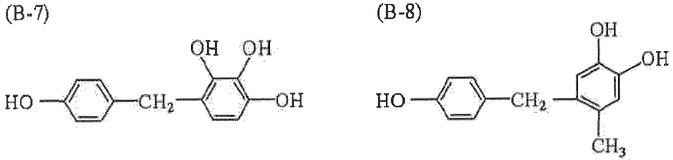

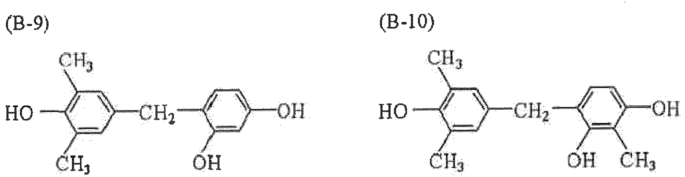

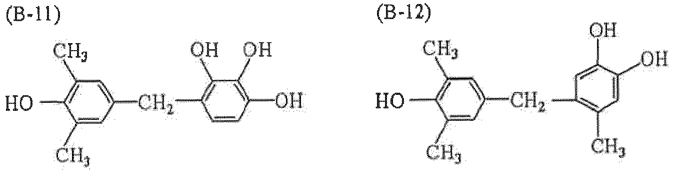

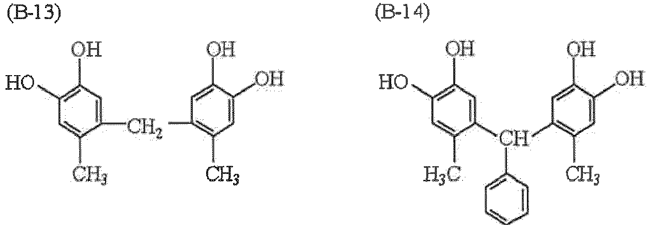

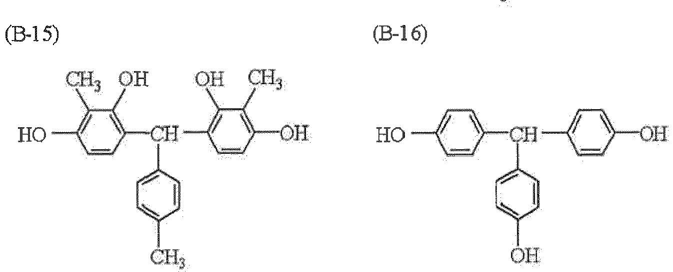

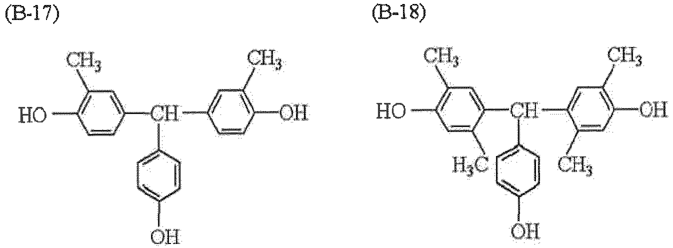

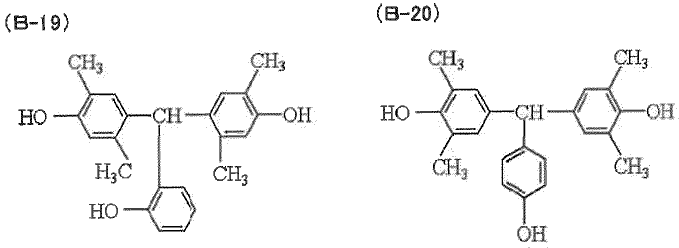

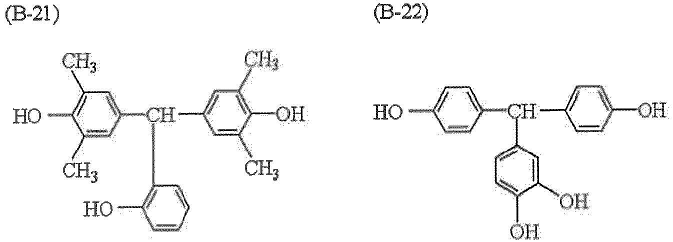

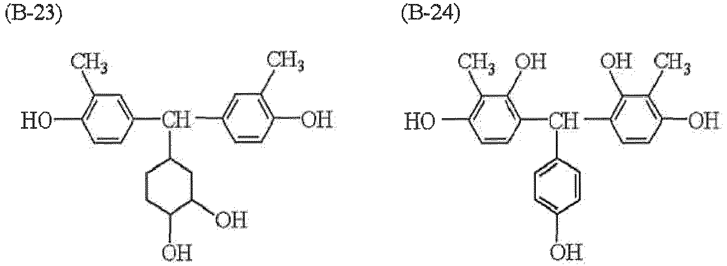

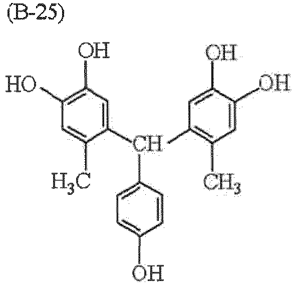

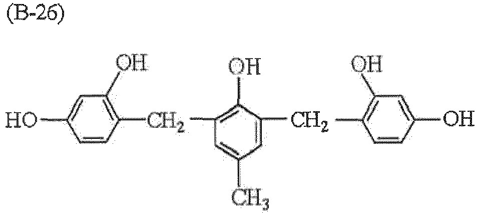

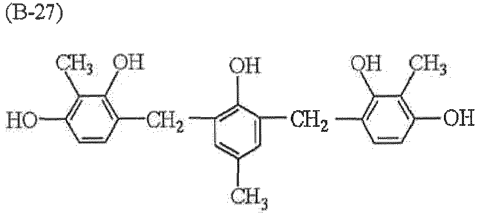

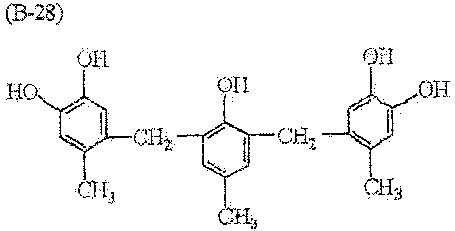

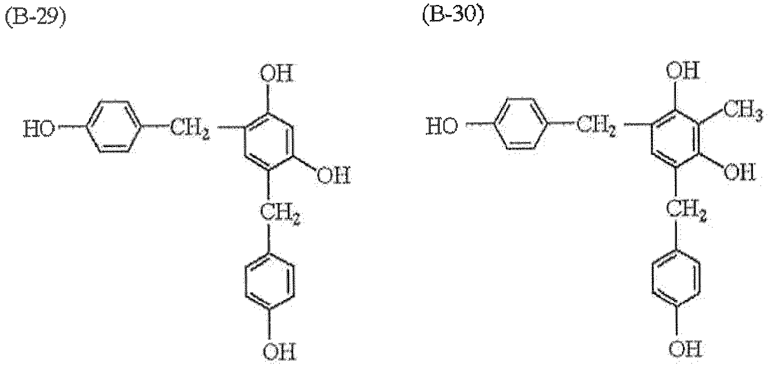

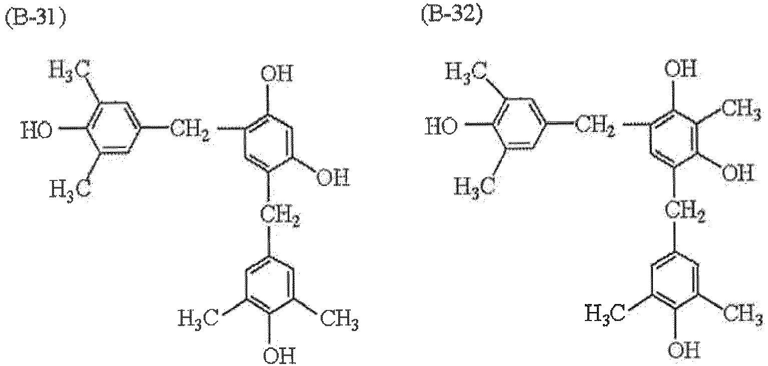

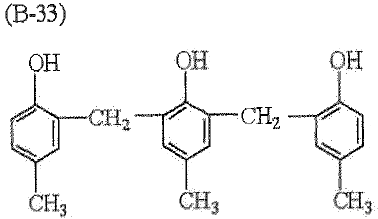

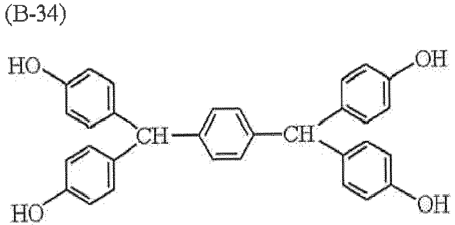

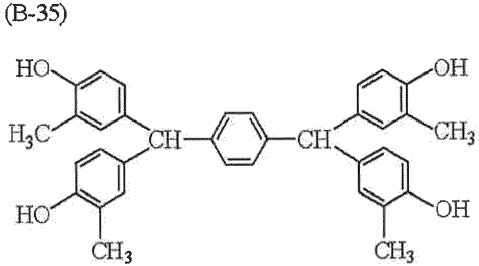

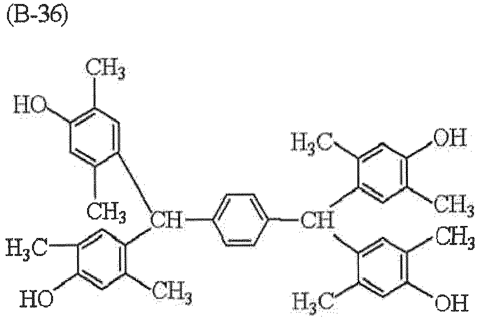

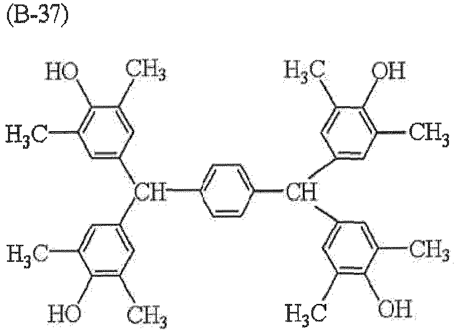

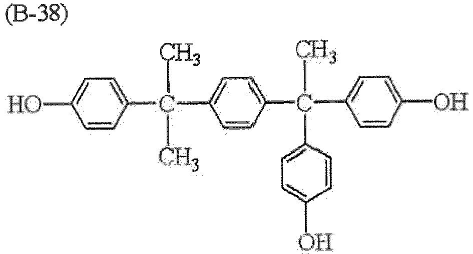

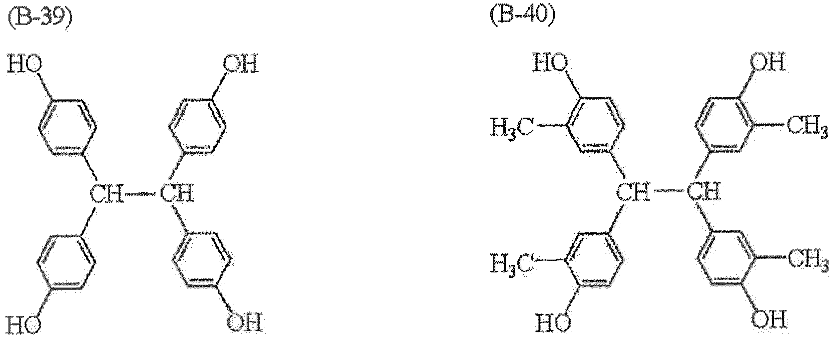

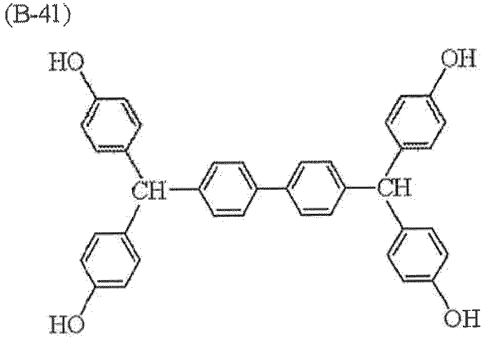

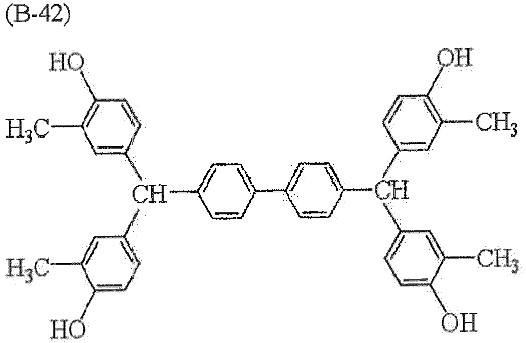

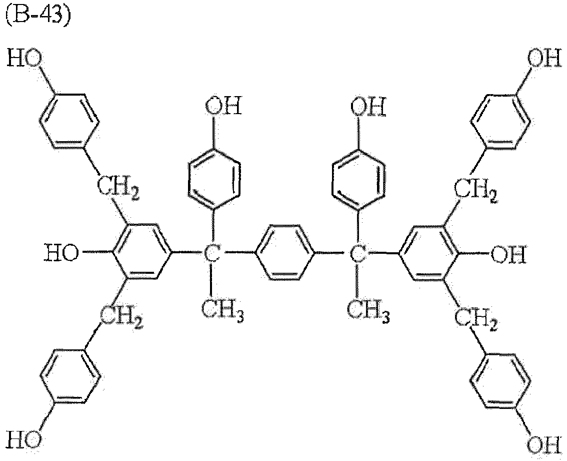

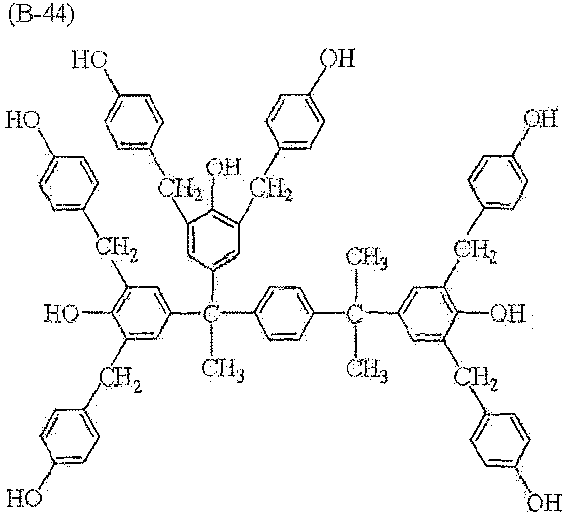

Among the low nucleus bodies (ballast molecules) illustrated above, (B-3), (B-29), (B-33), (B-38) are preferred. Compounds obtained by substituting a hydrogen atom of the phenolic hydroxy group of these ballast molecules with the 1,2-naphthoquinone diazide sulfonyl group are suited for the (B) component of the positive photosensitive resin composition of the present invention. 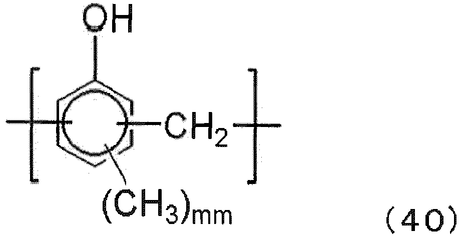 "mm" is an integer of 0 to 3.

The novolac resin having a repeating unit represented by the formula (40) may be synthesized by making condense aldehydes and the phenols shown by the following formula (41), specifically, at least one kind of phenols of o-cresol, m-cresol, p-cresol, 3,5-xylenol according to an ordinary method. 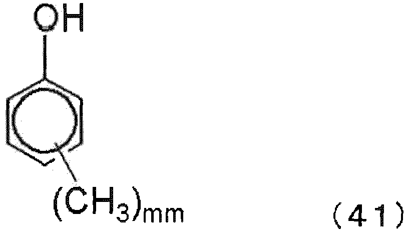 "mm" is an integer of 0 to 3.

In this case, as the aldehydes, for example, formaldehyde, para-formaldehyde, acetaldehyde, benzaldehyde may be exemplified, but the formaldehyde is preferable.

A ratio of the phenols represented by the formula (41) to the aldehydes is preferably 0.2 to 2, particularly preferably 0.3 to 2, by molar ratio.

As a method of introducing the 1,2-naphthoquinone diazide sulfonyl group into a compound in which the group is introduced, it is preferable to perform a dehydrochlorination condensation reaction between the 1,2-naphthoquinone diazide sulfonyl chloride and the phenolic hydroxy group with a basic catalyst. In the case of reacting with the ballast molecule represented by the formula (35), trihydroxybenzophenone or tetrahydroxybenzophenone, a ratio of substituting hydrogen atoms of the phenolic hydroxy group with the 1,2-naphthoquinone diazide sulfonyl group is 10 to 100 mol%, and preferably 50 to 100 mol%. In the case of reacting with the novolac resin having a repeating unit represented by the formula (40), a ratio of substituting hydrogen atoms of the phenolic hydroxy group with the 1,2-naphthoquinone diazide sulfonyl group is 2 to 50 mol%, and preferably 3 to 27 mol%.

An addition amount of the (B) component is preferably 1 to 50 parts by mass, more preferably 10 to 40 parts by mass relative to 100 parts by mass of the (A-1) component. Furthermore, one kind or two or more kinds of the (B) components in combination may be used.

By blending the (B) component like this, before exposure, the solubility to the alkali aqueous solution is suppressed due to the dissolution preventing effect of the (B) component, the system becomes alkaliinsoluble, and when exposed, the photosensitizer of the (B) component generates an acid by light, a dissolution rate to the alkaline aqueous solution increases, and the system becomes alkali-soluble.

That is, when an alkaline aqueous solution is used as a developer, an unexposed part is not dissolved in the developer and an exposed part is soluble in the developer. As a result, a positive pattern may be formed.

### ((D) Solvent)

The (D) component in the positive photosensitive resin composition is a solvent. The solvent of the (D) component is not limited as long as it can dissolve the (A-1) component, the (A-2) component and the (B) component. Examples of the solvents includes: ketones such as cyclohexanone, cyclopentanone, methyl-2-n-amyl ketone; alcohols such as 3-methoxybutanol, 3-methyl-3-methoxybutanol, 1-methoxy-2-propanol, 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, diethylene glycol dimethyl ether; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-monotert-butyl ether acetate, γ-butyrolactone. One or more kinds thereof may be used. In particular, ethyl lactate, cyclohexanone, cyclopentanone, propylene glycol monomethyl ether acetate, γ-butyrolactone or a mixed solvent thereof is preferable.

A blending amount of the (D) component is preferably 50 to 2,000 parts by mass, particularly preferably 100 to 1,000 parts by mass relative to 100 parts by mass of a total of the blending amounts of the (A-1) component, the (A-2) component and the (B) component.

### ((C) Crosslinking Agent)

The positive photosensitive resin composition of the present invention preferably contains furthermore, in addition to the (A-1), (A-2), (B), and (D) components that are necessary components, (C) one kind or two or more kinds of crosslinking agents selected from an amino condensate modified by formaldehyde or formaldehyde-alcohol; a phenol compound having two or more methylol groups or alkoxymethylol groups by average in one molecule; a compound in which a hydrogen atom of a phenolic hydroxy group is substituted with a glycidyl group; a compound in which a hydrogen atom of a phenolic hydroxy group is substituted with a substituent represented by the following formula (C-1); and a compound having two or more nitrogen atoms having a glycidyl group represented by the following formula (C-2) . 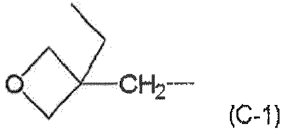 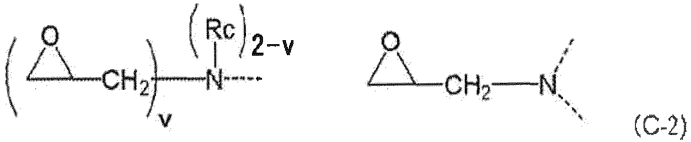 In the formulae, a dotted line represents a bond, Rc represents a linear, branched, or cyclic alkyl group having 1 to 6 carbon atoms, and v represents 1 or 2.

Examples of the (C) component in the positive photosensitive resin composition according to the present invention is one or two or more kinds of crosslinking agent(s) selected from an amino condensate modified by formaldehyde or formaldehyde-alcohol, a phenol compound having two or more methylol groups or alkoxymethylol groups by average in one molecule, a compound in which a hydrogen atom of a hydroxy group of a polyhydric phenol is substituted with a glycidyl group, a compound in which a hydrogen atom of a hydroxy group of a polyhydric phenol is substituted with a group represented by the following formula (C-1), and a compound having two or more nitrogen atoms having a glycidyl group represented by the following formula (C-2) . 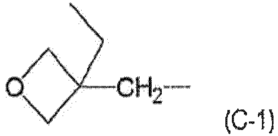 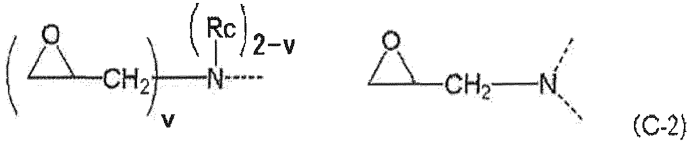 In the formula, a dotted line represents a bond, Rc represents a linear, branched, or cyclic alkyl group having 1 to 6 carbon atoms, and v represents 1 or 2.

Examples of the amino condensates modified by the formaldehyde or formaldehyde-alcohol include a melamine condensate modified by the formaldehyde or formaldehyde-alcohol, and a urea condensate modified by the formaldehyde or formaldehyde-alcohol.

The melamine condensate modified by the formaldehyde or formaldehyde-alcohol is prepared in such a manner that, firstly, according to a well-known method, a melamine monomer is modified by methylol reaction with formalin, or this is furthermore modified by alkoxylation with alcohol, thus modified melamine represented by the following general formula (42) is obtained. As the alcohol, a lower alcohol, for example alcohols having 1 to 4 carbon atoms is preferable. 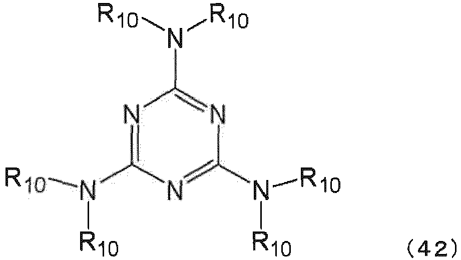 In the formula, R₁₀s may be the same or different from each other, and is a methylol group, an alkoxymethyl group containing an alkoxy group having 1 to 4 carbon atoms or a hydrogen atom, and at least one of them is a methylol group or the alkoxymethyl group.

Examples of the R₁₀ include a hydrogen atom, and alkoxymethyl groups such as a methylol group, a methoxymethyl group, and an ethoxymethyl group.

Specific examples of the modified melamine represented by the general formula (42) include trimethoxymethylmonomethylol melamine, dimethoxymethylmonomethylol melamine, trimethylol melamine, hexamethylol melamine, and hexamethoxymethylol melamine. Next, the modified melamine represented by the general formula (42) or its multimer (for example, an oligomer such as a dimer or a trimer) is subjected to addition condensation polymerization with formaldehyde until a desired molecular weight is obtained according to the conventional method to obtain a melamine condensate modified by formaldehyde or formaldehyde-alcohol.

The urea condensate modified by the formaldehyde or formaldehyde-alcohol is prepared, according to, for example, a well-known method, by modifying a urea condensate having a desired molecular weight by methylol reaction with formaldehyde, or by further modifying by alkoxylation with alcohol.

Specific examples of the urea condensate modified by the formaldehyde or formaldehyde-alcohol include a methoxymethylated urea condensate, an ethoxymethylated urea condensate, a propoxymethylated urea condensate.

These modified melamine condensates and modified urea condensates may be used by one king or by mixing two or more kinds.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, compounds represented by the following formulae (C-3) to (C-7).

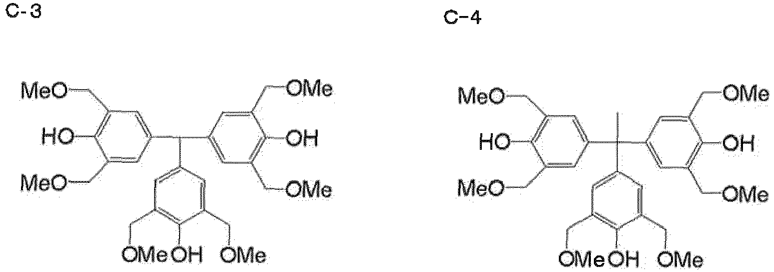

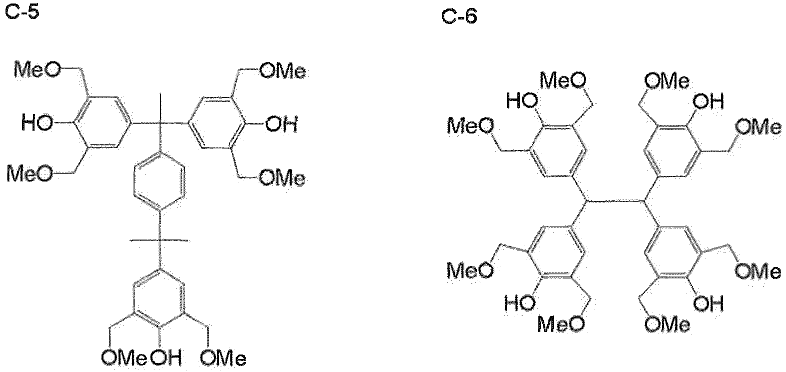

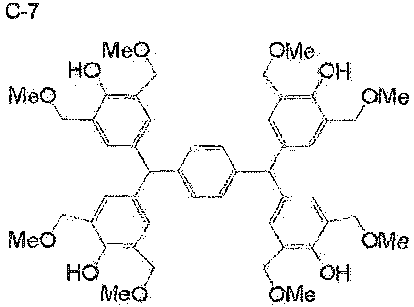

The crosslinking agents may be used singularly or in combination of two or more kinds.

Examples of the compounds in which a hydrogen atom of a hydroxy group of polyhydric phenol is substituted with a glycidyl group include a compound obtained by reaction of the hydroxy group of bisphenol A, tris(4-hydroxyphenyl)methane, and 1,1,1-tris(4-hydroxyphenyl)ethane with epichlorohydrin in the presence of a base. Suitable examples of the compound in which a hydrogen atom of a hydroxy group of a polyhydric phenol is substituted with a glycidyl group include the compounds represented by the following formulae (C-8) to (C-14) . 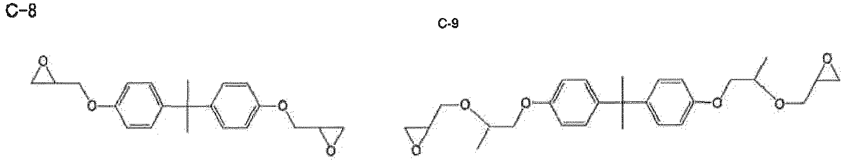 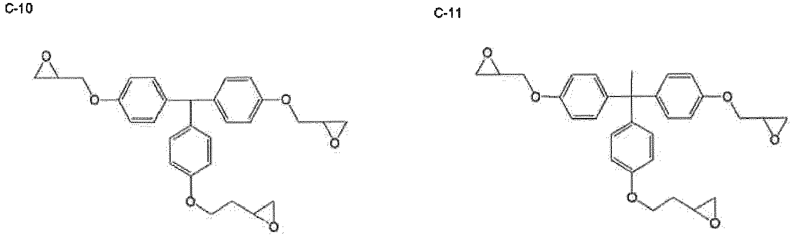 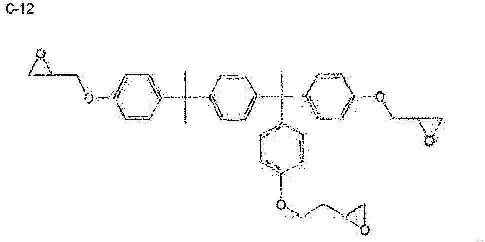 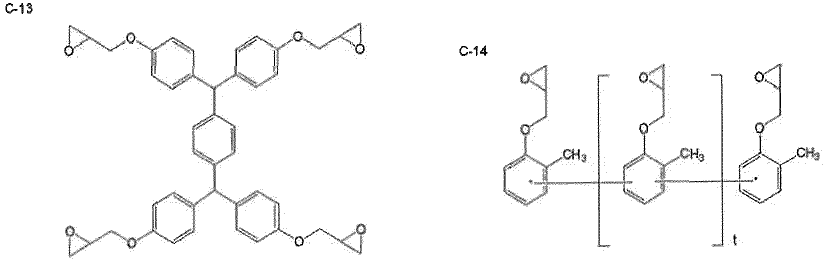 In the formulae, t is 2≤t≤3.

One kind or two kinds of the compounds (a compound in which a hydrogen atom of a phenolic hydroxy group is substituted with a glycidyl group) obtained by substituting a hydroxy group of the polyhydric phenol with a glycidyl group may be used as a crosslinking agent.

Examples of the compound in which a hydrogen atom of a phenolic hydroxy group is substituted with a substituent represented by the following formula (C-1) include ones containing two or more of the substituents and represented by the following formula (C-15). 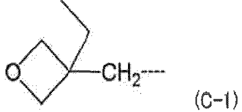 In the formula, a dotted line represents a bond. 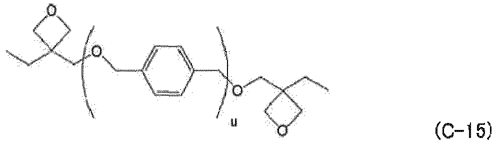 In the formula, 1≤u≤3.

Examples of the compound containing two or more nitrogen atoms having a glycidyl group represented by the following formula (C-2) include ones represented by the following formulae (C-16). 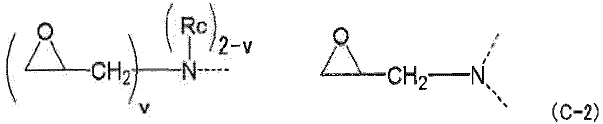 In the formula, a dotted line represents a bond, Rc represents a linear, branched, or cyclic alkyl group having 1 to 6 carbon atoms, and v represents 1 or 2. 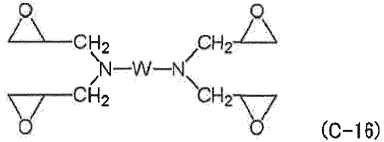 In the formula, W represents a linear, branched or cyclic alkylene group having 2 to 12 carbon atoms, or a divalent aromatic group. The W here is applied only in the above formula.

Examples of the compounds represented by the formula (C-16) include compounds represented by the following formulae (C-17) to (C-20).

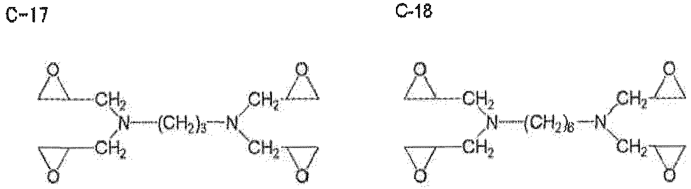

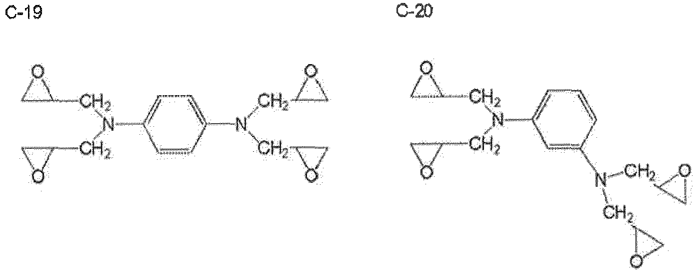

As the compound containing two or more nitrogen atoms each of which has a glycidyl group(s) represented by the formula (C-2), a compound represented by the following formula (C-21) may be suitably used.

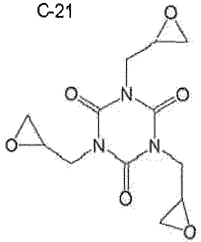

One kind or two kinds of these compounds containing two or more nitrogen atoms each of which has a glycidyl group(s) represented by the formula (C-2) may be used as a crosslinking agent.

The (C) component is a component that causes a crosslinking reaction in the post-curing after forming a pattern of the positive photosensitive resin composition of the present invention to further increase the strength of a cured product. A weight average molecular weight of the (C) component like this is preferable to be 150 to 10,000, and particularly preferable to be 200 to 3,000, from the viewpoint of the photocurability and heat resistance.

In the positive photosensitive resin composition of the present invention, a blending amount of the (C) component is preferably 0.5 to 50 parts by mass, and particularly preferably 1 to 30 parts by mass relative to 100 parts by mass of the (A-1) component.

### ((E) Compound that generates acid by heat)

The positive photosensitive resin composition of the present invention may further contain (E) a compound that generates an acid by heat. The compound generating an acid by heat of the (E) component may be added to thermally expedite a crosslinking reaction with the (A-1) component in a step of heating and post-curing in a temperature of 100 to 300°C performed after the pattern formation.

In particular, as the (E) component, one that doesn't encourage the curing of a film and doesn't disturb the pattern formation until a pattern is formed by development. In order to realize this, the (E) component is preferably one that, after the photosensitive resin composition is coated, doesn't generate an acid at a temperature in a step of removing a solvent and drying, but generates an acid by a heat treatment after pattern formation to encourage the curing of the pattern or a film of the photosensitive resin composition. Specifically, a compound that is decomposed by a heat treatment at 100°C to 300°C, preferably at 150°C to 300°C to generate an acid is preferable. By containing such component (E), crosslinking and curing reaction of the pattern or the film of the positive photosensitive resin composition can be further promoted in the step of heating and post-curing at 100 to 300°C after patterning. The (E) component makes it possible to further improve the mechanical strength, the chemical resistance, the adhesiveness of the obtained pattern or film, by further forwarding the crosslinking, and the curing reaction.

As the compound that generates an acid by a suitable heat, compounds described in paragraphs [0061] to [0085] of the publication of JP 2007-199653 A may be exemplified.

A blending amount of the compound that generates an acid by heat is preferably 0.1 part by mass or larger, more preferably 0.5 part by mass or larger, and, preferably 30 parts by mass or smaller, and more preferably 10 parts by mass or smaller relative to 100 parts by mass of the (A-1) component in the positive photosensitive resin composition of the present invention.

### (Other components)

In the positive photosensitive resin composition of the present invention, components other than the (A-1), (A-2), (B), (C), (D) and (E) component may be further contained. As such other components, for example, an adhesive aide, (G) a surfactant may be contained. As the (G) surfactant, compounds illustrated below may be preferably contained.

As the (G) surfactant, a nonionic surfactant is preferable. Examples thereof include fluorinated surfactants, specifically, perfluoroalkyl polyoxyethylene ethanol, fluorinated alkyl ester, perfluoroalkylamine oxide, and a fluorine-containing organosiloxane compound.

As these surfactants, commercially available ones may be used. Example thereof include Fluorad "FC-4430" (manufactured by Sumitomo 3M Limited), Surflon "S-141" and "S-145" (all manufactured by ASAHI GLASS CO., LTD.), UNIDYNE "DS-401", "DS-4031" and "DS-451" (all manufactured by DAIKIN INDUSTRIES, LTD.), Megafac "F-8151" (manufactured by DIC Corporation), "X-70-093" (manufactured by Shin-Etsu Chemical Co., Ltd.), etc. Among these, preferred are Fluorad "FC-4430" (manufactured by Sumitomo 3M Limited) and "X-70-093" (manufactured by from Shin-Etsu Chemical Co., Ltd.).

### (Patterning process)

The present invention provides a patterning process comprising the following steps.
(1) A step of coating the positive photosensitive resin composition on a substrate to form a photosensitive material film,
(2) subsequently, after a heat treatment, a step of exposing a photosensitive material film with a high energy beam having a wavelength of 190 to 500 nm or an electron beam via a photomask, and,
(3) a step of developing with a developer of an alkaline aqueous solution.

In the following, a patterning process using the positive photosensitive resin composition of the present invention will be described.

In the positive photosensitive resin composition of the present invention, in order to form a pattern, a well-known lithography technology may be adopted and performed. For example, on a silicon wafer, a SiO₂ substrate, a SiN substrate, or a substrate on which a pattern such as copper wiring is formed, the photosensitive resin composition is coated by a technique of spin-coating (spin-coating method), followed by prebaking under the condition at 80 to 130°C, and for 50 to 600 seconds to form a photosensitive film having a thickness of 1 to 50 µm, preferably 1 to 30 µm, and furthermore preferably 5 to 20 µm.

According to the spin-coating method, after dispensing 5 mL of the photosensitive resin composition on such a silicon substrate, by rotating the substrate, the photosensitive resin composition may be coated on the substrate. At this time, by adjusting the rotation rate, a film thickness of the photosensitive film on the substrate may be readily adjusted.

Subsequently, by holding a mask for forming a target pattern over the photosensitive material film, a high energy beam of a wavelength of 190 to 500 nm such as an i-line and a g-line or an electron beam is irradiated such that an exposure dose is 1 to 5,000 mJ/cm², preferably 100 to 2,000 mJ/cm².

Subsequently, as needs arise, at 60 to 150°C for 1 to 10 minutes, preferably at 80 to 120°C for 1 to 5 minutes on such a hot plate, a post-exposure heat treatment (post exposure baking (PEB)) may be applied.

After that, the development is applied. In the positive photosensitive resin composition of the present invention, an alkaline development using an alkaline aqueous solution may be applied.

Examples of the aqueous alkaline solution that can be favorably used for the alkali development include 2.38% aqueous tetramethylammonium hydroxide (TMAH) solution. The development may be performed according to an ordinary method such as a spray method and a paddle method, or by dipping in the developer. After that, as needs arise, by performing cleaning, rinsing and drying, a resist film having a desired pattern may be obtained.

### (Method of forming cured film)

The film having a pattern obtained by the patterning process may be baked and post-cured with an oven or a hot plate at 100 to 300°C, preferably 150 to 300°C, more preferably 180 to 250°C to form a cured film. In this post-curing step, the post-curing temperature of 100 to 300°C allows the film of the photosensitive resin composition to increase the crosslinking density and to remove remaining volatile components. Thus, this temperature range is preferable in view of adhesiveness to a substrate, heat resistance, strength, and electronic characteristics. The time for the post-curing can be 10 minutes to 10 hours.

The formed pattern is used for the purpose of a protective film for covering wirings, circuits and substrates. The formed patterns and protective films, while having excellent insulation property, have excellent adhesive force on a metal layer such as Cu of wirings and circuits to be covered, on a metal electrode existing on the substrate, or on an insulating substrate such as SiN existing in wirings and circuits to be covered, and make it possible, while having the mechanical strength appropriate as a protective film, to remarkably improve the resolution performance for enabling a finer pattern formation.

### (Cured Film)

The cured film thus obtained is excellent in the adhesiveness to the substrate, heat resistance, electric characteristics, mechanical strength and chemical resistance to an alkaline peeling solution, and also excellent in reliability of a semiconductor device using the film as a protective film, in particular, it is possible to prevent occurrence of cracks in the temperature cycle test, it can be suitably used as a protective film (an interlayer insulating film or a surface protective film) for electric and electronic parts, a semiconductor device.

That is, the present invention provides an interlayer insulation film or a surface protective film made of the cured film obtained by curing the positive photosensitive resin composition.

The above protective film is useful for an insulator film for a semiconductor device including rewiring use, an insulator film for a multilayer printed substrate, a solder mask, and a cover lay film, because of its heat resistance, chemical resistance, and insulating property.

Furthermore, the present invention provides an electronic component having the interlayer insulation film or the surface protective film.

The electronic component like this becomes excellent in reliability because the electronic component has the protective film (interlayer insulation film or surface protective film) having heat resistance, chemical resistance, and the insulation property.

### EXAMPLE

In what follows, with reference to synthesis examples, comparative synthesis examples, examples and comparative examples, the present invention will be specifically described. However, the present invention is not limited to the following examples.

### 1. Synthesis of Resin

In the following synthesis examples, chemical structures and names of the used compounds are shown below. 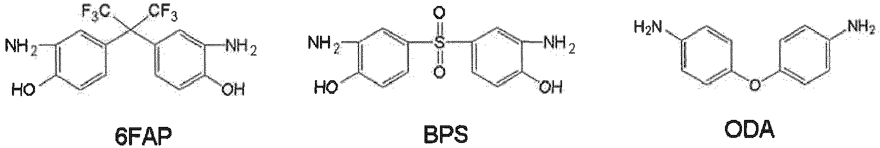 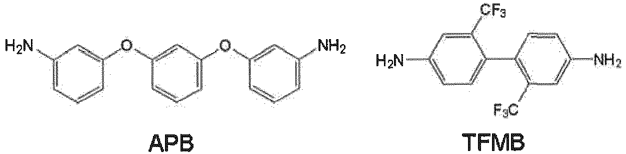 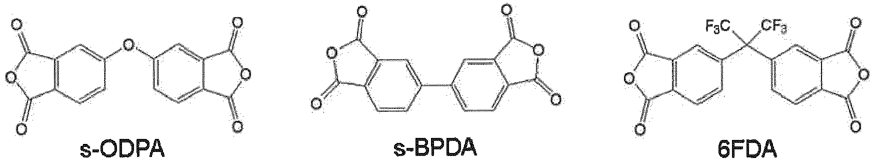 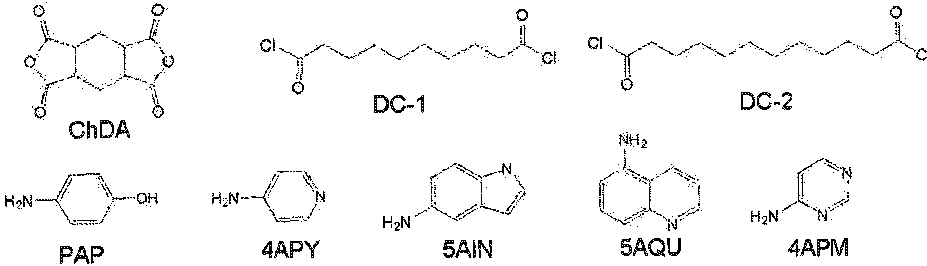 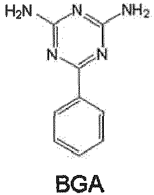 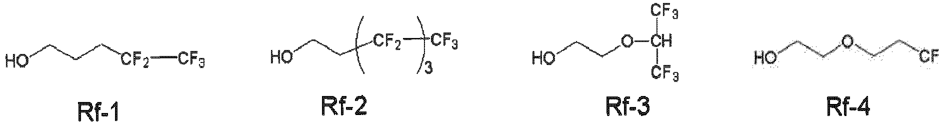 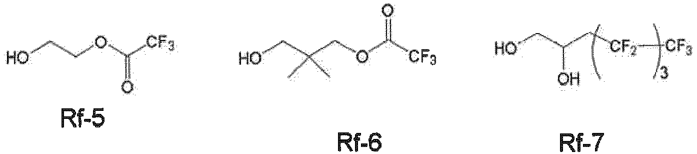
6FAP:2,2-bis(3-amino-4-hydroxyphenyl) hexafluoropropane
BPS: bis(3-amino-4-hydroxyphenyl)sulfone
ODA: 4,4'-diaminodiphenyl ether
APB: 1,3-bis(3-aminophenoxy)benzene
TFMB: 2,2'-bis(trifluoromethyl)benzidine
s-ODPA: 3,3',4,4'-oxydiphthalic dianhydride
s-BPDA: 3,3', 4,4'-biphenyltetracarboxylic dianhydride
6FDA: 4,4'-(hexafluoroisopropylidene)diphthalic anhydride
ChDA: 1,2,4,5-cyclohexanetetracarboxylic dianhydride
DC-1: Sebacoyl dichloride
DC-2: Dodecanedioyl dichloride
PAP: 4-aminophenol
4APY: 4-aminopyridine
5AIN: 5-aminoindole
5AQU: 5-aminoquinone
4APM: 4-aminopyrimidine
BGA: benzoguanamine
Rf-1: 4,4,5,5-pentafluoropentanol
Rf-2: 1H, 1H, 2H, 2H-nonafluoro-1-hexanol
Rf-3: 1-trifluoromethyl-2,2,2-trifluoroethyl-2'-hydroxyethyl ether
Rf-4: 3,3,3-trifluoropropyl-2'-hydroxyethyl ether
Rf-5: hydroxyethyl trifluoroacetate
Rf-6: 3-hdroxy-2,2-dimethylpropyltrifluoroacetate Rf-7: 4,4,5,5,6,6,7,7,7,7-nonafluoro-1,2-heptanediol
Each of D-400, ED-600 and RT-1000 (all product name, manufactured by HUNTMAN Corporation) is a diamine represented by the general formula (31).

### (Synthesis Example 1) Synthesis of Polyimide Resin (A1-1)

Into a 1L flask provided with a stirrer and a thermometer, 30 g (81.9 mmol) of 2,2,-bis(3-amino-4-hydroxyphenyl)hexafluoropropane (6FAP), 0.9 g (8.6 mmol) of 4-aminophenol(PAP) and 125 g of N-methyl-2-pyrollidone were added, followed by dissolving by stirring at room temperature. Next, under room temperature, a solution in which 26.7 g (86.2 mmol) of 3,3',4,4'-oxydiphthalic dianhydride (s-ODPA) was dissolved in 270 g of N-methyl-2-pyrrolidone was dropped thereto, after dropping, followed by stirring for 3 hours under room temperature. Thereafter, 40g of xylene was added to the reaction liquid, followed by heating and refluxing for 3 hours while removing water generated at 170°C outside the system. After cooling to the room temperature, the reaction liquid was dropped into 2 L of ultrapure water under stirring, a precipitate was filtered to be washed appropriately with water, followed by drying under reduced pressure at 40°C for 48 hours, a polyimide resin (A1-1) was obtained. A molecular weight of the polymer was measured by GPC. A weight average molecular weight was 35,000 in terms of polystyrene.

### (Synthesis Example 2) to (Synthesis Example 8), (Comparative Synthesis Example 1) Synthesis of Polyimide Resin (A1-2) to (A1-8), and (B-1)

As a diamine compound, a monoamine compound, and a tetracarboxylic dianhydride, compounds of the weights shown in the following Table 1 were used, and, according to the same formulation as the synthesis example 1, polyimide resins (A1-2) to (A1-8), and (B-1) were obtained. A molecular weight of each of polymers was measured according to the GPC, weight average molecular weights in terms of polystyrene are shown in the following Table 1.

**[Table 1]**

| | | Diamine Compound | | | | | | | | Monoamine Compound | Tetracaboxylic dianhydride | | Molecular weight |
|---|---|---|---|---|---|---|---|---|---|---|---|---|---|
| | | 6 FAP | BPS | ODA | APB | D-400 | ED-600 | RT-1000 | BGA | PAP | s-ODPA | s-BPDA | |
| Synthesis Example 1 | A1-1 | 30.0 g (81.9 mmol) | | | | | | | | 0.9 g (8.6 mmol) | 26.7 g (86.2 mmol) | | 35,000 |
| Synthesis Example 2 | A1-2 | 30.0 g (81.9 mmol) | | | | | | | | 0.9 g (8.6 mmol) | 18.7 g (60.3 mmol) | 7.6 g (25.9 mmol) | 34,000 |
| Synthesis Example 3 | A1-3 | 27.0 g (73.7 mmol) | | 1.6 g (8.2 mmol ) | | | | | | 0.9 g (8.6 mmol) | 26.7 g (86.2 mmol) | | 36,000 |
| Synthesis Example 4 | A1-4 | 27.0 g (73.7 mmol) | | | 2.4 g (8.2 mmol ) | | | | | 0.9 g (8.6 mmol) | 26.7 g (86.2 mmol) | | 35,000 |
| Synthesis Example 5 | A1-5 | 23.7 g (64.7 mmol) | | | | 7.4 g (17.2 mmol) | | | | 0.9 g (8.6 mmol) | 26.7 g (86.2 mmol) | | 34,000 |
| Synthesis Example 6 | A1-6 | 23.7 g (64.7 mmol) | | | | | 10.3 g (17.2 mmol) | | | 0.9 g (8.6 mmol) | 26.7 g (86.2 mmol) | | 34,000 |
| Synthesis Example 7 | Al-7 | 23.7 g (64.7 mmol) | | | | | | 17.2 g (17.2 mmol) | | 0.9 g (8.6 mmol) | 26.7 g (86.2 mmol) | | 36,000 |
| Synthesis Example 8 | A1-8 | | 23.0 g (81.9 mmol) | | | | | | | 0.9 g (8.6 mmol) | 26.7 g (86.2 mmol) | | 35,000 |
| Comparative Synthesis Example 1 | B-1 | 27.0 g (73.7 mmol) | | | | | | | 1.5 g (8.2 mmol ) | 0.9 g (8.6 mmol) | 26.7 g (86.2 mmol) | | 33,000 |

### (Synthesis Example 9) Synthesis of Tetracarboxylic Diester Dichloride (X-1))

Into a 3L flask provided with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added, under stirring at room temperature, 114.7 g (644 mmol) of 4,4,5,5,5-pentafluoropentanol (Rf-1) was dropped thereto, followed by stirring for 24 hours under room temperature. After that, 370 g of a 10% aqueous solution of hydrochloric acid was dropped under ice cooling to stop the reaction. To the reaction liquid, 800 g of 4-methyl-2-pentanone was added to sample an organic layer, followed by washing 6 times with 600 g of ultrapure water. A solvent of the obtained organic layer was distilled and 193 g of a tetracarboxylic diester compound was obtained. To the obtained tetracarboxylic diester compound, 772 g of N-methyl-2-pyrolidone was added, followed by dissolving by stirring at room temperature. Next, under ice cooling, 75.8 g (637 mmol) of thionyl chloride was added such that a temperature of the reaction liquid keeps 10°C or lower, after the end of the dropping, followed by stirring for 2 hours under ice cooling, and a N-methyl-2-pyrolidone solution of tetracarboxylic diester dichloride (X-1) was obtained.

### (Synthesis Example 10) Synthesis of Tetracarboxylic Diester Dichloride (X-2)

In the Synthesis Example 9, 3,3',4,4'-oxydiphthalic dianhydride (s-ODPA) was substituted with 94.8 g (322 mmol) of 3,3',4,4'-biphenyl tetracarboxylic dianhydride (s-BPDA), and the others are in the same procedures, a N-methyl-2-pyrolidone solution of tetracarboxylic diester dichloride (X-2) was obtained.

### (Synthesis Example 11) Synthesis of Tetracarboxylic Diester Dichloride (X-3)

In the Synthesis Example 9, 4,4,5,5,5-pentafluoropentanol (Rf-1) was substituted with 170.1 g (644 mmol) of 1H, 1H, 2H, 2H-nonafluoro-1-hexanol (Rf-2), and the others are in the same procedures, a N-methyl-2-pyrolidone solution of tetracarboxylic diester dichloride (X-3) was obtained.

### (Synthesis Example 12) Synthesis of Tetracarboxylic Diester Dichloride (X-4)

In the Synthesis Example 9, 4,4,5,5,5-pentafluoropentanol (Rf-1) was substituted with 136.6 g (644 mmol) of 1-trifluoromethyl-2,2,2-trifluoroethyl-2'-hydroxyethyl ether (Rf-3), and the others are in the same procedures, a N-methyl-2-pyrolidone solution of tetracarboxylic diester dichloride (X-4) was obtained.

### (Synthesis Example 13) Synthesis of Tetracarboxylic Diester Dichloride (X-5)

In the Synthesis Example 9, 4,4,5,5,5-pentafluoropentanol (Rf-1) was substituted with 112.2 g (644 mmol) of 3,3,3-trifluoropropyl-2'-hydroxyethyl ether (Rf-4), and the others are in the same procedures, a N-methyl-2-pyrolidone solution of tetracarboxylic diester dichloride (X-5) was obtained.

### (Synthesis Example 14) Synthesis of Tetracarboxylic Diester Dichloride (X-6)

In the Synthesis Example 9, 4,4,5,5,5-pentafluoropentanol (Rf-1) was substituted with 101.8 g (644 mmol) of 2-hydroxyethyl trifluoroacetate (Rf-5), and the others are in the same procedures, an N-methyl-2-pyrolidone solution of tetracarboxylic diester dichloride (X-6) was obtained.

### (Synthesis Example 15) Synthesis of Tetracarboxylic Diester Dichloride (X-7)

In the Synthesis Example 9, 4,4,5,5,5-pentafluoropentanol (Rf-1) was substituted with 101.8 g (644 mmol) of 3-hydroxy-2,2-dimethylpropyl trifluoroacetate (Rf-6), and the others are in the same procedures, an N-methyl-2-pyrolidone solution of tetracarboxylic diester dichloride (X-7) was obtained.

### (Synthesis Example 16) Synthesis of Tetracarboxylic Diester Dichloride (X-8)

In the Synthesis Example 9, 4,4,5,5,5-pentafluoropentanol (Rf-1) was substituted with 189.4 g (644 mmol) of 4,4,5,5,6,6,7,7,7-nonafluoro-1,2-heptane diol (Rf-7), and the others are in the same procedures, a N-methyl-2-pyrolidone solution of tetracarboxylic diester dichloride (X-8) was obtained.

### (Synthesis Example 17) Synthesis of Polyamide-imide Resin (A1-9)

Into a 500 ml flask provided with a stirrer and a thermometer, 28.5 g (77.9 mmol) of 2,2,-bis(3-amino-4-hydroxyphenyl)hexafluoropropane (6FAP), 0.4 g (4.1 mmol) of 4-aminophenol(PAP), and 125 g of N-methyl-2-pyrollidone were added, followed by dissolving by stirring at room temperature. Next, under room temperature, a solution in which 15.3 g (49.2 mmol) of 3,3',4,4'-oxydiphthalic dianhydride (s-ODPA) was dissolved in 155 g of N-methyl-2-pyrrolidone was dropped thereto, after the end of dropping, followed by stirring for 3 hours under room temperature. Thereafter, 40g of xylene was added to the reaction liquid, followed by heating and refluxing for 3 hours while removing water generated at 170°C outside the system. After cooling to the room temperature, 1.4 g (18.0 mmol) of pyridine was added thereto, and a mixed liquid of 14.7 g (4.1 mmol as tetracarboxylic diester dichloride) of a separately prepared N-methyl-2-pyrolidone solution (X-1) of tetracarboxylic diester dichloride and 6.9 g (28.7 mmol) of sebacoyl dichloride (DC-1) was dropped thereto so as to keep the temperature to 5°C or lower. After the end of the dropping, the temperature is returned to the room temperature, the reaction liquid was dropped into 2 L of ultrapure water under stirring, a precipitate was filtered to be washed appropriately with water, followed by drying under reduced pressure at 40°C for 48 hours, and a polyamide-imide resin (A1-9) was obtained. A molecular weight of the polymer was measured by GPC. A weight average molecular weight was 35,000 in terms of polystyrene.

### (Synthesis Example 18) to (Synthesis Example 29) Synthesis of Polyamide-imide Resins (A1-10) to (A1-21)

As a diamine compound, a monoamine compound, a tetracarboxylic dianhydride, and a tetracarboxylic diester dichloride, compounds of the weights shown in the following Table 2 were used, with the same procedures as that of Synthesis Example 17, polyamide-imide resins (A1-10) to (A1-21) were obtained. By measuring a molecular weight of each of polymers by GPC, weight average molecular weights in terms of polystyrene are shown in the following Table 2.

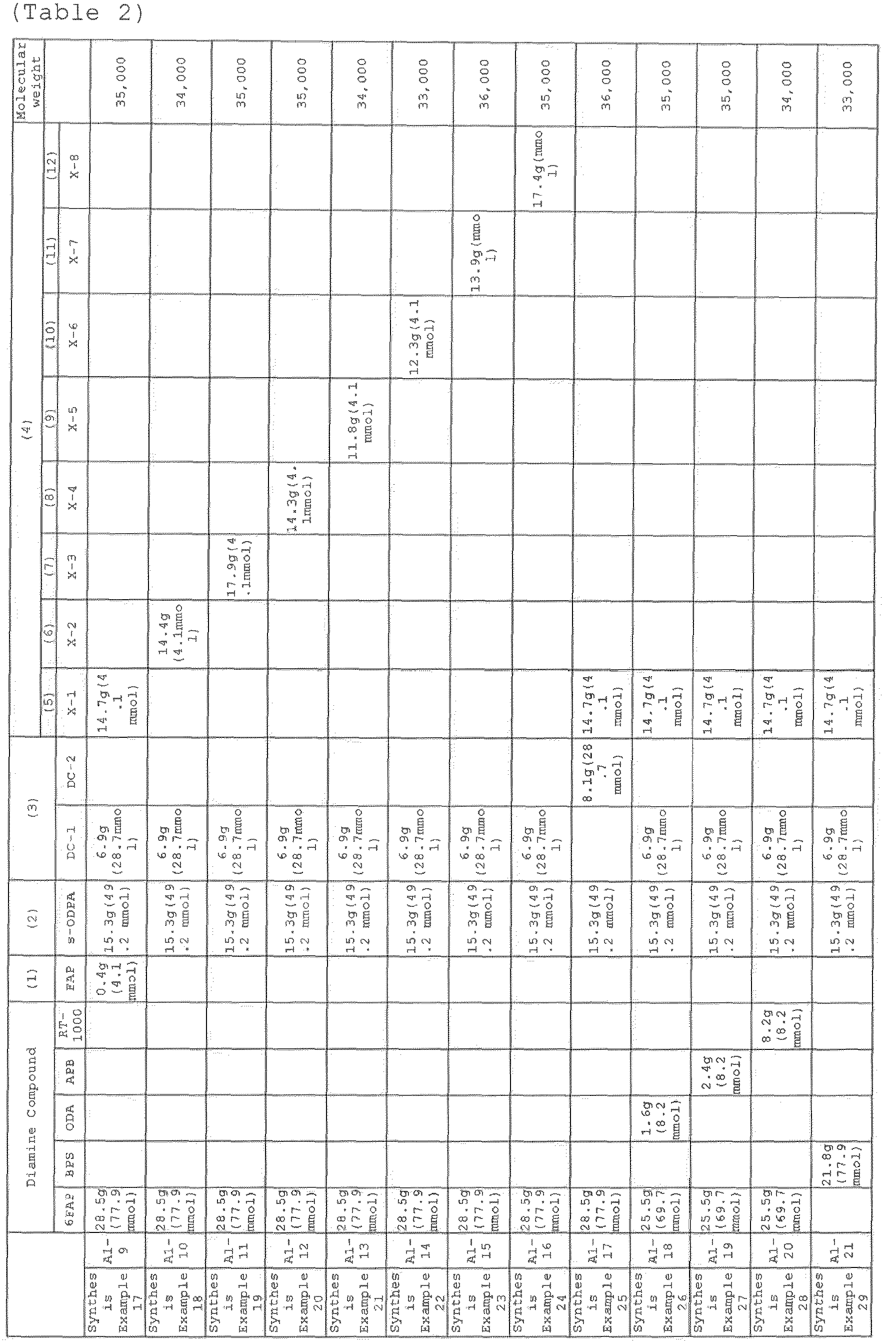

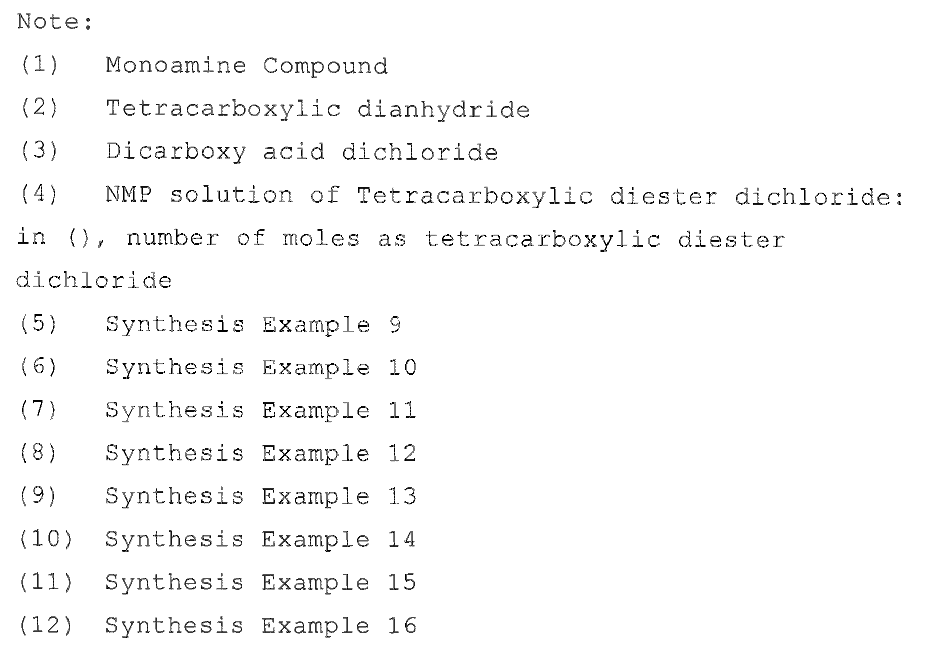

### (Synthesis Example 30) Synthesis of Nitrogen-containing Heterocycle-containing Polyimide Resin (A2-1)

Into a 1L flask provided with a stirrer and a thermometer, 30 g (93.7 mmol) of 2,2,-bis(trifluormethyl)benzidine (TFMB), 5.9 g (62.5 mmol) of 4-aminopyridine (4APY), and 144 g of N-methyl-2-pyrolidone were added, followed by dissolving by stirring at room temperature. Next, under room temperature, a solution obtained by dissolving 38.8 g (125.0 mmol) of 3,3',4,4'-oxydiphthalic dianhydride (s-ODPA) in 390 g of N-methyl-2-pyrrolidone was dropped thereto, after the end of the dropping, followed by stirring for 3 hours under room temperature. After that, 40 g of xylene was added to the reaction liquid, followed by heating and refluxing for 3 hours while removing water generated at 170°C outside of the system. After cooling to the room temperature, the reaction liquid was dropped into 2L of ultrapure water under stirring, followed by filtering a precipitate, followed by properly washing with water, further followed by drying under reduced pressure at 40°C for 48 hours, thus a polyimide resin (A2-1) was obtained. By measuring a molecular weight of the polymer by GPC, a weight average molecular weight was 6,500 in terms of polystyrene.

### (Synthesis Example 31) to (Synthesis Example 37) Synthesis of Nitrogen-containing Heterocycle-containing Polyimide Resin (A2-2) to (A2-8)

As a diamine compound, a monoamine compound, and a tetracarboxylic dianhydride, compounds of the weights shown in the following Table 3 were used, with the same procedures as that of Synthesis Example 30, polyimide resins (A2-2) to (A2-8) were obtained. By measuring a molecular weight of each of polymers by GPC, weight average molecular weights in terms of polystyrene are shown in the following Table 3.

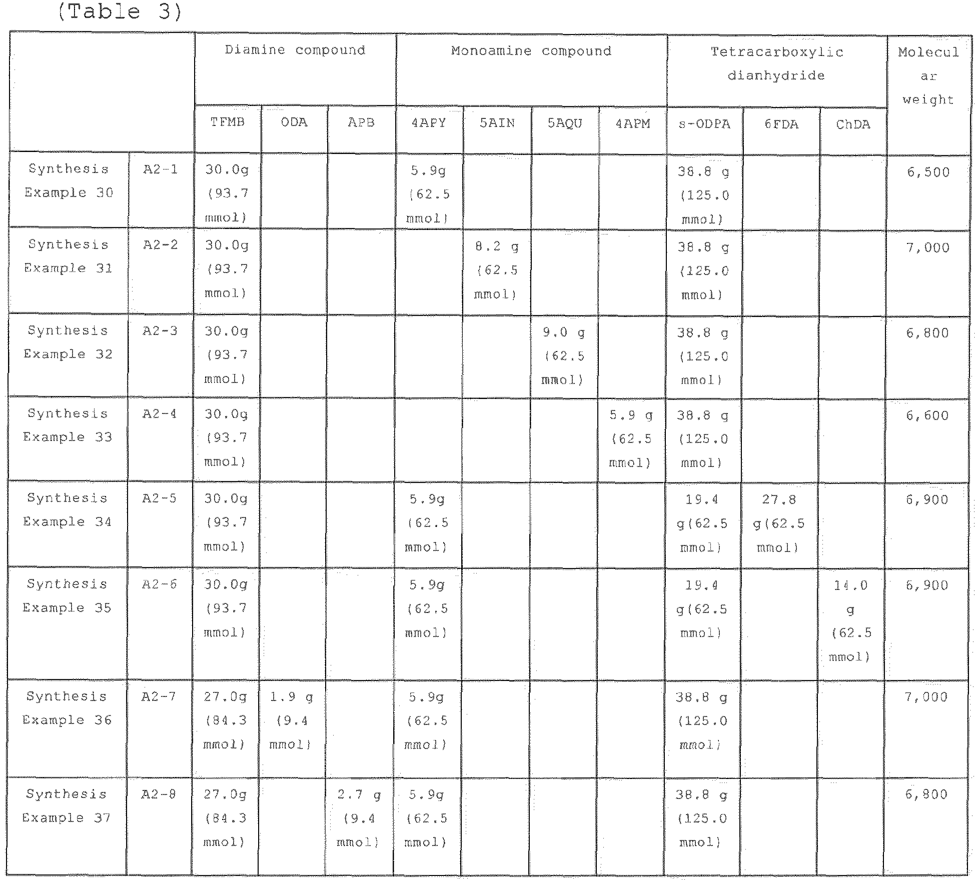

### II. Preparation of Photosensitive Resin Composition

Polyimide resins (A1-1) to (A1-8), (B-1) synthesized in the Synthesis Example 1 to Synthesis Example 8 and Comparative Synthesis Example 1, polyamide-imide resins (A1-9) to (A1-21) synthesized in Synthesis Examples 17 to Synthesis Example 29, and nitrogen-containing heterocycle-containing polyimide resins (A2-2) to (A2-8) synthesized according to Synthesis example 31 to Synthesis example 37 were used as a base resin, with compositions and blending amounts described in Table 4A to 4C, resin compositions of 30 mass% in terms of resin were prepared. Thereafter, after stirring, mixing, and dissolving, micro-filtering was applied with a Teflon (registered trade mark) 0.5µm filter, and a photosensitive resin composition was obtained. In Table, PGMEA of a solvent represents propylene glycol monomethyl ether acetate and GBL represents γ-butyrolactone.

**(Table 4A)**

| | Resin | | | Photosensitizer | Crosslinking agent | | Acid generator | Solvent | |
|---|---|---|---|---|---|---|---|---|---|
| | (A-1) component | | (A-2) component | (B) Component | (C) Component | | (E) Component | (D) Component | |
| Photosensitive resin composition 1 | Al-1 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 2 | Al-2 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 3 | A1-3 100 parts by mass | | A2-1 10 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 4 | A1-4 100 parts by mass | | A2-1 10 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 5 | Al-5 100 parts by mass | | A2-1 20 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 6 | A1-6 100 parts by mass | | A2-1 20 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 7 | A1-7 100 parts by mass | | A2-1 20 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 8 | Al-8 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 9 | A1-9 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 10 | A1-10 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 11 | A1-11 100 part s by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 12 | A1-12 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 13 | A1-13 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 14 | A1-14 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 15 | A1-15 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |

**(Table 4B)**

| | Resin | | | Photosensit izer | Crosslinking agent | | Acid generator | Solvent | |
|---|---|---|---|---|---|---|---|---|---|
| | (A-1) component | | (A-2) component | (B) Component | (C) Component | | (E) Component | (D) Component | |
| Photosensitive resin composition 16 | A1-16 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 17 | A1-17 100 parts by mass | | A2-1 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 18 | A1-18 100 parts by mass | | A2-1 10 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 19 | A1-19 100 parts by mass | | A2-1 10 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 20 | A1-20 100 parts by mass | | A2-1 10 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 21 | A1-21 100 parts by mass | | A2-1 15 parts by mass | Photosensitizer 1 15 parts by mass | CL-1 10 parts by mass | CL-2 15 parts by mass | | PGMEA 2.07 parts by mass | GBL 23 parts by mass |
| Photosensitive resin composition 22 | A1-9 100 parts by mass | | A2-2 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 23 | A1-9 100 parts by mass | | A2-3 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 24 | A1-9 100 parts by mass | | A2-4 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 25 | A1-9 100 parts by mass | | A2-5 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 26 | A1-9 100 parts by mass | | A2-6 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 27 | A1-9 100 parts by mass | | A2-7 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 28 | A1-9 100 parts by mass | | A2-8 15 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 29 | Al-2 70 parts by mass | A1-9 30 parts by mass | A2-5 15 parts by mass | Photosensitizer 1 15 parts by mass | CL-1 10 parts by mass | CL-2 15 parts by mass | | PGMEA 207 parts by mass | GBL23 parts by mass |
| Photosensitive resin composition 30 | A1-2 70 parts by mass | A1-7 30 parts by mass | A2-5 15 parts by mass | Photosensitizer 1 15 parts by mass | CL-1 10 parts by mass | CL-2 15 parts by mass | | PGMEA 207 parts by mass | GBL 23 parts by mass |

**(Table 4C)**

| | Resin | | | Photosensitizer | Crosslinking agent | | Acid generator | Solvent | |
|---|---|---|---|---|---|---|---|---|---|
| | (A-1) component | | (A-2) component | (B) Component | (C) Component | | (E) Component | (D) Component | |
| Photosensitive resin composition 31 | Al-1 100 parts by mass | | A2-5 15 parts by mass | Photosensitizer 1 15 parts by mass | CL-1 10 parts by mass | CL-2 15 parts by mass | E-1 2 parts by mass | PGMEA 207 parts by mass | GBL 23 parts by mass |
| Photosensitive resin composition 32 | A1-9 100 parts by mass | | A2-5 15 parts by mass | Photosensitizer 1 15 parts by mass | CL-1 10 parts by mass | CL-2 15 parts by mass | E-1 2 parts by mass | PGMEA 207 parts by mass | GBL 23 parts by mass |
| Photosensitive resin composition 33 | A1-9 100 parts by mass | | A2-5 5 parts by mass | Photosensitizer 1 15 parts by mass | CL-1 10 parts by mass | CL-2 15 parts by mass | | PGMEA 207 parts by mass | GBL 23 parts by mass |
| Photosensitive resin composition 34 | A1-9 100 parts by mass | | A2-5 30 parts by mass | Photosensitizer 1 15 parts by mass | CL-1 10 parts by mass | CL-2 15 parts by mass | | PGMEA 207 parts by mass | GBL 23 parts by mass |
| Comparative Photosensitive resin composition 1 | A1-1 100 parts by mass | | | Photosensitizer 1 15 parts by mass | CL-1 10 parts by mass | CL-2 15 parts by mass | | PGMEA 207 parts by mass | GBL 23 parts by mass |
| Comparative Photosensitive resin composition 2 | A1-9 100 parts by mass | | | Photosensitizer 1 15 parts by mass | CL-1 10 parts by mass | CL-2 15 parts by mass | | PGMEA 207 parts by mass | GBL 23 parts by mass |
| Comparative Photosensitive resin composition 3 | Al-5 100 parts by mass | B-1 80 parts by mass | | Photosensitizer 1 15 parts by mass | CL-1 10 parts by mass | CL-2 15 parts by mass | | PGMEA 207 parts by mass | GBL 23 parts by mass |

In the Table 4A to 4C, details of the photosensitizer (photosensitizer 1) which are quinonediazide compounds, the crosslinking agents (CL-1, (CL-2), and the acid generator (E-1), are as shown below.

### Photosensitizer (photosensitizer 1)

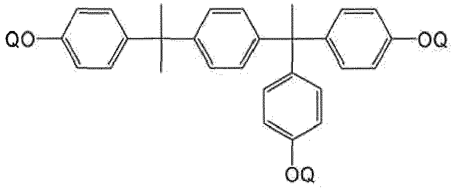

In the formula, Q represents a 1,2-naphthoquinone diazidosulfonyl group represented by the following formula (40) or a hydrogen atom, and 90% of the Q is substituted with the 1,2-naphthoquinone diazidosulfonyl group represented by the following formula (40).

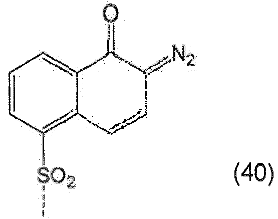

### Crosslinking Agent (CL-1)

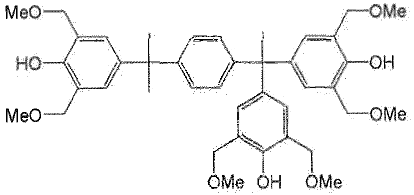

### Crosslinking Agent (CL-2)

Epoxy resin: EP4000L manufactured by ADEKA Corporation

### Thermal Acid Generator (E-1)

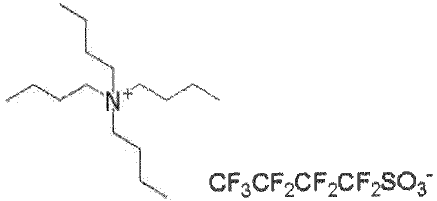

### III. Pattern Formation

By rotating a substrate after each of the photosensitive resin compositions 1 to 34, and comparative photosensitive resin compositions 1 to 3 was dispensed by 5 mL on a silicon substrate, that is, by a spin coating method, the photosensitive resin composition was coated such that a film thickness is 10 µm after patterning and heating for the post-curing. That is, by studying in advance that after the post-curing step, the film thickness decreases, the number of rotation during coating was adjusted such that a finishing film thickness after the post-curing is 10 µm.

Subsequently, prebaking was applied on a hot plate at 100°C for 2 minutes. Then, i-line exposure and patterning was performed with an i-line stepper NSR-2205i11 manufactured by Nikon Corporation. In the patterning, a mask for a positive pattern was used. The mask has a pattern which can form a hole of 20 µm in lengthwise and breadthwise arrangement of 1:1, and can form a hole pattern of 10 µm in increments from 50 µm to 20 µm, 5 µm in increments from 20 µm to 10 µm, and 1 µm in increments from 10 µm to 1 µm.

In the development step, an alkaline aqueous solution was used as a developer, and a 2.38% tetramethyl ammonium hydroxide aqueous solution was used as the developer. After performing three times paddle development with the 2.38% tetramethyl ammonium hydroxide (TMAH) aqueous solution for 1 minute, followed by rinsing with ultrapure water.

Next, the obtained pattern on the substrate was post-cured with an oven at 180°C for 2 hours while purging with nitrogen.

Subsequently, each substrate was cutout such that a shape of the obtained hole pattern may be observed, followed by observing a shape of the hole pattern with a scanning electron microscope (SEM). A minimum aperture diameter of the opening holes was measured on the post-cured film having a thickness of 10 µm, followed by evaluating a shape of the pattern. The sensitivity at which the minimum pattern was formed was shown in Table 5A and 5B together with these results.

The pattern shape of hole was evaluated based on the following criteria, and evaluation results are shown in Table 5A and 5B.
good: It was observed as a rectangular shape or a forward tapered shape (a dimension of a hole upper part is larger than a dimension of a bottom part).
poor: It was observed as an inversely tapered shape (a shape where a dimension of a hole upper part is smaller than a dimension of a bottom part), an overhang shape (a shape where a hole upper part protrudes), one having drastic thickness reduction, or one having a residue on a bottom surface.

### IV. Rupture Elongation

The photosensitive resin compositions 1 to 34 and comparative photosensitive resin compositions 1 to 3 each was spin-coated on an aluminum substrate such that a finishing film thickness after curing is 10 µm. Subsequently, prebaking was applied on a hot plate at 100°C for 3 minutes, and a photosensitive resin film was obtained.

Thereafter, curing was performed with an oven at 180°C for 2 hours while purging with nitrogen and a photosensitive resin cured film was obtained. Next, a wafer with a cured film was cut in strips of a width of 10 mm and a length of 60 mm, followed by peeling the cured film from the substrate by dipping in hydrochloric acid of 20 mass%. The obtained cured film was subjected to a measurement of the rupture elongation using an Autograph AGX-1KN manufactured by Shimadzu Corporation. The measurement was performed 10 times a sample, and an average value thereof is shown in Table 5A and 5B.

**(Table 5A)**

| | Composition | Hole Shape | Minimum hole diameter (µm) | Sensitivity (mJ/cm²) | Rupture Elongation (%) |
|---|---|---|---|---|---|
| Example 1 | Photosensitive Resin Composition 1 | Good | 6 | 540 | 64 |
| Example 2 | Photosensitive Resin Composition 2 | Good | 6 | 560 | 62 |
| Example 3 | Photosensitive Resin Composition 3 | Good | 6 | 580 | 68 |
| Example 4 | Photosensitive Resin Composition 4 | Good | 6 | 580 | 70 |
| Example 5 | Photosensitive Resin Composition 5 | Good | 6 | 600 | 75 |
| Example 6 | Photosensitive Resin Composition 6 | Good | 6 | 600 | 80 |
| Example 7 | Photosensitive Resin Composition 7 | Good | 6 | 580 | 90 |
| Example 8 | Photosensitive Resin Composition 8 | Good | 6 | 560 | 62 |
| Example 9 | Photosensitive Resin Composition 9 | Good | 5 | 420 | 108 |
| Example 10 | Photosensitive Resin Composition 10 | Good | 5 | 440 | 92 |
| Example 11 | Photosensitive Resin Composition 11 | Good | 5 | 400 | 94 |
| Example 12 | Photosensitive Resin Composition 12 | Good | 5 | 400 | 92 |
| Example 13 | Photosensitive Resin Composition 13 | Good | 5 | 420 | 100 |
| Example 14 | Photosensitive Resin Composition 14 | Good | 5 | 380 | 90 |
| Example 15 | Photosensitive Resin Composition 15 | Good | 5 | 400 | 92 |
| Example 16 | Photosensitive Resin Composition 16 | Good | 5 | 460 | 106 |
| Example 17 | Photosensitive Resin Composition 17 | Good | 5 | 420 | 110 |
| Example 18 | Photosensitive Resin Composition 18 | Good | 6 | 500 | 108 |
| Example 19 | Photosensitive Resin Composition 19 | Good | 6 | 420 | 108 |
| Example 20 | Photosensitive Resin Composition 20 | Good | 6 | 440 | 112 |
| Example 21 | Photosensitive Resin Composition 21 | Good | 5 | 400 | 90 |
| Example 22 | Photosensitive Resin Composition 22 | Good | 5 | 420 | 102 |
| Example 23 | Photosensitive Resin Composition 23 | Good | 5 | 420 | 100 |

**(Table 5B)**

| | Composition | Hole Shape | Minimum hole diameter (µm) | Sensitivity (mJ/cm2) | Rupture Elongation (%) |
|---|---|---|---|---|---|
| Example 24 | Photosensitive Resin Composition 24 | Good | 5 | 420 | 106 |
| Example 25 | Photosensitive Resin Composition 25 | Good | 5 | 460 | 102 |
| Example 26 | Photosensitive Resin Composition 26 | Good | 5 | 420 | 104 |
| Example 27 | Photosensitive Resin Composition 27 | Good | 5 | 460 | 96 |
| Example 28 | Photosensitive Resin Composition 28 | Good | 5 | 420 | 98 |
| Example 29 | Photosensitive Resin Composition 29 | Good | 5 | 420 | 82 |
| Example 30 | Photosensitive Resin Composition 30 | Good | 6 | 500 | 79 |
| Example 31 | Photosensitive Resin Composition 31 | Good | 6 | 540 | 64 |
| Example 32 | Photosensitive Resin Composition 32 | Good | 5 | 460 | 104 |
| Example 33 | Photosensitive Resin Composition 33 | Good | 5 | 420 | 85 |
| Example 34 | Photosensitive Resin Composition 34 | Good | 6 | 500 | 106 |
| Comparative Example 1 | Comparative Photosensitive Resin Composition 1 | Good | 6 | 480 | 22 |
| Comparative Example 2 | Comparative Photosensitive Resin Composition 2 | Good | 5 | 380 | 42 |
| Comparative Example 3 | Comparative Photosensitive Resin Composition 3 | Good | 6 | 400 | 30 |

As shown in Table 5A and 5B, since the positive photosensitive resin compositions of the present invention show an excellent pattern shape in the alkali solvent development, and the minimum hole dimension shows a value smaller than the finishing film thickness of 10 µm, it was found that an aspect ratio of 1 or larger can be achieved.

Furthermore, even when the positive photosensitive resin compositions of the present invention were cured at low temperatures, cured films having excellent mechanical strength were obtained.

On the contrary, the cured films obtained by using the comparative photosensitive resin compositions 1 to 3 resulted in poor mechanical characteristics than the cured films obtained from the compositions of the present invention.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A positive photosensitive resin composition comprising:
(A-1) an alkali-soluble resin containing at least one or more structures selected from a polyimide structure, a polybenzoxazole structure, a polyamide-imide structure, and a precursor structure thereof;
(A-2) a resin containing at least one or more structures selected from a polyimide structure, a polybenzoxazole structure, a polyamide-imide structure, and a precursor structure thereof, each of which has no alkali-soluble group and contains a heterocyclic skeleton having at least one or more nitrogen atoms at a molecular end;
(B) a compound having a quinonediazide structure for serving as a photosensitizer to generate an acid by light and increase a dissolution speed to an alkaline aqueous solution; and
(D) a solvent.

2. The positive photosensitive resin composition according to Claim 1, wherein the (A-2) contains a polyimide structure represented by the following general formula (1), 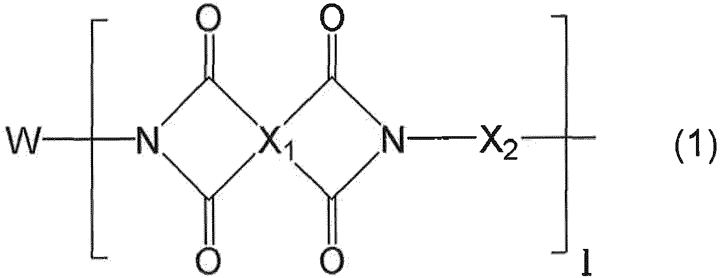 wherein, W is a monovalent organic group comprising a heterocyclic skeleton having at least one or more nitrogen atoms, X₁ is a tetravalent organic group, X₂ is a divalent organic group, and "1" represents an integer of 1 to 1000.

3. The positive photosensitive resin composition according to claim 1 or 2, wherein the positive photosensitive resin composition contains 5 parts by mass or larger and 50 parts by mass or smaller of the (A-2) relative to 100 parts by mass of the (A-1).

4. The positive photosensitive resin composition according to any one of claim 1 to 3, wherein the (A-1) contains a structure represented by the following general formula (2) and/or (3), 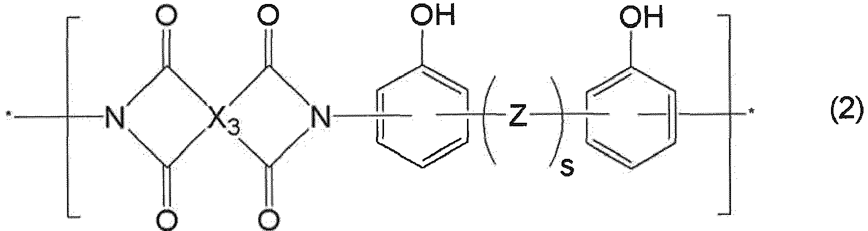 wherein X₃ is a tetravalent organic group, "s" represents 0 or 1, Z is a divalent linking group, and when s=0, two aromatic rings in the formula are directly bonded without a linking group, 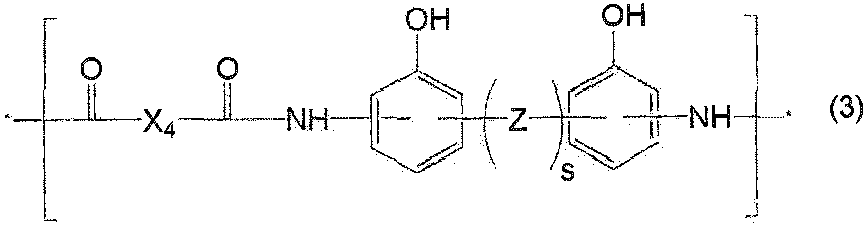 wherein, X₄ is a divalent organic group, and "s" and Z are the same as the above.

5. The positive photosensitive resin composition according to claim 4, wherein Z in the general formulae (2) and (3) is a divalent group represented by the following general formula (4) or (5), 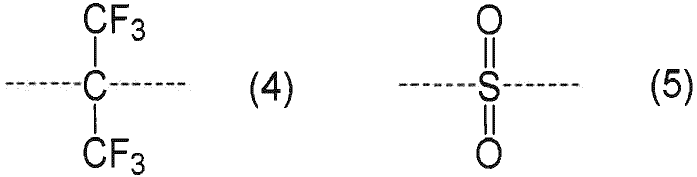 wherein a dotted line represents a bond.

6. The positive photosensitive resin composition according to any one of claim 1 to 5, wherein
the (A-1) furthermore contains a structural unit represented by the following general formulae (6) and/or (8), 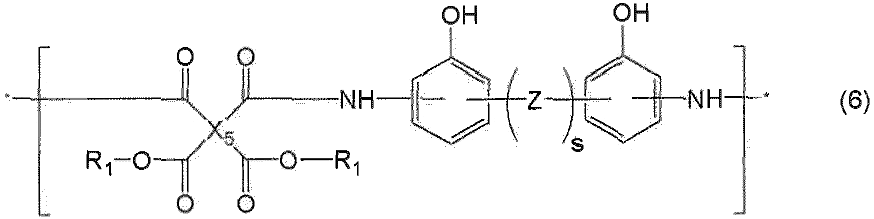 wherein X₅ is a tetravalent organic group, R₁ is a group represented by the following general formula (7), "s" represents 0 or 1, Z is a divalent linking group, and, when s=0, two aromatic rings in the formula are directly linked without a linking group, 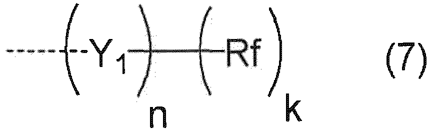 wherein a dotted line represents a bond, Y₁ is an organic group with a valency of (k+1), Rf is a linear branched, or cyclic alkyl group having 1 to 20 carbon atoms or an aromatic group optionally substituted with an alkyl group in which a part or all of hydrogen atoms are substituted with fluorine atoms, "k" represents 1, 2 or 3 and "n" represents 0 or 1, 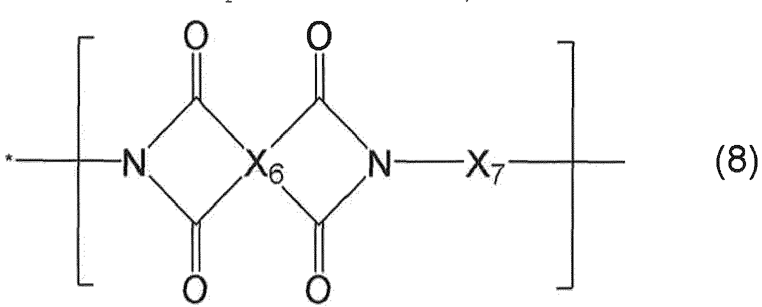 wherein X₆ is a tetravalent organic group, and X₇ is a group shown by the following general formula (9), 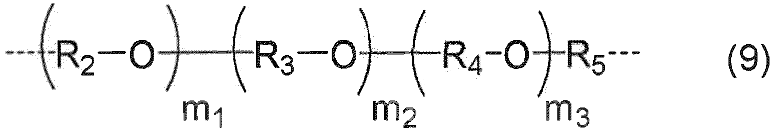 wherein R₂ to R₅ each is independently a linear or branched alkylene group having 2 to 10 carbon atoms, m₁ is an integer of 1 to 40, and m₂, m₃ each is independently an integer of 0 to 40.

7. The positive photosensitive resin composition according to claim 6, wherein the R₁ in the general formula (6) is an organic group selected from any one of groups represented by the following general formulae (10), (11), (12) and (13), 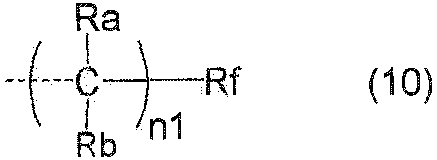 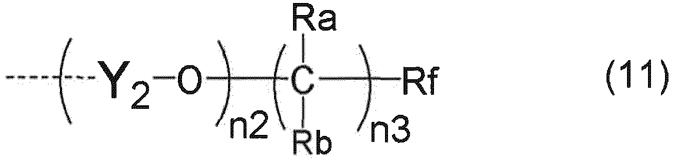 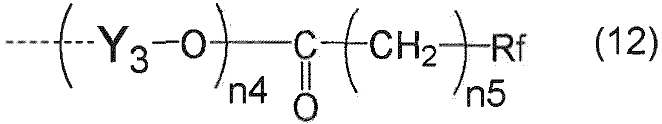 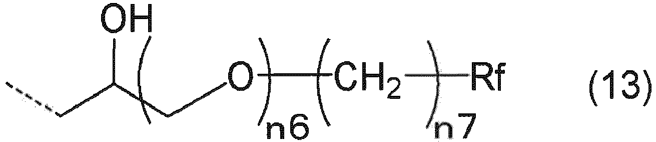 wherein a dotted line represents a bond, Rf is the same as the above, Ra and Rb are a hydrogen atom or an alkyl group having 1 to 3 carbon atoms, Y₂ and Y₃ are a linear or branched alkylene group having 1 to 6 carbon atoms, n1 represents an integer of 0 to 6, n2 represents an integer of 1 to 6, n3 represents an integer of 0 to 6, n4 represents an integer of 1 to 6, n5 represents an integer of 0 to 6, n6 represents 0 or 1, and n7 represents an integer of 0 to 6.

8. The positive photosensitive resin composition according to any one of claim 1 to 7, further comprising (C) one or two or more kinds of crosslinking agents selected from an amino condensate modified by formaldehyde or formaldehyde-alcohol; a phenol compound having two or more methylol groups or alkoxymethylol groups by average in one molecule; a compound in which a hydrogen atom of a phenolic hydroxy group is substituted with a glycidyl group; a compound in which a hydrogen atom of a phenolic hydroxy group is substituted with a substituent represented by the following formula (C-1); and a compound containing two or more nitrogen atoms having a glycidyl group represented by the following formula (C-2), 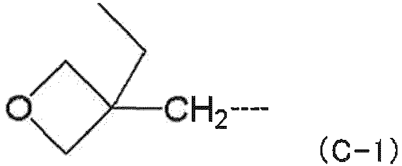 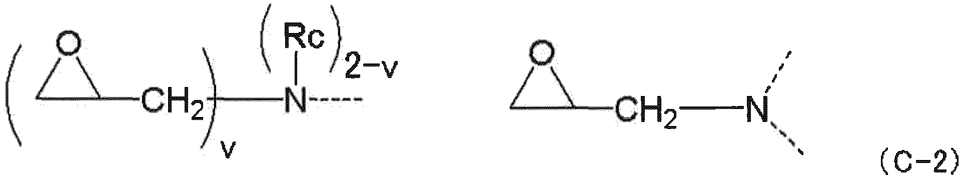 wherein a dotted line represents a bond, Rc represents a linear, branched, or cyclic alkyl group having 1 to 6 carbon atoms, and "v" represents 1 or 2.

9. The positive photosensitive resin composition according to any one of claim 1 to 8, further comprising (E) a compound to generate an acid by heating.

10. A patterning process comprising steps of:
(4) forming a photosensitive material film by coating the positive photosensitive resin composition according to any one of claim 1 to 9 on a substrate;
(5) subsequently, after a heat treatment, exposing the photosensitive material film with a high energy beam having a wavelength of 190 to 500 nm or an electron beam via a photomask; and
(6) developing with a developer of an alkaline aqueous solution.

11. A method of forming a cured film comprising a step of:
heating and post-curing a film on which a pattern is formed by the patterning process according to claim 10 at a temperature of 100 to 300°C.

12. An interlayer insulation film being a cured film by curing the positive photosensitive resin composition according to any one of claims 1 to 9.

13. A surface protective film being a cured film by curing the positive photosensitive resin composition according to any one of claims 1 to 9.

14. An electronic component having the interlayer insulation film according to claim 12 or the surface protective film according to claim 13.

## Patentansprüche

1. Positive lichtempfindliche Harzzusammensetzung, umfassend:
(A-1) ein alkalilösliches Harz, das mindestens eine oder mehrere Strukturen enthält, die aus einer Polyimidstruktur, einer Polybenzoxazolstruktur, einer Polyamid-Imidstruktur und einer Vorläuferstruktur davon ausgewählt sind;
(A-2) ein Harz, das mindestens eine oder mehrere Strukturen enthält, die aus einer Polyimidstruktur, einer Polybenzoxazolstruktur, einer Polyamid-Imidstruktur und einer Vorläuferstruktur davon ausgewählt sind, von denen jede keine alkalilösliche Gruppe aufweist und ein heterocyclisches Gerüst mit mindestens einem oder mehreren Stickstoffatomen an einem Molekülende enthält;
(B) eine Verbindung mit einer Chinondiazidstruktur, die als Photosensibilisator dient, um durch Licht eine Säure zu erzeugen und die Auflösungsgeschwindigkeit in einer alkalischen wässrigen Lösung zu erhöhen; und
(D) ein Lösungsmittel.

2. Positive lichtempfindliche Harzzusammensetzung nach Anspruch 1, wobei die (A-2) eine Polyimidstruktur enthält, die durch die folgende allgemeine Formel (1) dargestellt wird, 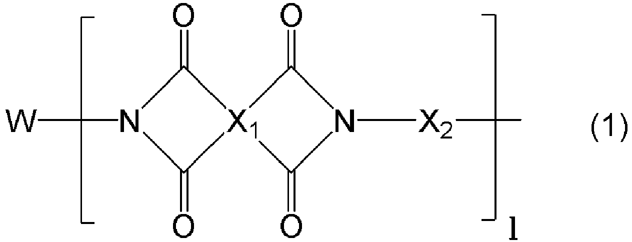 worin W eine einwertige organische Gruppe ist, die ein heterocyclisches Gerüst mit mindestens einem oder mehreren Stickstoffatomen umfaßt, X₁ eine vierwertige organische Gruppe ist, X₂ eine zweiwertige organische Gruppe ist und "I" eine ganze Zahl von 1 bis 1000 darstellt.

3. Positive lichtempfindliche Harzzusammensetzung nach Anspruch 1 oder 2, wobei die positive lichtempfindliche Harzzusammensetzung 5 Masseteile oder mehr und 50 Masseteile oder weniger des (A-2) bezogen auf 100 Masseteile des (A-1) enthält.

4. Positive lichtempfindliche Harzzusammensetzung nach einem der Ansprüche 1 bis 3, wobei das (A-1) eine Struktur der folgenden allgemeinen Formel (2) und/oder (3) enthält, 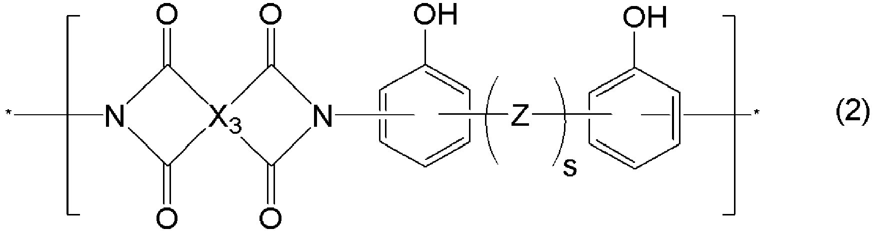 worin X₃ eine vierwertige organische Gruppe ist, "s" 0 oder 1 darstellt, Z eine zweiwertige Verknüpfungsgruppe ist, und wenn s=0 ist, zwei aromatische Ringe in der Formel direkt ohne eine Verknüpfungsgruppe gebunden sind, 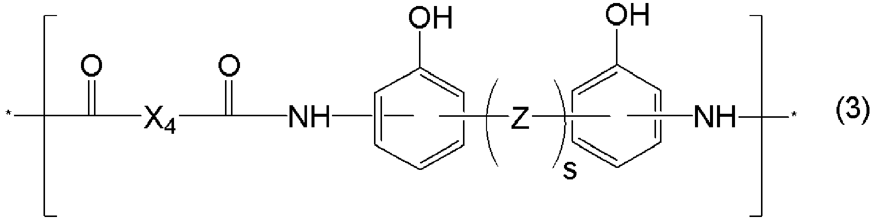 worin X₄ eine zweiwertige organische Gruppe ist und "s" und Z die gleiche Bedeutung wie oben haben.

5. Positive lichtempfindliche Harzzusammensetzung nach Anspruch 4, wobei Z in den allgemeinen Formeln (2) und (3) eine zweiwertige Gruppe ist, die durch die folgende allgemeine Formel (4) oder (5) dargestellt wird, 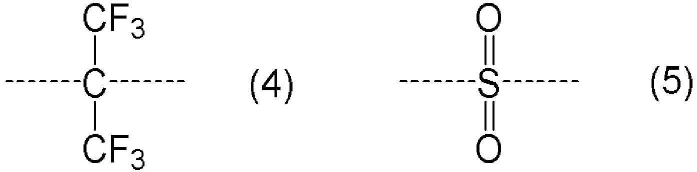 wobei eine gestrichelte Linie eine Bindung darstellt.

6. Positive lichtempfindliche Harzzusammensetzung nach einem der Ansprüche 1 bis 5, wobei
das (A-1) weiterhin eine Struktureinheit enthält, die durch die folgenden allgemeinen Formeln (6) und/oder (8) dargestellt wird, 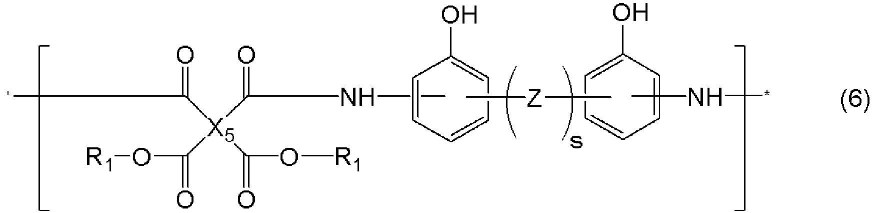 worin X₅ eine vierwertige organische Gruppe ist, R₁ eine Gruppe ist, die durch die folgende allgemeine Formel (7) dargestellt wird, "s" 0 oder 1 darstellt, Z eine zweiwertige Verknüpfungsgruppe ist, und, wenn s=0 ist, zwei aromatische Ringe in der Formel direkt ohne eine Verknüpfungsgruppe verbunden sind, 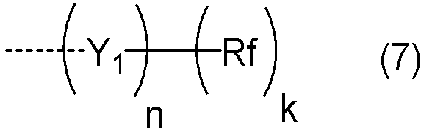 worin eine gestrichelte Linie eine Bindung darstellt, Y₁ eine organische Gruppe mit einer Wertigkeit von (k+1) ist, Rf eine lineare, verzweigte oder cyclische Alkylgruppe mit 1 bis 20 Kohlenstoffatomen oder eine aromatische Gruppe ist, die gegebenenfalls mit einer Alkylgruppe substituiert ist, in der ein Teil oder alle Wasserstoffatome mit Fluoratomen substituiert sind, "k" 1, 2 oder 3 darstellt und "n" 0 oder 1 darstellt, 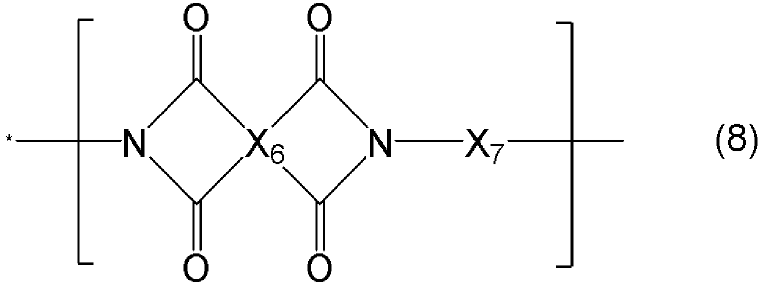 worin X₆ eine vierwertige organische Gruppe ist und X₇ eine durch die folgende allgemeine Formel (9) dargestellte Gruppe ist, 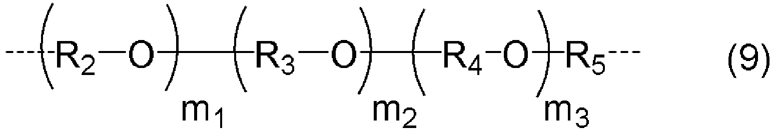 worin R₂ bis R₅ jeweils unabhängig voneinander eine lineare oder verzweigte Alkylengruppe mit 2 bis 10 Kohlenstoffatomen sind, m₁ eine ganze Zahl von 1 bis 40 ist und m₂, m₃ jeweils unabhängig voneinander eine ganze Zahl von 0 bis 40 sind.

7. Positive lichtempfindliche Harzzusammensetzung nach Anspruch 6, wobei das R₁ in der allgemeinen Formel (6) eine organische Gruppe ist, die aus einer der Gruppen ausgewählt ist, die durch die folgenden allgemeinen Formeln (10), (11), (12) und (13) dargestellt sind, 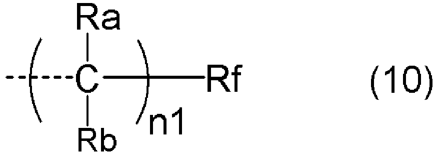 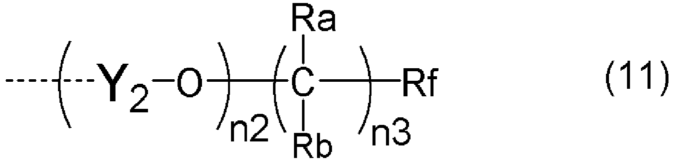 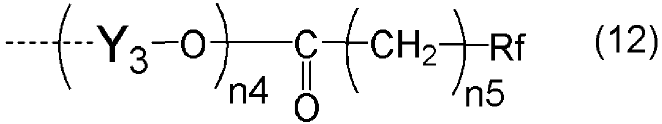 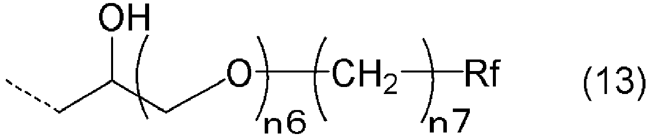 worin eine gestrichelte Linie eine Bindung darstellt, Rf das gleiche wie oben ist, Ra und Rb ein Wasserstoffatom oder eine Alkylgruppe mit 1 bis 3 Kohlenstoffatomen sind, Y₂ und Y₃ eine lineare oder verzweigte Alkylengruppe mit 1 bis 6 Kohlenstoffatomen sind, n1 eine ganze Zahl von 0 bis 6 darstellt, n2 eine ganze Zahl von 1 bis 6 darstellt, n3 eine ganze Zahl von 0 bis 6 darstellt, n4 eine ganze Zahl von 1 bis 6 darstellt, n5 eine ganze Zahl von 0 bis 6 darstellt, n6 0 oder 1 darstellt und n7 eine ganze Zahl von 0 bis 6 darstellt.

8. Positive lichtempfindliche Harzzusammensetzung nach einem der Ansprüche 1 bis 7, ferner umfassend (C) eine oder zwei oder mehr Arten von Vernetzungsmitteln, ausgewählt aus einem mit Formaldehyd oder Formaldehyd-Alkohol modifizierten Aminokondensat; einer Phenolverbindung mit durchschnittlich
zwei oder mehr Methylolgruppen oder Alkoxymethylolgruppen in einem Molekül; einer Verbindung, in der ein Wasserstoffatom einer phenolischen Hydroxygruppe mit einer Glycidylgruppe substituiert ist; einer Verbindung, in der ein Wasserstoffatom einer phenolischen Hydroxygruppe mit einem Substituenten der folgenden Formel (C-1) substituiert ist; und einer Verbindung, die zwei oder mehr Stickstoffatome mit einer Glycidylgruppe der folgenden Formel (C-2) enthält, 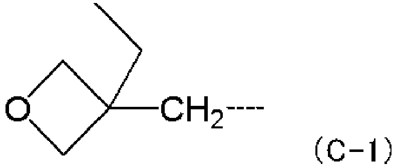 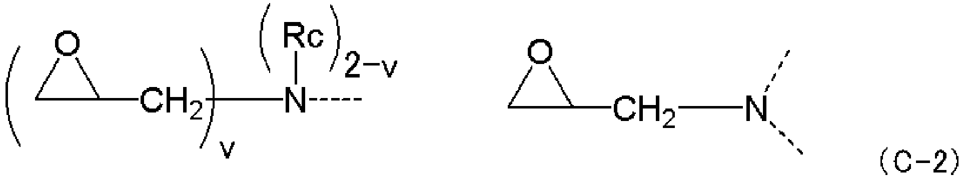 worin eine gestrichelte Linie eine Bindung darstellt, Rc eine lineare, verzweigte oder cyclische Alkylgruppe mit 1 bis 6 Kohlenstoffatomen darstellt und "v" 1 oder 2 darstellt.

9. Positive lichtempfindliche Harzzusammensetzung nach einem der Ansprüche 1 bis 8, ferner umfassend (E) eine Verbindung zur Erzeugung einer Säure durch Erhitzen.

10. Strukturierungsverfahren, das die folgenden Schritte umfasst:
(1) Bilden eines Films aus lichtempfindlichem Material durch Auftragen der positiven lichtempfindlichen Harzzusammensetzung nach einem der Ansprüche 1 bis 9 auf ein Substrat;
(2) anschließend, nach einer Wärmebehandlung, Belichten des lichtempfindlichen Materialfilms mit einem Hochenergiestrahl mit einer Wellenlänge von 190 bis 500 nm oder einem Elektronenstrahl über eine Fotomaske; und
(3) Entwicklung mit einem Entwickler aus einer alkalischen wässrigen Lösung.

11. Verfahren zur Bildung eines gehärteten Films, das einen Schritt umfasst:
Erhitzen und Nachhärten einer Folie, auf der ein Muster durch das Strukturierungsverfahren nach Anspruch 10 gebildet wird, bei einer Temperatur von 100 bis 300° C.

12. Zwischenschicht-Isolierfilm, der ein gehärteter Film durch Härten der positiven lichtempfindlichen Harzzusammensetzung nach einem der Ansprüche 1 bis 9 ist.

13. Oberflächenschutzfilm, der ein gehärteter Film durch Härten der positiven lichtempfindlichen Harzzusammensetzung nach einem der Ansprüche 1 bis 9 ist.

14. Elektronisches Bauteil mit dem Zwischenschicht-Isolierfolie nach Anspruch 12 oder dem Oberflächenschutzfilm nach Anspruch 13.

## Revendications

1. Composition de résine photosensible positive comprenant :
(A-1) une résine soluble dans les alcalis contenant au moins une ou plusieurs structures choisies parmi une structure polyimide, une structure polybenzoxazole, une structure polyamide-imide et une structure précurseur de celles-ci ;
(A-2) une résine contenant au moins une ou plusieurs structures choisies parmi une structure polyimide, une structure polybenzoxazole, une structure polyamide-imide et une structure précurseur de celles-ci, chacune d'elles n'ayant pas de groupe soluble dans les alcalis et contenant un squelette hétérocyclique ayant au moins un ou plusieurs atomes d'azote à une extrémité moléculaire ;
(B) un composé ayant une structure quinonediazide pour servir de photosensibilisateur pour générer un acide par la lumière et augmenter une vitesse de dissolution en une solution aqueuse alcaline ; et
(D) un solvant.

2. Composition de résine photosensible positive selon la revendication 1, dans laquelle (A-2) contient une structure polyimide représentée par la formule générale (1) suivante, 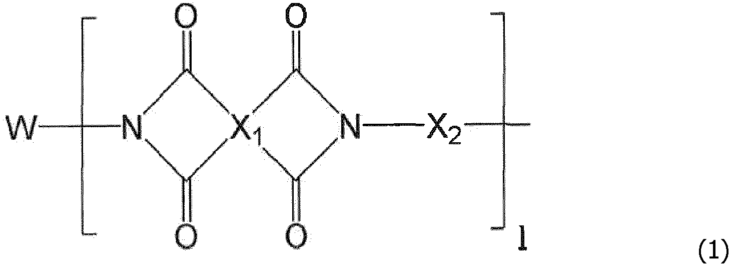 dans laquelle, W est un groupe organique monovalent comprenant un squelette hétérocyclique ayant au moins un ou plusieurs atomes d'azote, X₁ est un groupe organique tétravalent, X₂ est un groupe organique divalent, et « I » représente un nombre entier de 1 à 1 000.

3. Composition de résine photosensible positive selon la revendication 1 ou 2, dans laquelle la composition de résine photosensible positive contient 5 parties en masse ou plus et 50 parties en masse ou moins de (A-2) par rapport à 100 parties en masse de (A-1).

4. Composition de résine photosensible positive selon l'une quelconque des revendications 1 à 3, dans laquelle (A-1) contient une structure représentée par la formule générale (2) et/ou (3) suivantes, 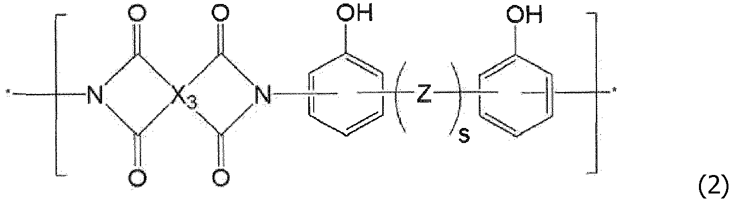 dans laquelle X₃ est un groupe organique tétravalent, « s » représente 0 ou 1, Z est un groupe de liaison divalent, et lorsque s = 0, deux cycles aromatiques dans la formule sont directement liés sans groupe de liaison, 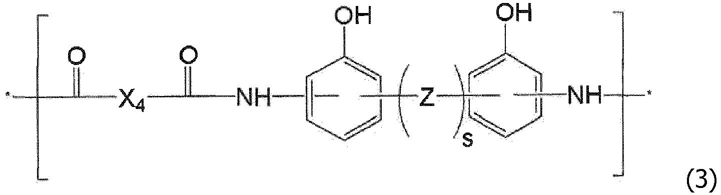 dans laquelle, X₄ est un groupe organique divalent, et « s » et Z sont les mêmes que ci-dessus.

5. Composition de résine photosensible positive selon la revendication 4, dans laquelle Z dans les formules générales (2) et (3) est un groupe divalent représenté par la formule générale (4) ou (5) suivante, 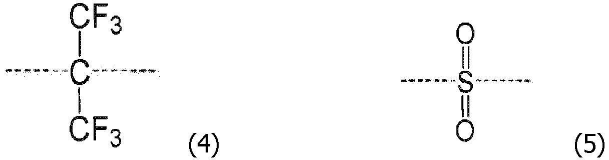 dans laquelle une ligne pointillée représente une liaison.

6. Composition de résine photosensible positive selon l'une quelconque des revendications 1 à 5, dans laquelle (A-1) contient en outre un motif structural représenté par les formules générales (6) et/ou (8) suivantes, 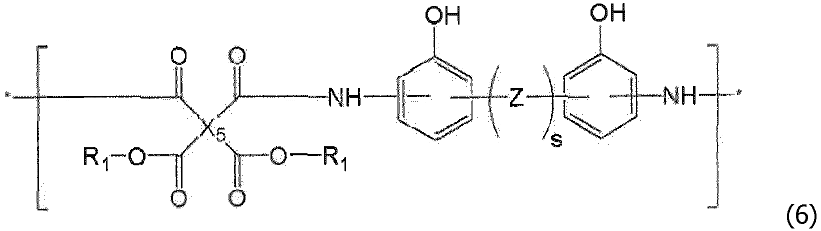 dans laquelle X₅ est un groupe organique tétravalent, R₁ est un groupe représenté par la formule générale (7) suivante, « s » représente 0 ou 1, Z est un groupe de liaison divalent, et, lorsque s = 0, deux cycles aromatiques dans la formule sont directement liés sans groupe de liaison, 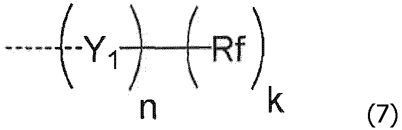 dans laquelle une ligne pointillée représente une liaison, Y₁ est un groupe organique avec une valence de (k+1), Rf est un groupe alkyle linéaire, ramifié ou cyclique ayant 1 à 20 atomes de carbone ou un groupe aromatique éventuellement substitué par un groupe alkyle dans lequel une partie ou la totalité des atomes d'hydrogène sont substitués par des atomes de fluor, « k » représente 1, 2 ou 3, et « n » représente 0 ou 1, 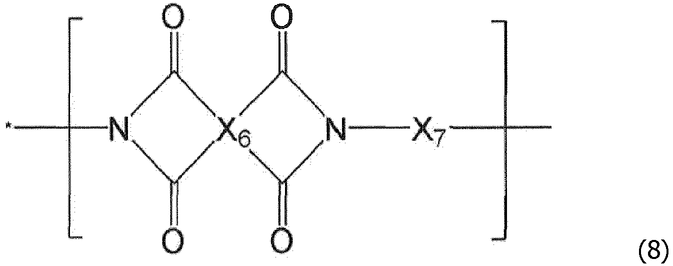 dans laquelle X₆ est un groupe organique tétravalent, et X₇ est un groupe représenté par la formule générale (9) suivante, 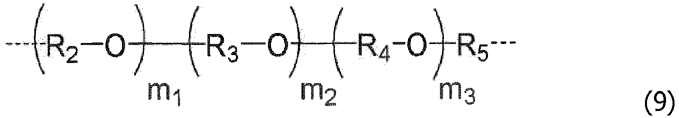 dans laquelle R₂ à R₅ sont chacun indépendamment un groupe alkylène linéaire ou ramifié ayant 2 à 10 atomes de carbone, m₁ est un nombre entier de 1 à 40, et m₂, m₃ sont chacun indépendamment un nombre entier de 0 à 40.

7. Composition de résine photosensible positive selon la revendication 6, dans laquelle R₁ dans la formule générale (6) est un groupe organique choisi parmi l'un quelconque des groupes représentés par les formules générales (10), (11), (12) et (13) suivantes, 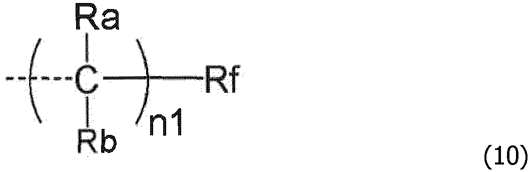 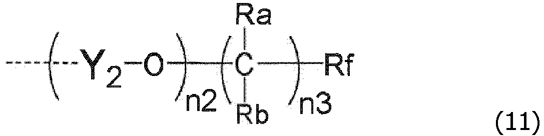 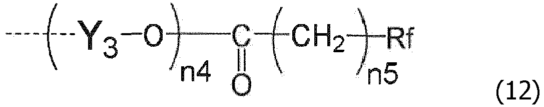 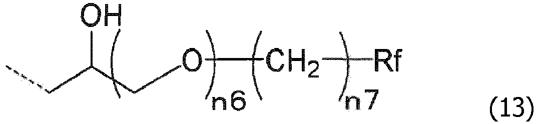 dans lesquelles une ligne pointillée représente une liaison, Rf est le même que ci-dessus, Ra et Rb sont un atome d'hydrogène ou un groupe alkyle ayant 1 à 3 atomes de carbone, Y₂ et Y₃ sont un groupe alkylène linéaire ou ramifié ayant 1 à 6 atomes de carbone , n1 représente un nombre entier de 0 à 6, n2 représente un nombre entier de 1 à 6, n3 représente un nombre entier de 0 à 6, n4 représente un nombre entier de 1 à 6, n5 représente un nombre entier de 0 à 6, n6 représente 0 ou 1, et n7 représente un nombre entier de 0 à 6.

8. Composition de résine photosensible positive selon l'une quelconque des revendications 1 à 7, comprenant en outre
(C) un ou deux types d'agents de réticulation ou plus choisis parmi un condensat amino modifié par du formaldéhyde ou du formaldéhyde-alcool ; un composé phénolique ayant deux groupes méthylol ou groupes alcoxyméthylol ou plus en moyenne dans une molécule ; un composé dans lequel un atome d'hydrogène d'un groupe hydroxy phénolique est substitué par un groupe glycidyle ; un composé dans lequel un atome d'hydrogène d'un groupe hydroxy phénolique est substitué par un substituant représenté par la formule (C-1) suivante ; et un composé contenant deux atomes d'azote ou plus ayant un groupe glycidyle représenté par la formule (C-2) suivante, 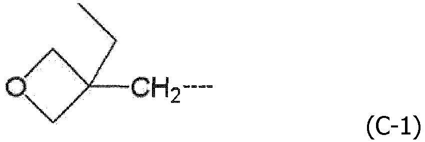 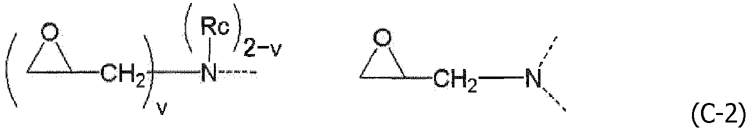 dans lesquelles une ligne pointillée représente une liaison, Rc représente un groupe alkyle linéaire, ramifié ou cyclique ayant 1 à 6 atomes de carbone, et « v » représente 1 ou 2.

9. Composition de résine photosensible positive selon l'une quelconque des revendications 1 à 8, comprenant en outre
(E) un composé pour générer un acide par chauffage.

10. Procédé de formation de motifs comprenant les étapes de :
(4) formation d'un film de matériau photosensible par revêtement de la composition de résine photosensible positive selon l'une quelconque des revendications 1 à 9 sur un substrat ;
(5) par la suite, après un traitement thermique, exposition du film de matériau photosensible avec un faisceau à haute énergie ayant une longueur d'onde de 190 à 500 nm ou un faisceau d'électrons par l'intermédiaire d'un photomasque ; et
(6) développement avec un révélateur d'une solution aqueuse alcaline.

11. Procédé de formation d'un film durci comprenant une étape de :
chauffage et post-durcissement d'un film sur lequel un motif est formé par le procédé de formation de motifs selon la revendication 10 à une température de 100 à 300 °C.

12. Film isolant intercouche étant un film durci par durcissement de la composition de résine photosensible positive selon l'une quelconque des revendications 1 à 9.

13. Film protecteur de surface étant un film durci par durcissement de la composition de résine photosensible positive selon l'une quelconque des revendications 1 à 9.

14. Composant électronique comportant le film isolant intercouche selon la revendication 12 ou le film protecteur de surface selon la revendication 13.
